# EUROPEAN PATENT APPLICATION

(11) **EP 4 770 364 A1**
(43) Date of publication of application: **01.07.2026**
(21) Application number: 25224136.9
(22) Date of filing: 16.12.2025
(51) Int. Cl.: H10K 50/17, H10K 85/60

(54) **LIGHT-EMITTING DEVICE INCLUDING CONDENSED CYCLIC COMPOUND, ELECTRONIC APPARATUS INCLUDING THE LIGHT-EMITTING DEVICE, AND THE CONDENSED CYCLIC COMPOUND**

(30) Priority: 31.12.2024 KR 20240202487
(71) Applicant: Samsung Display Co., Ltd., Yongin-si, Gyeonggi-do 17113 (KR)
(72) Inventor: KIM, Seran, 17113 Yongin-si (KR); KIM, Gyeongheon, 17113 Yongin-si (KR); KIM, Hyeondeuk, 17113 Yongin-si (KR); KIM, Hoilim, 17113 Yongin-si (KR); BAEK, Seungin, 17113 Yongin-si (KR); YOO, Dongsun, 17113 Yongin-si (KR)
(74) Representative: Marks & Clerk LLP

(57) **Abstract**

A light-emitting device including a condensed cyclic compound represented by Formula 1, an electronic apparatus including the light-emitting device, and the condensed cyclic compound represented by Formula 1 are provided. 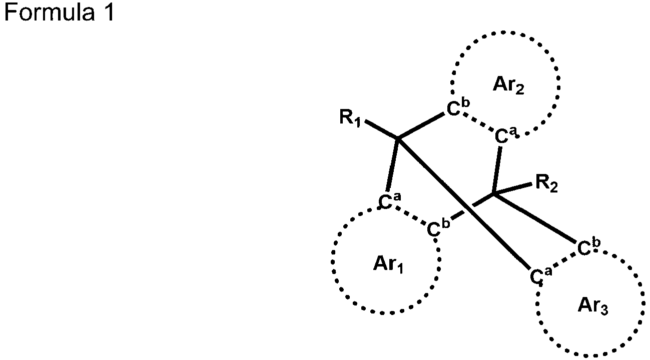 A detailed description of Formula 1 is provided.

## Description

### BACKGROUND

### 1. Field

One or more embodiments relate to a light-emitting device including a condensed cyclic compound, an electronic apparatus including the light-emitting device, and the condensed cyclic compound.

### 2. Description of the Related Art

Among light-emitting devices, "self-emissive" devices are distinguished by their relatively wide (broad) viewing angles, high contrast ratios, short (fast or rapid) response times, and/or excellent or suitable characteristics in terms of luminance, driving voltage, and/or response speed, particularly when compared to non-self-emissive or comparable devices in the related art.

In a light-emitting device, a first electrode is arranged on a substrate, followed by a sequential arrangement of a hole transport region, an emission layer, an electron transport region, and a second electrode (e.g., sequentially arranged on the first electrode). Holes provided from the first electrode travel (move) through the hole transport region to the emission layer, while electrons provided from the second electrode travel (move) through the electron transport region to the emission layer. In the emission layer, these carriers, (e.g., the holes and electrons), recombine to produce excitons. The excitons then transition (e.g., relax) from an excited state to a ground state, thereby emitting (e.g., generating) light, e.g., to display an image.

### SUMMARY

One or more aspects of embodiments of embodiments of the present disclosure are directed toward a light-emitting device including a condensed cyclic compound, an electronic apparatus including the light-emitting device, and the condensed cyclic compound.

Additional aspects will be set forth in part in the description which follows and, in part, will be apparent from the description, or may be learned by practice of the presented embodiments of the disclosure.

According to one or more embodiments, a light-emitting device includes
a first electrode,
a second electrode opposite to (e.g., facing) the first electrode,
an interlayer arranged between the first electrode and the second electrode and including an emission layer, and
a condensed cyclic compound represented by Formula 1: 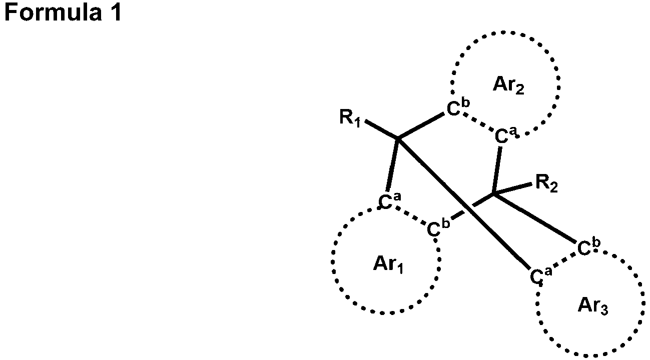
wherein, in Formula 1,
Ar₁ to Ar₃ are each independently any one of (e.g., selected from among) groups represented by Formulae 2-1 to 2-3,
if (e.g., when), among Ar₁ to Ar₃, there are rings represented by the same formula, the rings are substantially identical to or different from each other, 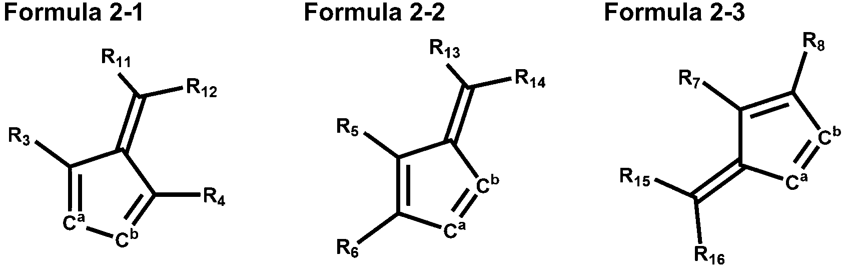
wherein, in Formulae 1 and 2-1 to 2-3,
R₁ to R₈ and R₁₁ to R₁₆ are each independently hydrogen, deuterium, -F, -Cl, -Br, -I, a hydroxyl group, a cyano group, a nitro group, a C₁-C₆₀ alkyl group unsubstituted or substituted with at least one R₁₀ₐ, a C₂-C₆₀ alkenyl group unsubstituted or substituted with at least one R₁₀ₐ, a C₂-C₆₀ alkynyl group unsubstituted or substituted with at least one R₁₀ₐ, a C₁-C₆₀ alkoxy group unsubstituted or substituted with at least one R₁₀ₐ, a C₃-C₆₀ carbocyclic group unsubstituted or substituted with at least one R₁₀ₐ, a C₁-C₆₀ heterocyclic group unsubstituted or substituted with at least one R₁₀ₐ, - C(Q₁)(Q₂)(Q₃), -Si(Q₁)(Q₂)(Q₃), -N(Q₁)(Q₂), -B(Q₁)(Q₂), -C(=O)(Q₁), -S(=O)₂(Q₁), or - P(=O)(Q₁ )(Q₂),
C^{a} and C^{b} in Formula 1 represent carbon atoms,
R₁₀ₐ is
deuterium, -F, -Cl, -Br, -I, a hydroxyl group, a cyano group, or a nitro group,
a C₁-C₆₀ alkyl group, a C₂-C₆₀ alkenyl group, a C₂-C₆₀ alkynyl group, or a C₁-C₆₀ alkoxy group, each unsubstituted or substituted with deuterium, -F, -Cl, -Br, -I, a hydroxyl group, a cyano group, a nitro group, a C₃-C₆₀ carbocyclic group, a C₁-C₆₀ heterocyclic group, a C₆-C₆₀ aryloxy group, a C₆-C₆₀ arylthio group, a C₇-C₆₀ arylalkyl group, a C₂-C₆₀ heteroarylalkyl group, -Si(Q₁₁)(Q₁₂)(Q₁₃), -N(Q₁₁)(Q₁₂), -B(Q₁₁)(Q₁₂), - C(=O)(Q₁₁), -S(=O)₂(Q₁₁), -P(=O)(Q₁₁)(Q₁₂), or any combination thereof,
a C₃-C₆₀ carbocyclic group, a C₁-C₆₀ heterocyclic group, a C₆-C₆₀ aryloxy group, a C₆-C₆₀ arylthio group, a C₇-C₆₀ arylalkyl group, or a C₂-C₆₀ heteroarylalkyl group, each unsubstituted or substituted with deuterium, -F, -Cl, -Br, -I, a hydroxyl group, a cyano group, a nitro group, a C₁-C₆₀ alkyl group, a C₂-C₆₀ alkenyl group, a C₂-C₆₀ alkynyl group, a C₁-C₆₀ alkoxy group, a C₃-C₆₀ carbocyclic group, a C₁-C₆₀ heterocyclic group, a C₆-C₆₀ aryloxy group, a C₆-C₆₀ arylthio group, a C₇-C₆₀ arylalkyl group, a C₂-C₆₀ heteroarylalkyl group, -Si(Q₂₁)(Q₂₂)(Q₂₃), -N(Q₂₁)(Q₂₂), -B(Q₂₁)(Q₂₂), - C(=O)(Q₂₁), -S(=O)₂(Q₂₁), -P(=O)(Q₂₁)(Q₂₂), or any combination thereof, or
-Si(Q₃₁)(Q₃₂)(Q₃₃), -N(Q₃₁)(Q₃₂), -B(Q₃₁)(Q₃₂), -C(=O)(Q₃₁), -S(=O)₂(Q₃₁), or - P(=O)(Q₃₁)(Q₃₂),
Q₁ to Q₃, Q₁₁ to Q₁₃, Q₂₁ to Q₂₃, and Q₃₁ to Q₃₃ are each independently hydrogen, deuterium, -F, -Cl, -Br, -I, a hydroxyl group, a cyano group, a nitro group, or a C₁-C₆₀ alkyl group, a C₂-C₆₀ alkenyl group, a C₂-C₆₀ alkynyl group, a C₁-C₆₀ alkoxy group, a C₃-C₆₀ carbocyclic group, or a C₁-C₆₀ heterocyclic group, each unsubstituted or substituted with deuterium, -F, a cyano group, a C₁-C₆₀ alkyl group, a C₁-C₆₀ alkoxy group, a phenyl group, a biphenyl group, or any combination thereof, and
C^{a} and C^{b} in Formulae 2-1 to 2-3 are carbon atoms corresponding to C^{a} and C^{b} in Formula 1, respectively.

According to one or more embodiments, each of an electronic apparatus and an electronic equipment include the light-emitting device.

According to one or more embodiments, provided is the condensed cyclic compound represented by Formula 1.

At least some of the above and other features of the invention are set out in the claims.

### BRIEF DESCRIPTION OF THE DRAWINGS

The accompanying drawings are included to provide a further understanding of the preceding and other aspects, features, and advantages of certain embodiments of the disclosure are incorporated in and constitute a part of this specification. The drawings illustrate example embodiments and, together with the following description taken in conjunction with the accompanying drawings. In the drawings:
FIG. 1 is a schematic view of a structure of a light-emitting device according to one or more embodiments;
FIG. 2 is a schematic view of a structure of an electronic apparatus according to one or more embodiments;
FIG. 3 is a schematic view of a structure of an electronic apparatus according to one or more embodiments;
FIG. 4 is a schematic view of electronic equipment according to one or more embodiments;
FIG. 5 is a schematic view of the exterior of a vehicle as electronic equipment including a light-emitting device according to one or more embodiments; and
FIGS. 6A-6C are each a schematic view of the interior of a vehicle according to one or more embodiments.

### DETAILED DESCRIPTION

Reference will now be made in more detail to one or more embodiments, examples of which are illustrated in the accompanying drawings, wherein like reference numerals refer to like elements throughout, and duplicative descriptions thereof may not be provided the specification. In this regard, the present embodiments may have different forms and should not be construed as being limited to the descriptions set forth herein. Accordingly, one or more embodiments are merely described in more detail, by referring to the drawings, to explain aspects of the present description.

As used herein, the term "and/or" includes any and all combinations of one or more of the associated listed items. Expressions such as "at least one of," "one of," "selected from," and "selected from among," when preceding a list of elements, modify the entire list of elements and do not modify the individual elements of the list. For example, throughout the disclosure, the expression "at least one of a, b or c" indicates only a, only b, only c, both (e.g., simultaneously) a and b, both (e.g., simultaneously) a and c, both (e.g., simultaneously) b and c, all of a, b, and c, or variations thereof.

Unless otherwise defined, all chemical names, technical and scientific terms, and terms defined in common dictionaries should be interpreted as having meanings consistent with the context of the related art, and should not be interpreted in an ideal or overly formal sense. It will be understood that although the terms "first," "second," and/or the like, may be used herein to describe one or more suitable components, these components should not be limited by these terms. These components are only used to distinguish one component from another.

An expression used in the singular such as "a," "an," and "the" encompasses the expression of the plural, unless it has a clearly different meaning in the context.

It will be further understood that the terms "has," "have," "having," "include," "includes," " including," "comprise," "comprises" and/or "comprising," as used herein, specify the presence of stated features or elements, but do not preclude the presence or addition of one or more other features or elements. Additionally, the terms "comprise(s)/comprising," "include(s)/including," "have/has/having", or other similar terms include or support the terms "consisting of" and "consisting essentially of," indicating the presence of stated features, integers, steps, operations, elements, and/or components, without or essentially without the presence of other features, integers, steps, operations, elements, components, and/or groups thereof.

The term "may" will be understood to refer to "one or more embodiments of the present disclosure," some of which include the described element and some of which exclude that element and/or include an alternate element. Similarly, alternative language such as "or" refers to "one or more embodiments of the present disclosure," each including a corresponding listed item.

In the following embodiments, if (e.g., when) one or more suitable components such as layers, films, regions, plates, and/or the like, are said to be "on" another component, this may include not only a case in which other components are "immediately on" the layers, films, regions, or plates, but also a case in which other components may be placed therebetween. Sizes of elements in the drawings may be exaggerated for convenience of explanation. For example, because sizes and thicknesses of components in the drawings are arbitrarily illustrated for convenience of explanation, the following embodiments are not limited thereto.

Spatially relative terms, such as "beneath," "below," "lower," "above," "upper," "bottom," "top," and the like, may be used herein for ease of description to describe one element or feature's relationship to another element(s) or feature(s) as illustrated in the drawings. It will be understood that the spatially relative terms are intended to encompass different orientations of the device in use or operation in addition to the orientation depicted in the drawings. For example, if the device in the drawings is turned over, elements described as "below" or "beneath" other elements or features would then be oriented "above" or "over" the other elements or features. Thus, the term "below" may encompass both (e.g., simultaneously) an orientation of above and below. The device may be otherwise oriented (rotated 90 degrees or at other orientations), and the spatially relative descriptors used herein should be interpreted accordingly.

The term "interlayer" as used herein refers to a single layer and/or all of multiple layers arranged between the first electrode and the second electrode of the light-emitting device.

In this context, "consisting essentially of" indicates that any additional components will not materially affect the chemical, physical, optical or electrical properties of the semiconductor film.

Further, in this specification, the phrase "on a plane," or "plan view," indicates viewing a target portion from the top, and the phrase "on a cross-section" indicates viewing a cross-section formed by vertically cutting a target portion from the side.

### Light-emitting device

An aspect of the disclosure provides a light-emitting device including: a first electrode; a second electrode opposite to (e.g., facing) the first electrode; an interlayer arranged between the first electrode and the second electrode and including an emission layer; and a condensed cyclic compound represented by Formula 1: 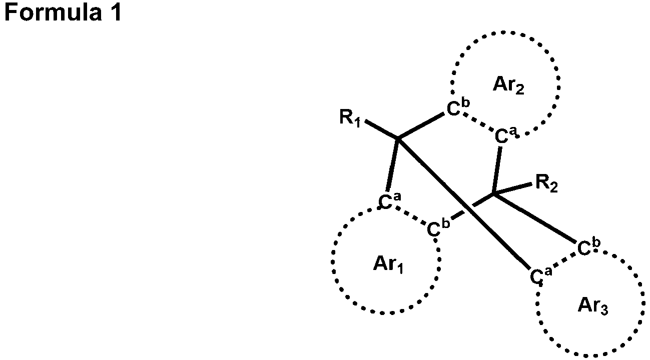
wherein, in Formula 1,
Ar₁ to Ar₃ are each independently any one of groups represented by Formulae 2-1 to 2-3,
if (e.g., when), among Ar₁ to Ar₃, there are rings represented by the same formula, the rings are substantially identical to (e.g. identical to) or different from each other, 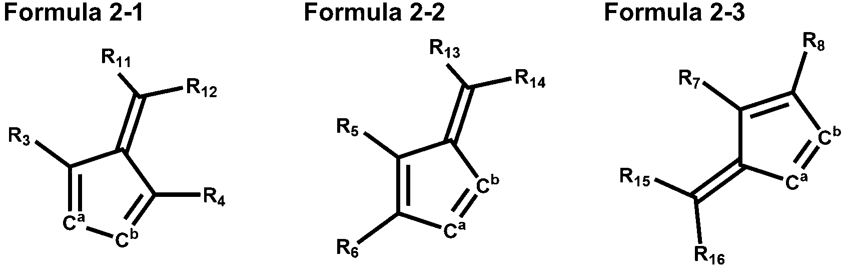
wherein, in Formulae 1 and 2-1 to 2-3,
R₁ to R₈ and R₁₁ to R₁₆ are each independently hydrogen, deuterium, -F, -Cl, -Br, -I, a hydroxyl group, a cyano group, a nitro group, a C₁-C₆₀ (e.g. C₁-C₂₀) alkyl group unsubstituted or substituted with at least one R₁₀ₐ, a C₂-C₆₀ (e.g. C₂-C₂₀) alkenyl group unsubstituted or substituted with at least one R₁₀ₐ, a C₂-C₆₀ (e.g. C₂-C₂₀) alkynyl group unsubstituted or substituted with at least one R₁₀ₐ, a C₁-C₆₀ (e.g. C₁-C₂₀) alkoxy group unsubstituted or substituted with at least one R₁₀ₐ, a C₃-C₆₀ (e.g. C₃-C₃₀) carbocyclic group unsubstituted or substituted with at least one R₁₀ₐ, a C₁-C₆₀ (e.g. C₁-C₂₀) heterocyclic group unsubstituted or substituted with at least one R₁₀ₐ, - C(Q₁)(Q₂)(Q₃), -Si(Q₁)(Q₂)(Q₃), -N(Q₁)(Q₂), -B(Q₁)(Q₂), -C(=O)(Q₁), -S(=O)₂(Q₁), or - P(=O)(Q₁)(Q₂),
C^{a} and C^{b} in Formula 1 represent carbon atoms,
R₁₀ₐ is:
deuterium, -F, -Cl, -Br, -I, a hydroxyl group, a cyano group, or a nitro group;
a C₁-C₆₀ (e.g. C₁-C₂₀) alkyl group, a C₂-C₆₀ (e.g. C₂-C₂₀) alkenyl group, a C₂-C₆₀ (e.g. C₂-C₂₀) alkynyl group, or a C₁-C₆₀ (e.g. C₁-C₂₀) alkoxy group, each unsubstituted or substituted with deuterium, -F, -Cl, -Br, -I, a hydroxyl group, a cyano group, a nitro group, a C₃-C₆₀ (e.g. C₃-C₃₀) carbocyclic group, a C₁-C₆₀ (e.g. C₁-C₂₀) heterocyclic group, a C₆-C₆₀ (e.g. C₆-C₃₀) aryloxy group, a C₆-C₆₀ (e.g. C₆-C₃₀) arylthio group, a C₇-C₆₀ (e.g. C₇-C₃₀) arylalkyl group, a C₂-C₆₀ (e.g. C₂-C₂₀) heteroarylalkyl group, -Si(Q₁₁)(Q₁₂)(Q₁₃), -N(Q₁₁)(Q₁₂), -B(Q₁₁)(Q₁₂), -C(=O)(Q₁₁), -S(=O)₂(Q₁₁), - P(=O)(Q₁₁)(Q₁₂), or any combination thereof;
a C₃-C₆₀ (e.g. C₃-C₃₀) carbocyclic group, a C₁-C₆₀ (e.g. C₁-C₂₀) heterocyclic group, a C₆-C₆₀ (e.g. C₆-C₃₀) aryloxy group, a C₆-C₆₀ (e.g. C₆-C₃₀) arylthio group, a C₇-C₆₀ (e.g. C₇-C₃₀) arylalkyl group, or a C₂-C₆₀ (e.g. C₂-C₂₀) heteroarylalkyl group, each unsubstituted or substituted with deuterium, -F, -Cl, -Br, -I, a hydroxyl group, a cyano group, a nitro group, a C₁-C₆₀ (e.g. C₁-C₂₀) alkyl group, a C₂-C₆₀ (e.g. C₂-C₂₀) alkenyl group, a C₂-C₆₀ (e.g. C₂-C₂₀) alkynyl group, a C₁-C₆₀ (e.g. C₁-C₂₀) alkoxy group, a C₃-C₆₀ (e.g. C₃-C₃₀) carbocyclic group, a C₁-C₆₀ (e.g. C₁-C₂₀) heterocyclic group, a C₆-C₆₀ (e.g. C₆-C₃₀) aryloxy group, a C₆-C₆₀ (e.g. C₆-C₃₀) arylthio group, a C₇-C₆₀ (e.g. C₇-C₃₀) arylalkyl group, a C₂-C₆₀ (e.g. C₂-C₂₀) heteroarylalkyl group, -Si(Q₂₁)(Q₂₂)(Q₂₃), - N(Q₂₁)(Q₂₂), -B(Q₂₁)(Q₂₂), -C(=O)(Q₂₁), -S(=O)₂(Q₂₁), -P(=O)(Q₂₁)(Q₂₂), or any combination thereof; or
-Si(Q₃₁)(Q₃₂)(Q₃₃), -N(Q₃₁)(Q₃₂), -B(Q₃₁)(Q₃₂), -C(=O)(Q₃₁), -S(=O)₂(Q₃₁), or - P(=O)(Q₃₁)(Q₃₂),
Q₁ to Q₃, Q₁₁ to Q₁₃, Q₂₁ to Q₂₃, and Q₃₁ to Q₃₃ are each independently: hydrogen; deuterium; -F; -Cl; -Br; -I; a hydroxyl group; a cyano group; a nitro group; or a C₁-C₆₀ (e.g. C₁-C₂₀) alkyl group, a C₂-C₆₀ (e.g. C₂-C₂₀) alkenyl group, a C₂-C₆₀ (e.g. C₂-C₂₀) alkynyl group, a C₁-C₆₀ (e.g. C₁-C₂₀) alkoxy group, a C₃-C₆₀ (e.g. C₃-C₃₀) carbocyclic group, or a C₁-C₆₀ (e.g. C₁-C₂₀) heterocyclic group, each unsubstituted or substituted with deuterium, -F, a cyano group, a C₁-C₆₀ (e.g. C₁-C₂₀) alkyl group, a C₁-C₆₀ (e.g. C₁-C₂₀) alkoxy group, a phenyl group, a biphenyl group, or any combination thereof, and
C^{a} and C^{b} in Formulae 2-1 to 2-3 are carbon atoms corresponding to C^{a} and C^{b} in Formula 1, respectively.

In one or more embodiments, if (e.g., when), among Ar₁ to Ar₃, there are rings represented by the same formula, the rings may be substantially identical (e.g. identical) to or different from each other. For example, i) if (e.g., when) Ar₁ and Ar₂ are each represented by Formula 2-1, R₃, R₄, R₁₁, and R₁₂ in Formula 2-1 for Ar₁ may be substantially identical (e.g. identical) to or different from R₃, R₄, R₁₁, and R₁₂ in Formula 2-1 for Ar₂, respectively, ii) if (e.g., when) Ar₁ and Ar₂ are each represented by Formula 2-2, R₅, R₆, R₁₃, and R₁₄ in Formula 2-2 for Ar₁ may be substantially identical (e.g. identical) to or different from R₅, R₆, R₁₃, and R₁₄ in Formula 2-2 for Ar₂, respectively, iii) if (e.g., when) Ar₁ and Ar₂ are each represented by Formula 2-3, R₇, R₈, R₁₅, and R₁₆ in Formula 2-3 for Ar₁ may be substantially identical (e.g. identical) to or different from R₇, R₈, R₁₅, and R₁₆ in Formula 2-3 for Ar₂, respectively, iv) if (e.g., when) Ar₁ and Ar₃ are each represented by Formula 2-1, R₃, R₄, R₁₁, and R₁₂ in Formula 2-1 for Ar₁ may be substantially identical (e.g. identical) to or different from R₃, R₄, R₁₁, and R₁₂ in Formula 2-1 for Ar₃, respectively, v) if (e.g., when) Ar₁ and Ar₃ are each represented by Formula 2-2, R₅, R₆, R₁₃, and R₁₄ in Formula 2-2 for Ar₁ may be substantially identical (e.g. identical) to or different from R₅, R₆, R₁₃, and R₁₄ in Formula 2-2 for Ar₃, respectively, vi) if (e.g., when) Ar₁ and Ar₃ are each represented by Formula 2-3, R₇, R₈, R₁₅, and R₁₆ in Formula 2-3 for Ar₁ may be substantially identical (e.g. identical) to or different from R₇, R₈, R₁₅, and R₁₆ in Formula 2-3 for Ar₃, respectively, vii) if (e.g., when) Ar₂ and Ar₃ are each represented by Formula 2-1, R₃, R₄, R₁₁, and R₁₂ in Formula 2-1 for Ar₂ may be substantially identical (e.g. identical) to or different from R₃, R₄, R₁₁, and R₁₂ in Formula 2-1 for Ar₃, respectively, viii) if (e.g., when) Ar₂ and Ar₃ are each represented by Formula 2-2, R₅, R₆, R₁₃, and R₁₄ in Formula 2-2 for Ar₂ may be substantially identical (e.g. identical) to or different from R₅, R₆, R₁₃, and R₁₄ in Formula 2-2 for Ar₃, respectively, and ix) if (e.g., when) Ar₂ and Ar₃ are each represented by Formula 2-3, (then) R₇, R₈, R₁₅, and R₁₆ in Formula 2-3 for Ar₂ may be substantially identical (e.g. identical) to or different from R₇, R₈, R₁₅, and R₁₆ in Formula 2-3 for Ar₃, respectively.

In one or more embodiments, the condensed cyclic compound may have a symmetrical structure.

In one or more embodiments, the condensed cyclic compound may not have a symmetrical structure.

In one or more embodiments, the condensed cyclic compound may have a lowest unoccupied molecular orbital (LUMO) energy level in a range of about -6.00 electron volt (eV) to about -5.00 eV, about -5.90 eV to about -5.00 eV, about -5.80 eV to about -5.00 eV, about -5.70 eV to about -5.00 eV, about -5.60 eV to about -5.00 eV, or about -5.50 eV to about -5.00 eV.

In one or more embodiments, the condensed cyclic compound may have a glass transition temperature (T_{g}) in a range of about 100 °C to about 160 °C.

In one or more embodiments, the condensed cyclic compound may include deuterium, -F, a cyano group, a tert-butyl group, a C₁-C₂₀ (e.g. C₁-C₁₀) alkoxy group, a phenyl group, or any combination thereof.

In one or more embodiments, at least two of Ar₁ to Ar₃ may be substantially identical (e.g. identical) to each other.

In one or more embodiments, Ar₁ to Ar₃ may be substantially identical (e.g. identical) to each other.

In one or more embodiments, Ar₁ to Ar₃ may be different from each other.

In one or more embodiments, the condensed cyclic compound may include at least one cyano group, and

the number of cyano groups included in the condensed cyclic compound may be 1 to 18.

In one or more embodiments, the condensed cyclic compound may not include (e.g., may exclude any) fluorine (F).

In one or more embodiments, R₁ to R₈ and R₁₁ to R₁₆ may each independently be: hydrogen, deuterium, -F, or a cyano group; a C₁-C₂₀ (e.g. C₁-C₁₀) alkyl group or a C₁-C₂₀ (e.g. C₁-C₁₀) alkoxy group, each unsubstituted or substituted with deuterium, -F, a cyano group, or any combination thereof; or a C₃-C₆₀ (e.g. C₃-C₃₀) carbocyclic group or a C₁-C₆₀ (e.g. C₁-C₂₀) heterocyclic group, each unsubstituted or substituted with deuterium, -F, a cyano group, a C₁-C₂₀ (e.g. C₁-C₁₀) alkyl group, a C₁-C₂₀ (e.g. C₁-C₁₀) alkoxy group, or any combination thereof.

In one or more embodiments, R₁ to R₈ and R₁₁ to R₁₆ may each independently be:
hydrogen, deuterium, -F, or a cyano group;
a methyl group, an ethyl group, an n-propyl group, an isopropyl group, an n-butyl group, a sec-butyl group, an isobutyl group, a tert-butyl group, an n-pentyl group, a tert-pentyl group, a neopentyl group, an isopentyl group, a sec-pentyl group, a 3-pentyl group, a sec-isopentyl group, an n-hexyl group, an isohexyl group, a sec-hexyl group, a tert-hexyl group, an n-heptyl group, an isoheptyl group, a sec-heptyl group, a tert-heptyl group, an n-octyl group, an isooctyl group, a sec-octyl group, a tert-octyl group, an n-nonyl group, an isononyl group, a sec-nonyl group, a tert-nonyl group, an n-decyl group, an isodecyl group, a sec-decyl group, a tert-decyl group, a methoxy group, an ethoxy group, an n-propoxy group, an isopropoxy group, an n-butoxy group, a sec-butoxy group, an isobutoxy group, a tert-butoxy group, an n-pentoxy group, a tert-pentoxy group, a 2,2-dimethylpropoxy group, an isopentoxy group, a sec-pentoxy group, or a 3-pentoxy group, each unsubstituted or substituted with deuterium, -F, a cyano group, or any combination thereof; or
a benzene group, a pentalene group, a naphthalene group, an azulene group, an indacene group, an acenaphthylene group, a phenalene group, a phenanthrene group, an anthracene group, a pyrrole group, a thiophene group, a furan group, an indole group, a benzoindole group, a naphthoindole group, an isoindole group, a benzoisoindole group, a naphthoisoindole group, a benzosilole group, a benzothiophene group, a benzofuran group, a carbazole group, a dibenzosilole group, a dibenzothiophene group, a dibenzofuran group, an indenocarbazole group, an indolocarbazole group, a benzofurocarbazole group, a benzothienocarbazole group, a benzosilolocarbazole group, a benzoindolocarbazole group, a benzocarbazole group, a benzonaphthofuran group, a benzonaphthothiophene group, a benzonaphthosilole group, a benzofurodibenzofuran group, a benzofurodibenzothiophene group, a benzothienodibenzothiophene group, a pyrazole group, an imidazole group, a triazole group, an oxazole group, an isoxazole group, an oxadiazole group, a thiazole group, an isothiazole group, a thiadiazole group, a benzopyrazole group, a benzimidazole group, a benzoxazole group, a benzoisoxazole group, a benzothiazole group, a benzoisothiazole group, a pyridine group, a pyrimidine group, a pyrazine group, a pyridazine group, a triazine group, a quinoline group, an isoquinoline group, a benzoquinoline group, a benzoisoquinoline group, a quinoxaline group, a benzoquinoxaline group, a quinazoline group, a benzoquinazoline group, a phenanthroline group, a cinnoline group, a phthalazine group, a naphthyridine group, an imidazopyridine group, an imidazopyrimidine group, an imidazotriazine group, an imidazopyrazine group, an imidazopyridazine group, an azacarbazole group, an azafluorene group, an azadibenzosilole group, an azadibenzothiophene group, or an azadibenzofuran group, each unsubstituted or substituted with deuterium, -F, a cyano group, a methyl group, an ethyl group, an n-propyl group, an isopropyl group, an n-butyl group, a sec-butyl group, an isobutyl group, a tert-butyl group, an n-pentyl group, a tert-pentyl group, a neopentyl group, an isopentyl group, a sec-pentyl group, a 3-pentyl group, a sec-isopentyl group, an n-hexyl group, an isohexyl group, a sec-hexyl group, a tert-hexyl group, an n-heptyl group, an isoheptyl group, a sec-heptyl group, a tert-heptyl group, an n-octyl group, an isooctyl group, a sec-octyl group, a tert-octyl group, an n-nonyl group, an isononyl group, a sec-nonyl group, a tert-nonyl group, an n-decyl group, an isodecyl group, a sec-decyl group, a tert-decyl group, a methoxy group, an ethoxy group, an n-propoxy group, an isopropoxy group, an n-butoxy group, a sec-butoxy group, an isobutoxy group, a tert-butoxy group, an n-pentoxy group, a tert-pentoxy group, a 2,2-dimethylpropoxy group, an isopentoxy group, a sec-pentoxy group, a 3-pentoxy group, or any combination thereof.

In one or more embodiments, R₁ to R₈ and R₁₁ to R₁₆ may each independently be:
hydrogen, deuterium, -F, a cyano group, -CH₃, -CH₂F, -CHF₂, -CF₃, -C₂H₅, - C₂H₄F, -C₂H₃F₂, -C₂H₂F₃, -C₂HF₄, -C₂F₅, -OCH₃, -OCH₂F, -OCHF₂, -OCF₃, -OC₂H₅, - OC₂H₄F, -OC₂H₃F₂, -OC₂H₂F₃, -OC₂HF₄, or -OC₂F₅; or
a benzene group, a pyridine group, a pyrimidine group, a pyrazine group, a pyridazine group, or a triazine group, each unsubstituted or substituted with deuterium, -F, a cyano group, -CH₃, -CH₂F, -CHF₂, -CF₃, -C₂H₅, -C₂H₄F, -C₂H₃F₂, -C₂H₂F₃, - C₂HF₄, -C₂F₅, -OCH₃, -OCH₂F, -OCHF₂, -OCF₃, -OC₂H₅, -OC₂H₄F, -OC₂H₃F₂, - OC₂H₂F₃, -OC₂HF₄, -OC₂F₅, or any combination thereof.

In one or more embodiments, at least one of R₁ and R₂ may be hydrogen, deuterium, -F, a cyano group, or a pyridine group.

In one or more embodiments, R₃ to R₈ and R₁₁ to R₁₆ may each independently be: hydrogen, deuterium, -F, or a cyano group; a C₁-C₂₀ (e.g. C₁-C₁₀) alkyl group or a C₁-C₂₀ (e.g. C₁-C₁₀) alkoxy group, each unsubstituted or substituted with deuterium, -F, a cyano group, or any combination thereof; or a group represented by Formula 3: 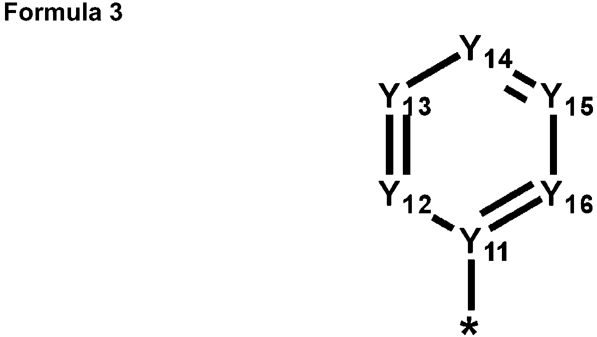
wherein, in Formula 3,
Y₁₁ is C or N,
Y₁₂ is C(Z₁₂) or N, Y₁₃ is C(Z₁₃) or N, Y₁₄ is C(Z₁₄) or N, Y₁₅ is C(Z₁₅) or N, and Y₁₆ is C(Z₁₆) or N,
Z₁₂ to Z₁₆ are each independently: hydrogen, deuterium, -F, or a cyano group; a C₁-C₂₀ (e.g. C₁-C₁₀) alkyl group or a C₁-C₂₀ (e.g. C₁-C₁₀) alkoxy group, each unsubstituted or substituted with deuterium, -F, a cyano group, or any combination thereof; or a C₃-C₆₀ (e.g. C₃-C₃₀) carbocyclic group or a C₁-C₆₀ (e.g. C₁-C₂₀) heterocyclic group, each unsubstituted or substituted with deuterium, -F, a cyano group, a C₁-C₂₀ (e.g. C₁-C₁₀) alkyl group, a C₁-C₂₀ (e.g. C₁-C₁₀) alkoxy group, or any combination thereof, and
* indicates a binding site to a neighboring atom.

In one or more embodiments, R₃ to R₈ and R₁₁ to R₁₆ may each independently be: hydrogen, deuterium, -F, or a cyano group; a methyl group, a tert-butyl group, -OCH₃, or -OC₂H₅, each unsubstituted or substituted with deuterium, -F, a cyano group, or any combination thereof; or a group represented by one of Formulae 3-1 to 3-22: 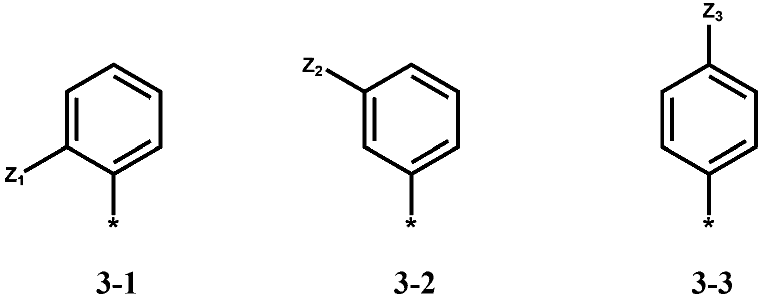 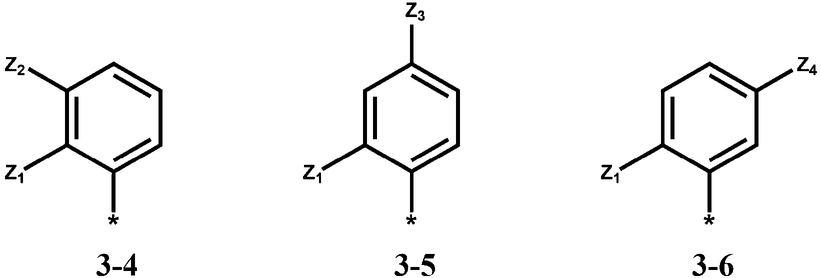 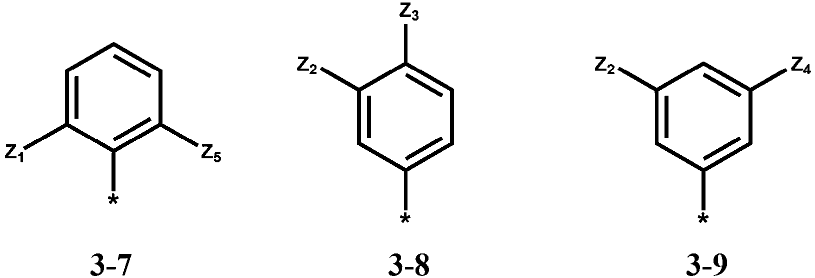 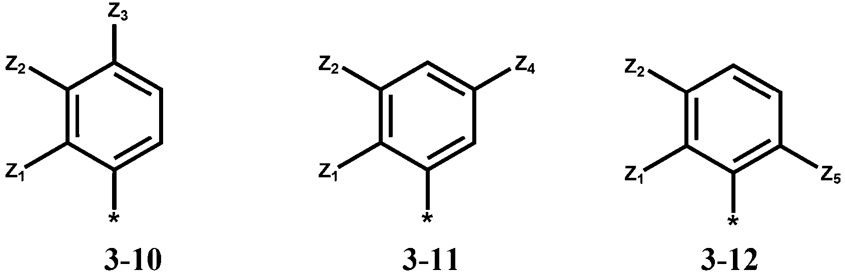 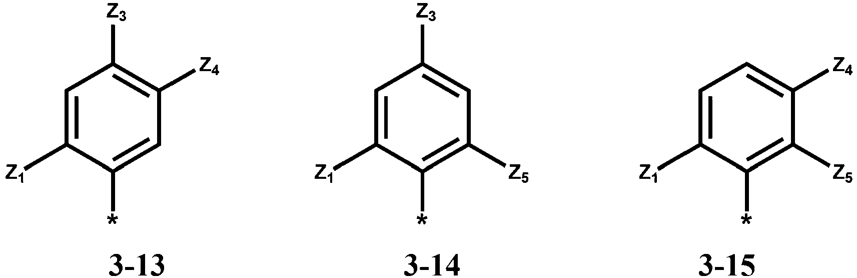 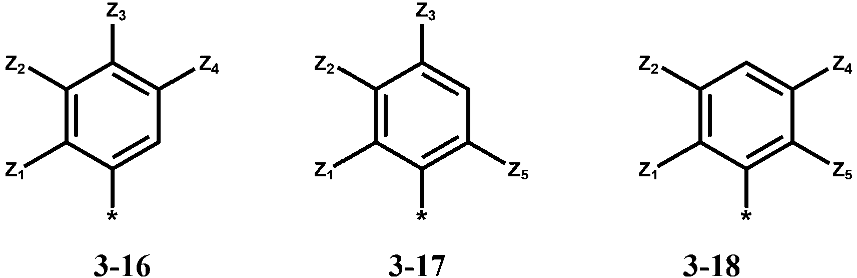 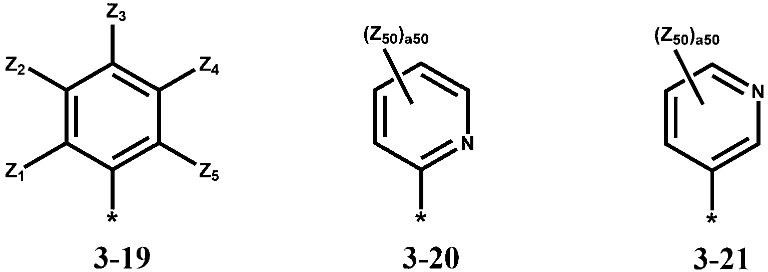 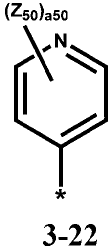
wherein, in Formulae 3-1 to 3-22,
a50 is an integer from 0 to 5,
Z₁ to Z₅ and Z₅₀ are each independently: deuterium, -F, or a cyano group; a C₁-C₂₀ (e.g. C₁-C₁₀) alkyl group or a C₁-C₂₀ (e.g. C₁-C₁₀) alkoxy group, each unsubstituted or substituted with deuterium, -F, a cyano group, or any combination thereof; or a C₃-C₆₀ (e.g. C₃-C₃₀) carbocyclic group or a C₁-C₆₀ (e.g. C₁-C₂₀) heterocyclic group, each unsubstituted or substituted with deuterium, -F, a cyano group, a C₁-C₂₀ (e.g. C₁-C₁₀) alkyl group, a C₁-C₂₀ (e.g. C₁-C₁₀) alkoxy group, or any combination thereof, and
* indicates a binding site to a neighboring atom.

In one or more embodiments, at least one of Z₁ to Z₅ in Formulae 3-1 to 3-9 may not be hydrogen.

In one or more embodiments, the condensed cyclic compound may be any one of groups represented by Formulae 1-1 to 1-6: 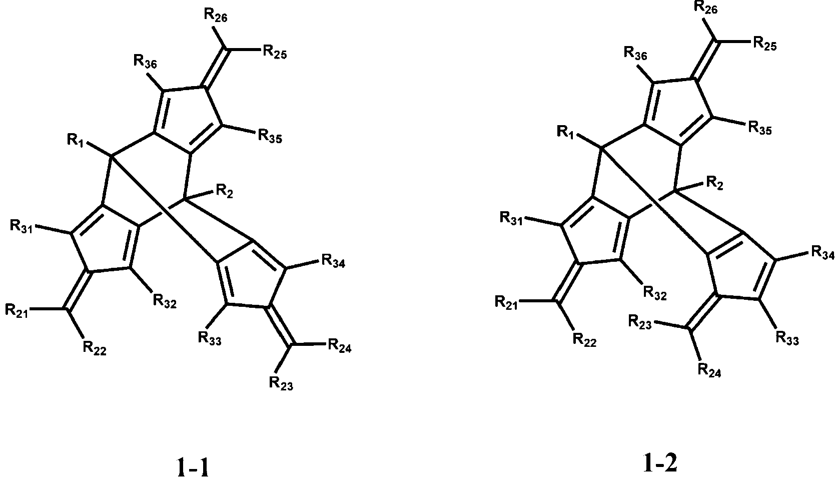 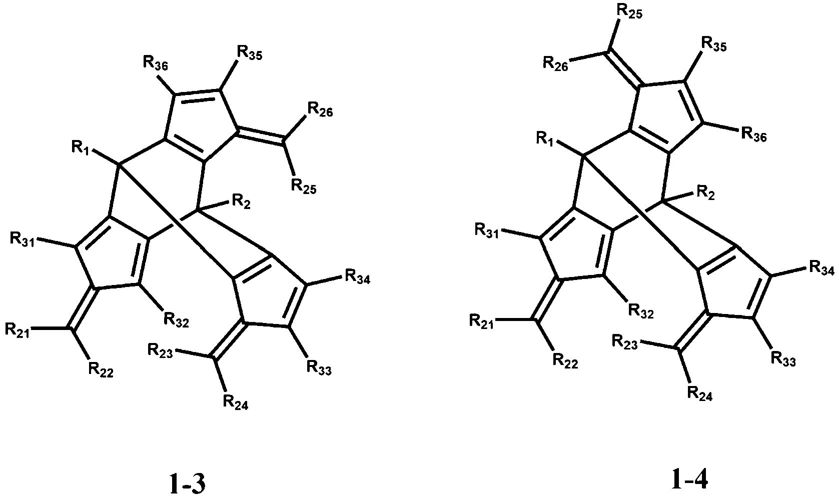 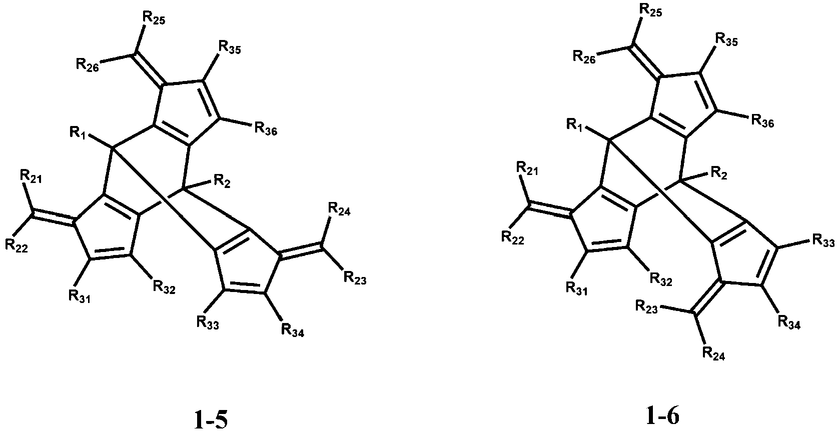
wherein, in Formulae 1-1 to 1-6,
R₁ and R₂ are each as described herein,
R₂₁ to R₂₆ and R₃₁ to R₃₆ are each independently hydrogen, deuterium, -F, - Cl, -Br, -I, a hydroxyl group, a cyano group, a nitro group, a C₁-C₆₀ (e.g. C₁-C₂₀) alkyl group unsubstituted or substituted with at least one R₁₀ₐ, a C₂-C₆₀ (e.g. C₂-C₂₀) alkenyl group unsubstituted or substituted with at least one R₁₀ₐ, a C₂-C₆₀ (e.g. C₂-C₂₀) alkynyl group unsubstituted or substituted with at least one R₁₀ₐ, a C₁-C₆₀ (e.g. C₁-C₂₀) alkoxy group unsubstituted or substituted with at least one R₁₀ₐ, a C₃-C₆₀ (e.g. C₃-C₃₀) carbocyclic group unsubstituted or substituted with at least one R₁₀ₐ, a C₁-C₆₀ (e.g. C₁-C₂₀) heterocyclic group unsubstituted or substituted with at least one R₁₀ₐ, - C(Q₁)(Q₂)(Q₃), -Si(Q₁)(Q₂)(Q₃), -N(Q₁)(Q₂), -B(Q₁)(Q₂), -C(=O)(Q₁), -S(=O)₂(Q₁), or - P(=O)(Q₁)(Q₂),
R₁₀ₐ is:
deuterium, -F, -Cl, -Br, -I, a hydroxyl group, a cyano group, or a nitro group;
a C₁-C₆₀ (e.g. C₁-C₂₀) alkyl group, a C₂-C₆₀ (e.g. C₂-C₂₀) alkenyl group, a C₂-C₆₀ (e.g. C₂-C₂₀) alkynyl group, or a C₁-C₆₀ (e.g. C₁-C₂₀) alkoxy group, each unsubstituted or substituted with deuterium, -F, -Cl, -Br, -I, a hydroxyl group, a cyano group, a nitro group, a C₃-C₆₀ (e.g. C₃-C₃₀) carbocyclic group, a C₁-C₆₀ (e.g. C₁-C₂₀) heterocyclic group, a C₆-C₆₀ (e.g. C₆-C₃₀) aryloxy group, a C₆-C₆₀ (e.g. C₆-C₃₀) arylthio group, a C₇-C₆₀ (e.g. C₇-C₃₀) arylalkyl group, a C₂-C₆₀ (e.g. C₂-C₂₀) heteroarylalkyl group, -Si(Q₁₁)(Q₁₂)(Q₁₃), -N(Q₁₁)(Q₁₂), -B(Q₁₁)(Q₁₂), -C(=O)(Q₁₁), -S(=O)₂(Q₁₁), - P(=O)(Q₁₁)(Q₁₂), or any combination thereof;
a C₃-C₆₀ (e.g. C₃-C₃₀) carbocyclic group, a C₁-C₆₀ (e.g. C₁-C₂₀) heterocyclic group, a C₆-C₆₀ (e.g. C₆-C₃₀) aryloxy group, a C₆-C₆₀ (e.g. C₆-C₃₀) arylthio group, a C₇-C₆₀ (e.g. C₇-C₃₀) arylalkyl group, or a C₂-C₆₀ (e.g. C₂-C₂₀) heteroarylalkyl group, each unsubstituted or substituted with deuterium, -F, -Cl, -Br, -I, a hydroxyl group, a cyano group, a nitro group, a C₁-C₆₀ (e.g. C₁-C₂₀) alkyl group, a C₂-C₆₀ (e.g. C₂-C₂₀) alkenyl group, a C₂-C₆₀ (e.g. C₂-C₂₀) alkynyl group, a C₁-C₆₀ (e.g. C₁-C₂₀) alkoxy group, a C₃-C₆₀ (e.g. C₃-C₃₀) carbocyclic group, a C₁-C₆₀ (e.g. C₁-C₂₀) heterocyclic group, a C₆-C₆₀ (e.g. C₆-C₃₀) aryloxy group, a C₆-C₆₀ (e.g. C₆-C₃₀) arylthio group, a C₇-C₆₀ (e.g. C₇-C₃₀) arylalkyl group, a C₂-C₆₀ (e.g. C₂-C₂₀) heteroarylalkyl group, -Si(Q₂₁)(Q₂₂)(Q₂₃), - N(Q₂₁)(Q₂₂), -B(Q₂₁)(Q₂₂), -C(=O)(Q₂₁), -S(=O)₂(Q₂₁), -P(=O)(Q₂₁)(Q₂₂), or any combination thereof; or
-Si(Q₃₁)(Q₃₂)(Q₃₃), -N(Q₃₁)(Q₃₂), -B(Q₃₁)(Q₃₂), -C(=O)(Q₃₁), -S(=O)₂(Q₃₁), or - P(=O)(Q₃₁)(Q₃₂), and
Q₁ to Q₃, Q₁₁ to Q₁₃, Q₂₁ to Q₂₃, and Q₃₁ to Q₃₃ are each independently: hydrogen; deuterium; -F; -Cl; -Br; -I; a hydroxyl group; a cyano group; a nitro group; or a C₁-C₆₀ (e.g. C₁-C₂₀) alkyl group, a C₂-C₆₀ (e.g. C₂-C₂₀) alkenyl group, a C₂-C₆₀ (e.g. C₂-C₂₀) alkynyl group, a C₁-C₆₀ (e.g. C₁-C₂₀) alkoxy group, a C₃-C₆₀ (e.g. C₃-C₃₀) carbocyclic group, or a C₁-C₆₀ (e.g. C₁-C₂₀) heterocyclic group, each unsubstituted or substituted with deuterium, -F, a cyano group, a C₁-C₆₀ (e.g. C₁-C₂₀) alkyl group, a C₁-C₆₀ (e.g. C₁-C₂₀) alkoxy group, a phenyl group, a biphenyl group, or any combination thereof.

In one or more embodiments, the condensed cyclic compound may be any one selected from among Compounds 1 to 72:

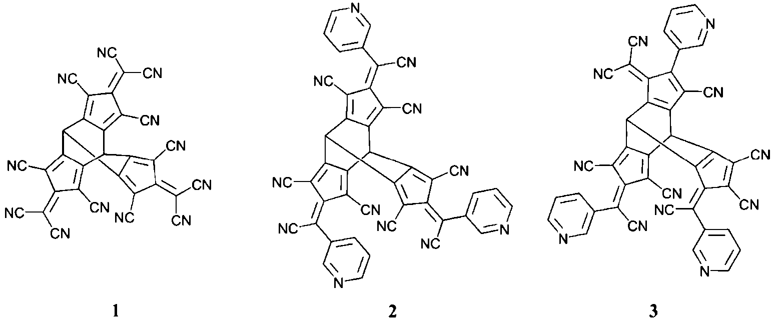

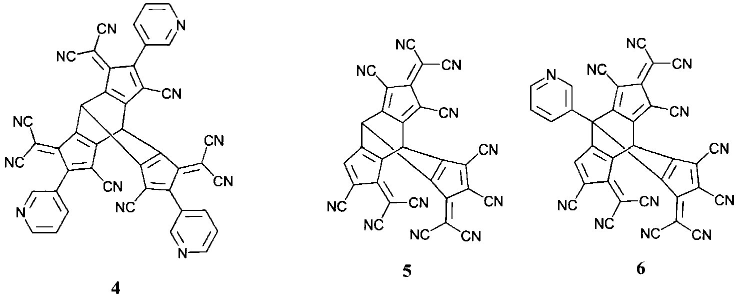

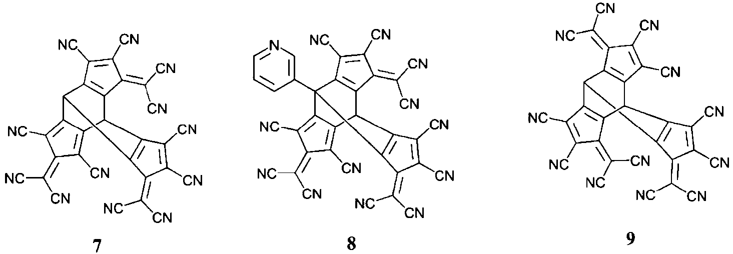

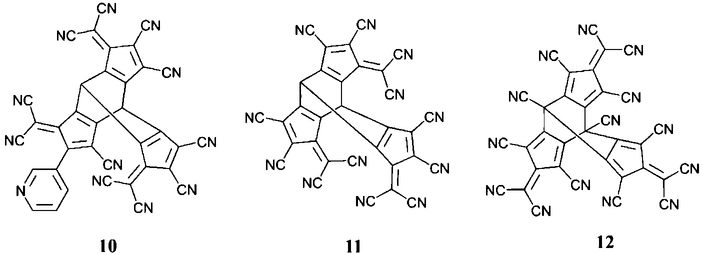

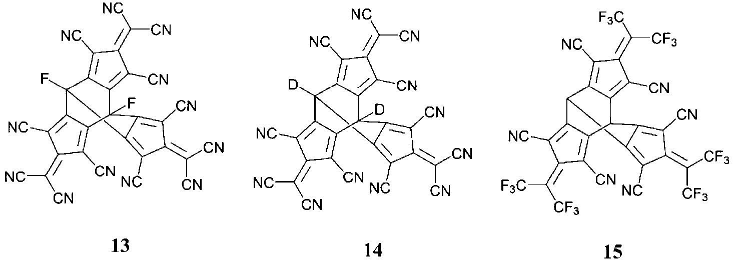

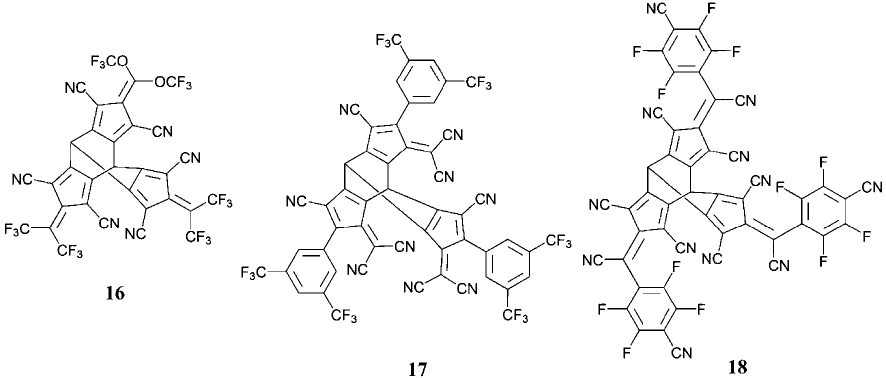

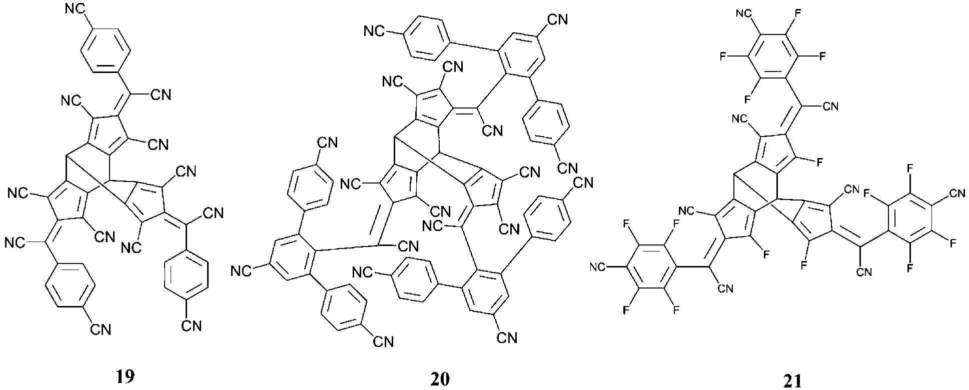

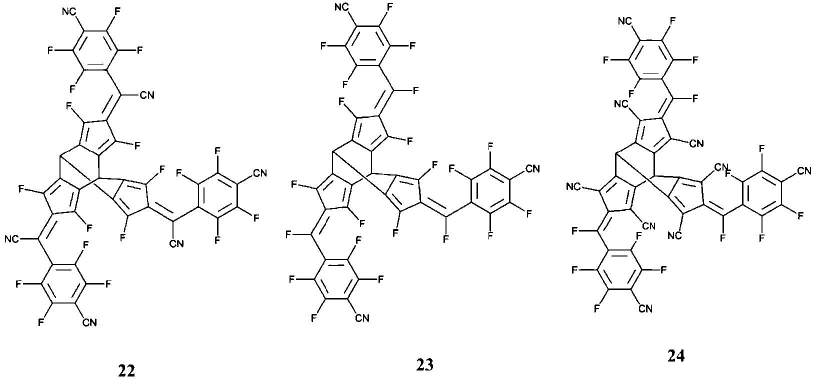

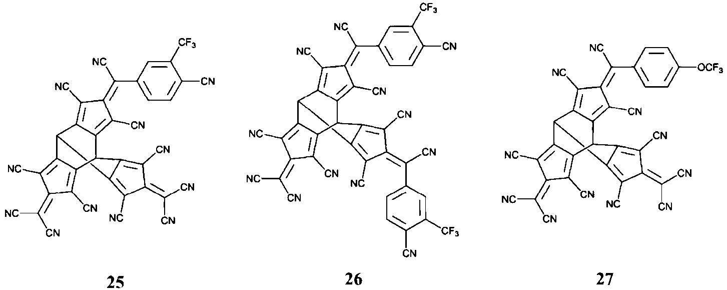

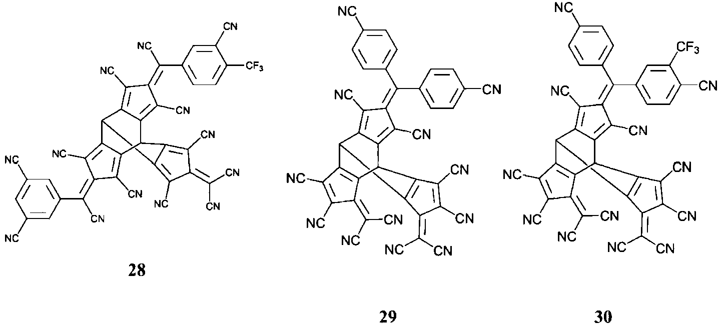

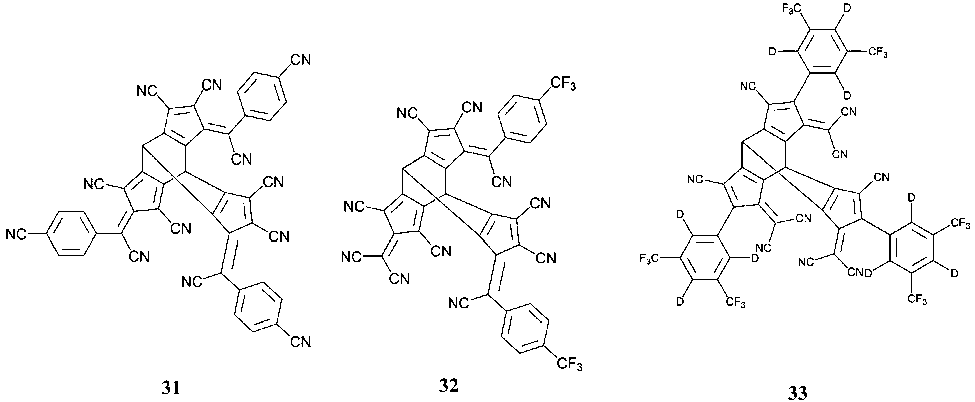

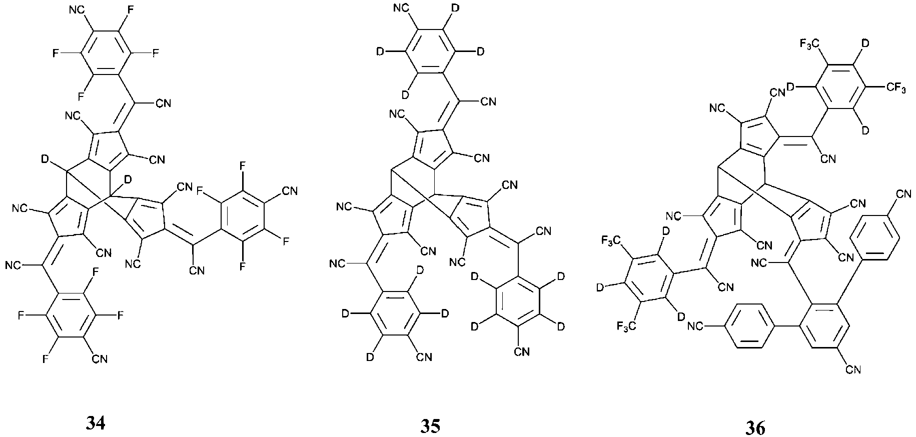

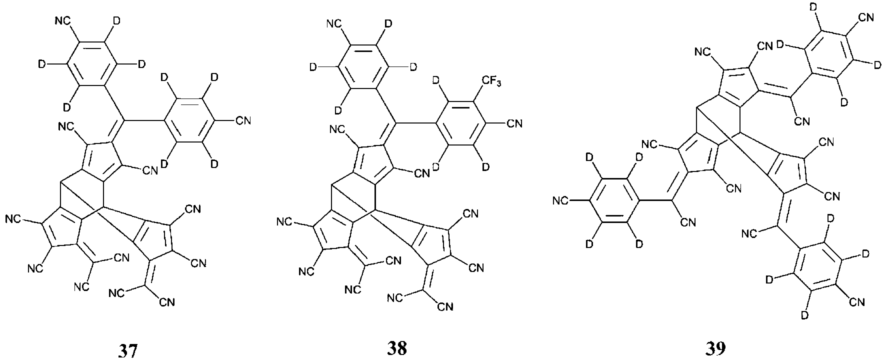

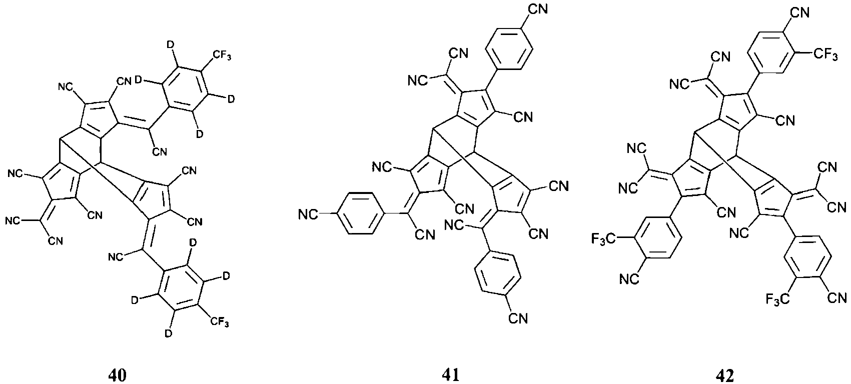

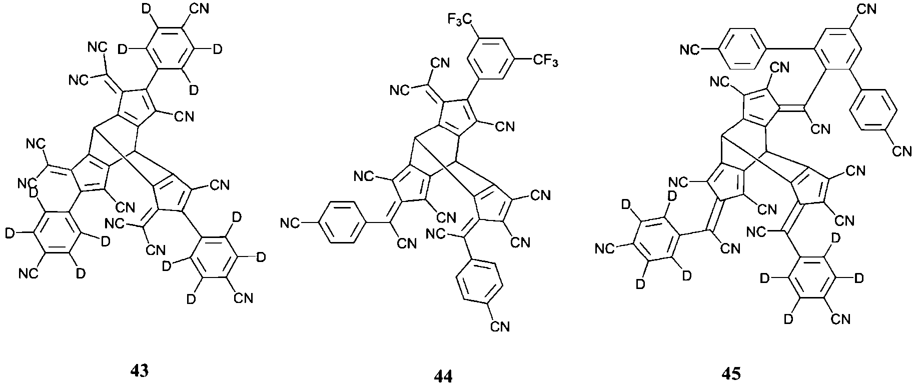

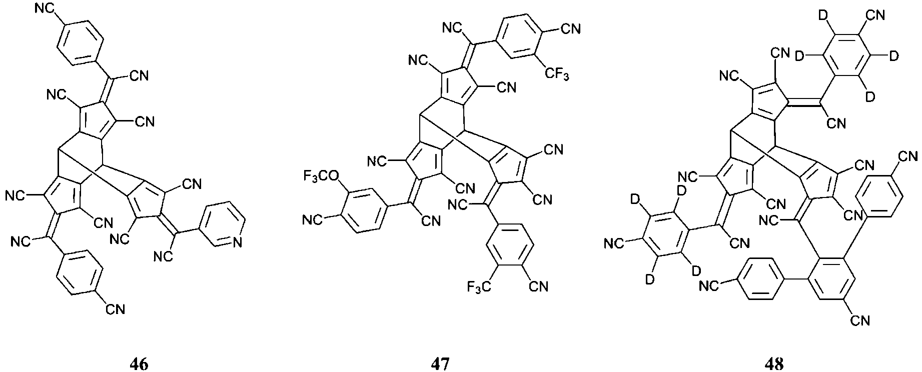

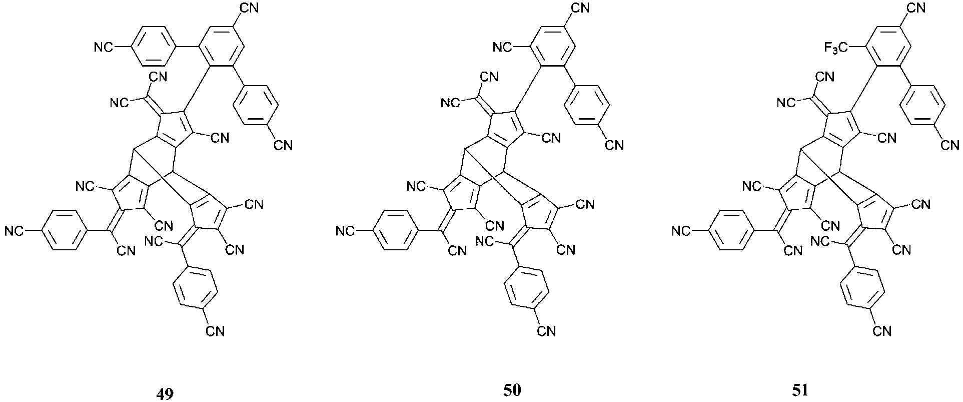

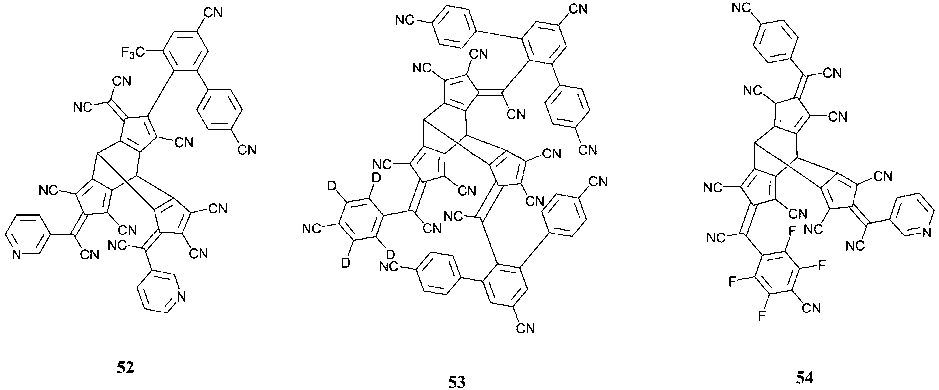

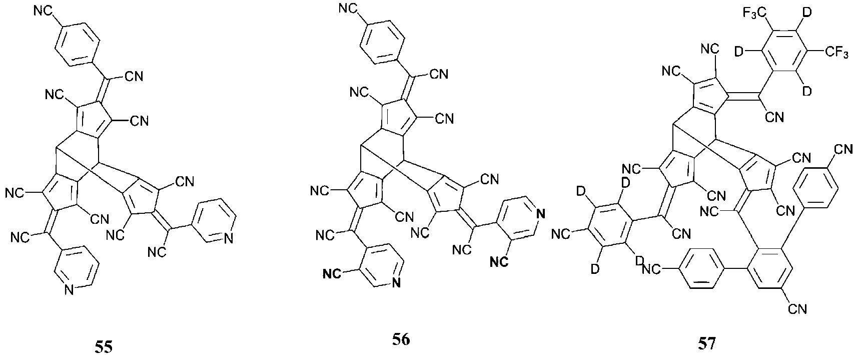

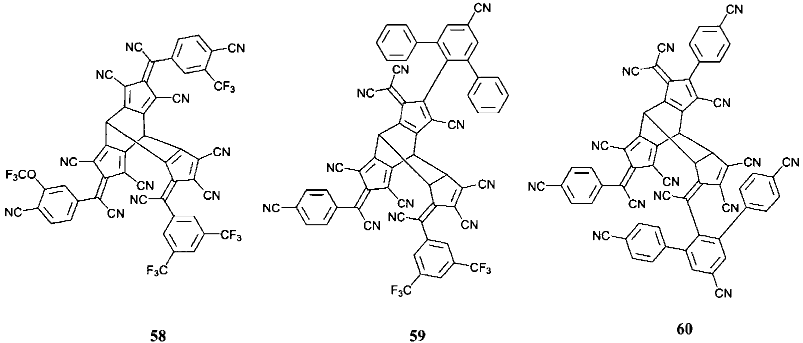

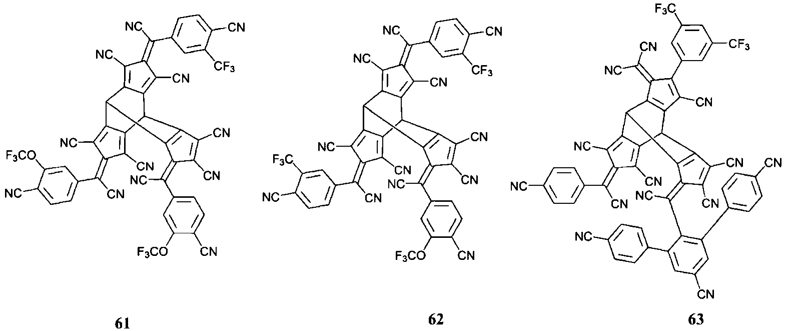

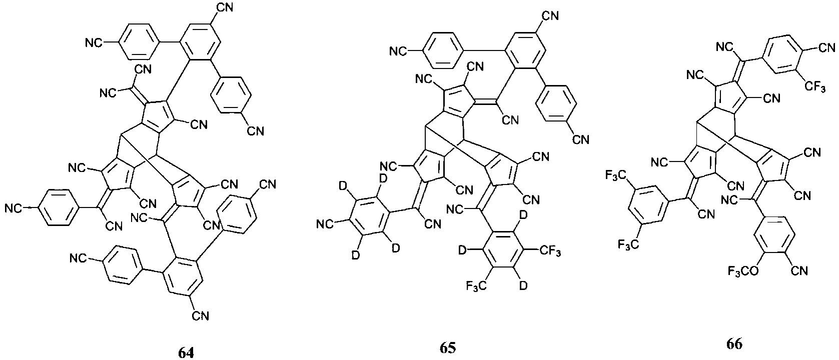

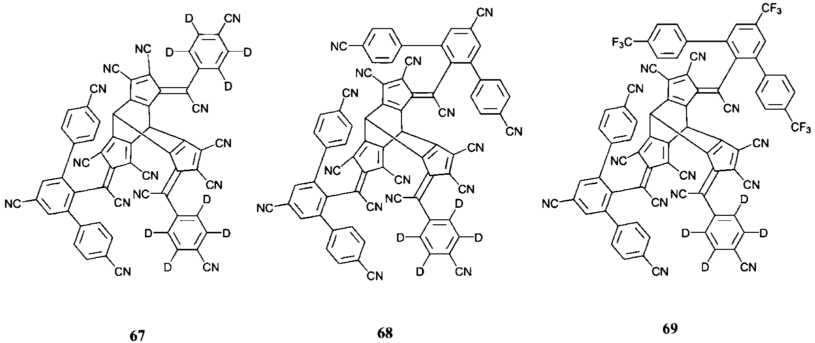

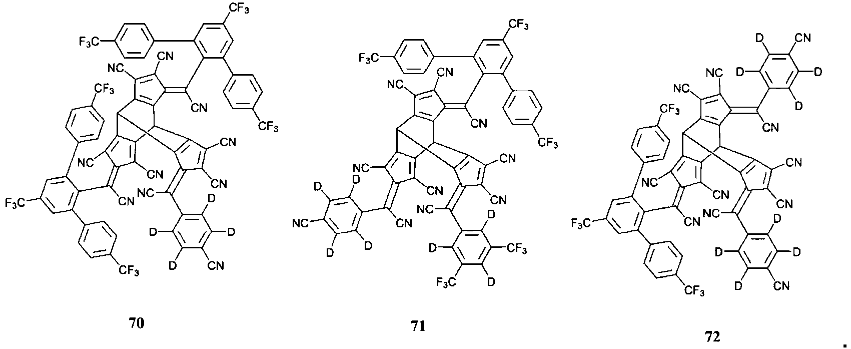

By having the structure of Formula 1 as a core and including at least one of the structures of Formulae 2-1 to 2-3, the condensed cyclic compound may have a three-dimensional skeleton and thus a high glass transition temperature, thereby having excellent or suitable material stability. In some embodiments, by satisfying the preceding structure, a specific LUMO energy level may be maintained, thereby suppressing or reducing the formation of a charge transfer complex.

Accordingly, a light-emitting device including the condensed cyclic compound may have improved efficiency in terms of injection and generation of holes in the device, thereby having improved luminescence efficiency and lifespan characteristics.

Synthesis methods of the condensed cyclic compound represented by Formula 1 may be recognizable by one of ordinary skill in the art by referring to Synthesis Examples and/or Examples to be described in more detail herein.

At least one condensed cyclic compound represented by Formula 1 may be used in a light-emitting device (e.g., an organic light-emitting device). Accordingly, provided is a light-emitting device including: a first electrode; a second electrode opposite to (e.g., facing) the first electrode; an interlayer arranged between the first electrode and the second electrode and including an emission layer; and the condensed cyclic compound represented by Formula 1.

In one or more embodiments,
the first electrode of the light-emitting device may be an anode,
the second electrode of the light-emitting device may be a cathode,
the interlayer may further include a hole transport region arranged between the first electrode and the emission layer and an electron transport region arranged between the emission layer and the second electrode,
the hole transport region may include a hole injection layer, a hole transport layer, an emission auxiliary layer, an electron-blocking layer, or any combination thereof, and
the electron transport region may include a hole-blocking layer, an electron transport layer, an electron injection layer, an electron control layer, or any combination thereof.

In one or more embodiments, the condensed cyclic compound represented by Formula 1 may be included in the interlayer.

In one or more embodiments, the condensed cyclic compound represented by Formula 1 may be included in the hole transport region.

In one or more embodiments, the condensed cyclic compound represented by Formula 1 may be included in the hole injection layer.

In one or more embodiments, the condensed cyclic compound represented by Formula 1 may be a p-dopant.

In one or more embodiments, the light-emitting device may be a tandem light-emitting device, and the interlayer and may include: m emitting units arranged between the first electrode and the second electrode and including at least one emission layer; and m-1 charge generation layers arranged between two adjacent emitting units among the m emitting units, and
m may be an integer of 2 or more.

In one or more embodiments, at least one of the m emitting units may further include an HT-emission auxiliary layer arranged on the side of the first electrode.

In one or more embodiments, at least one of the m emitting units may further include an ET-emission auxiliary layer arranged on the side of the second electrode.

In one or more embodiments, m may be 2 or 3.

In one or more embodiments, m may be 2,
the m emitting units may include a first emitting unit and a second emitting unit,
the m-1 charge generation layers may include a first charge generation layer,
the first charge generation layer may be arranged between the first emitting unit and the second emitting unit,
the first emitting unit may be arranged between the first electrode and the first charge generation layer, and
the second emitting unit may be arranged between the first charge generation layer and the second electrode.

In one or more embodiments, m may be 3,
the m emitting units may include a first emitting unit, a second emitting unit, and a third emitting unit,
the m-1 charge generation layers may include a first charge generation layer and a second charge generation layer,
the first charge generation layer may be arranged between the first emitting unit and the second emitting unit, and the second charge generation layer may be arranged between the second emitting unit and the third emitting unit,
the first emitting unit may be arranged between the first electrode and the first charge generation layer,
the second emitting unit may be arranged between the first charge generation layer and the second charge generation layer, and
the third emitting unit may be arranged between the second charge generation layer and the second electrode.

In one or more embodiments, the maximum emission wavelength of light emitted from at least one emitting unit among the m emitting units may be different from the maximum emission wavelength of light emitted from at least one emitting unit among the remaining emitting units.

In one or more embodiments, the emission layer may further include a host and a dopant.

In one or more embodiments, the emission layer may further include a sensitizer.

In one or more embodiments, the emission layer may be to emit blue light.

In one or more embodiments, the dopant may be a phosphorescent dopant or a delayed fluorescence dopant.

In one or more embodiments, the emission layer may further include a first host and a second host, wherein the first host may be a hole-transporting compound including at least one electron-donating group, and the second host may be an electron-transporting compound including at least one electron-withdrawing group.

In one or more embodiments, the emission layer may further include a third compound, wherein the third compound may be a metal-containing compound.

In one or more embodiments, the third compound may serve as a sensitizer, for example, a phosphorescent sensitizer.

In one or more embodiments, the third compound may not emit light.

In some embodiments, the emission layer may further include at least one of an auxiliary dopant and a sensitizer.

In one or more embodiments, the auxiliary dopant and the sensitizer may each independently be an organometallic compound including platinum and a tetradentate ligand bonded to platinum, wherein the tetradentate ligand may include a carbene moiety chemically bonded to platinum. For example, the auxiliary dopant and/or the sensitizer may include the third compound.

In one or more embodiments, the first host and the second host may serve as an exciplex host.

The term "electron-donating group" refers to any moiety having ability to donate electrons, and for example, may be a π electron-rich C₃-C₆₀ cyclic group or an amine group, but embodiments are not limited thereto. The electron-donating group may refer to a cyclic group other than a π electron-deficient nitrogen-containing C₁-C₆₀ cyclic group.

The term "electron-withdrawing group" refers to any moiety having ability to withdraw electrons, and for example, may be -F, -CFH₂, -CF₂H, -CF₃, -CN, -NO₂, a π electron-deficient nitrogen-containing C₁-C₆₀ cyclic group, or any combination thereof, but embodiments are not limited thereto.

Regarding a luminescence pathway in the light-emitting device according to one or more embodiments, the first host and the second host may form an exciton (first process), the energy of the exciton may be transferred to the third compound (second process), and the energy may be transferred from the third compound to the organometallic compound (third process).

In one or more embodiments, the amount of the third compound may be more than 0 parts by weight and less than 50 parts by weight based on the total weight of 100 parts by weight of the emission layer.

In one or more embodiments, the first host may include at least one carbazole moiety, and the second host may include at least one azine moiety.

In one or more embodiments, the first host may be represented by Formula 301-1A or 301-2A: 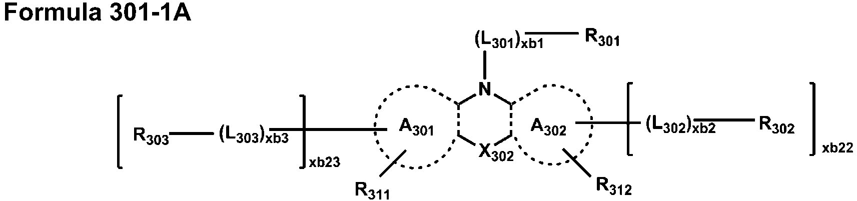 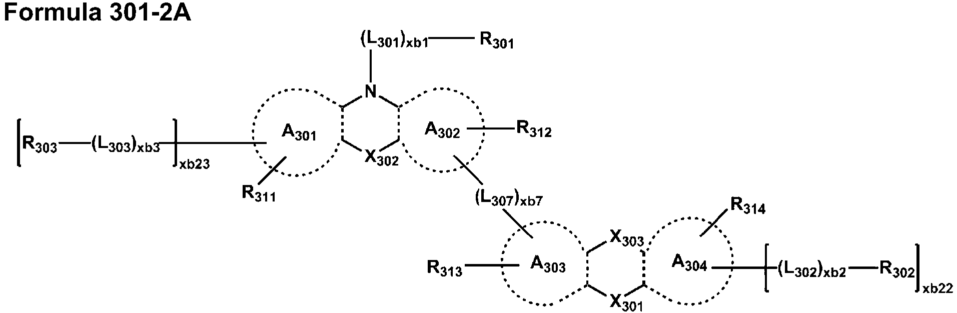
wherein, in Formulae 301-1A and 301-2A,
ring A₃₀₁ to ring A₃₀₄ may each independently be a C₃-C₆₀ carbocyclic group unsubstituted or substituted with at least one R₁₀ₐ or a C₁-C₆₀ heterocyclic group unsubstituted or substituted with at least one R₁₀ₐ,
X₃₀₁ may be O, S, N-[(L₃₀₄)_{xb4}-R_{304]}, C(R₃₀₄ₐ)(R₃₀₄ₐ), or Si(R₃₀₄ₐ)(R₃₀₅),
X₃₀₂ may be a single bond, O, S, N-[(L₃₀₅)_{xb5}-R₃₀₅ₐ], C(R₃₀₅ₐ)(R_{305b}), or Si(R₃₀₅ₐ)(R_{305b}),
X₃₀₃ may be a single bond, O, S, N-[(L₃₀₆)_{xb6}-R₃₀₆ₐ], C(R₃₀₆ₐ)(R_{306b}), or Si(R₃₀₆ₐ)(R_{306b}),
xb22 and xb23 may each independently be an integer from 0 to 10,
L₃₀₁ to L₃₀₇ may each independently be a C₃-C₆₀ carbocyclic group unsubstituted or substituted with at least one R₁₀ₐ or a C₁-C₆₀ heterocyclic group unsubstituted or substituted with at least one R₁₀ₐ,
xb1 to xb7 may each independently be an integer from 0 to 5,
R₃₀₁ to R₃₀₃, R₃₀₄ₐ to R₃₀₆ₐ, R_{304b} to R_{306b}, and R₃₁₁ to R₃₁₄ may each independently be hydrogen, deuterium, -F, -Cl, -Br, -I, a hydroxyl group, a cyano group, a nitro group, a C₁-C₆₀ alkyl group unsubstituted or substituted with at least one R₁₀ₐ, a C₂-C₆₀ alkenyl group unsubstituted or substituted with at least one R₁₀ₐ, a C₂-C₆₀ alkynyl group unsubstituted or substituted with at least one R₁₀ₐ, a C₁-C₆₀ alkoxy group unsubstituted or substituted with at least one R₁₀ₐ, a C₃-C₆₀ carbocyclic group unsubstituted or substituted with at least one R₁₀ₐ, a C₁-C₆₀ heterocyclic group unsubstituted or substituted with at least one R₁₀ₐ, -Si(Q₃₀₁)(Q₃₀₂)(Q₃₀₃), -N(Q₃₀₁)(Q₃₀₂), -B(Q₃₀₁)(Q₃₀₂), -C(=O)(Q₃₀₁), -S(=O)2(Q₃₀₁), or -P(=O)(Q₃₀₁)(Q₃₀₂), and
Q₃₀₁ to Q₃₀₃ may each be as described in connection with Q₁.

In one or more embodiments, the first host may be one of (e.g., any one selected from among) Compounds HTH1 to HTH56 or Compounds HTH1' to HTH40', but embodiments are not limited thereto:

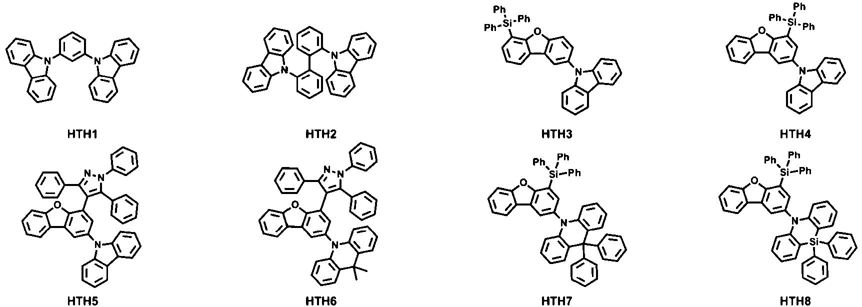

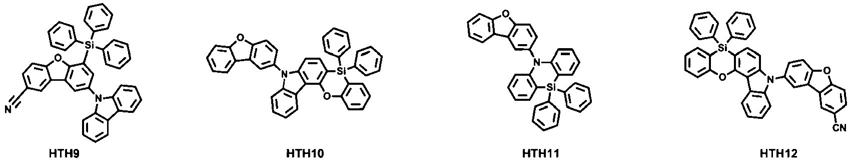

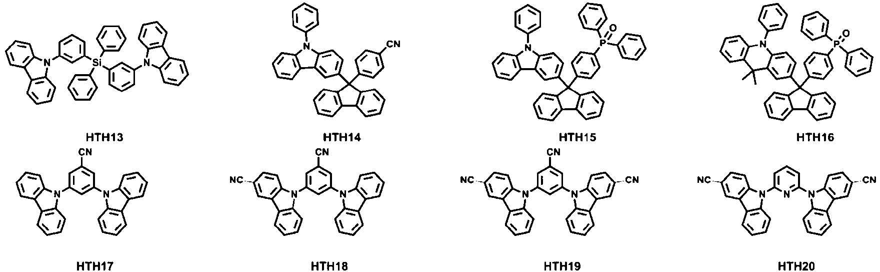

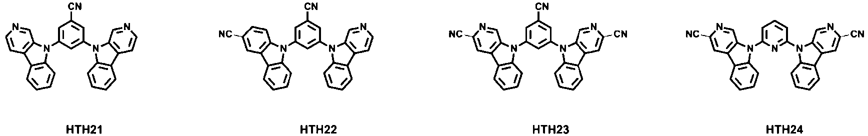

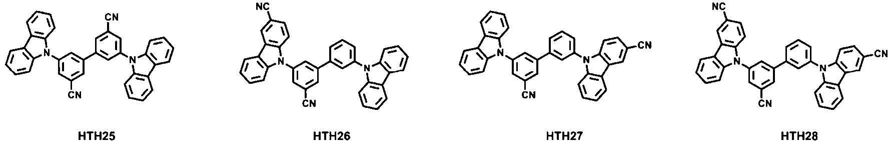

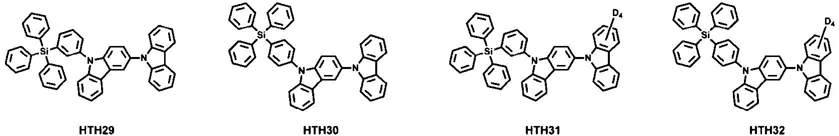

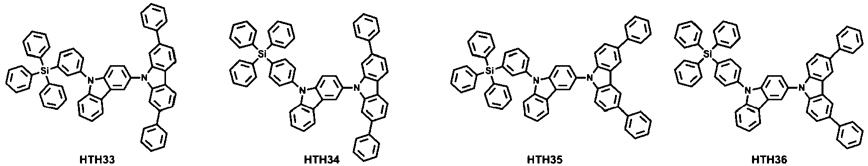

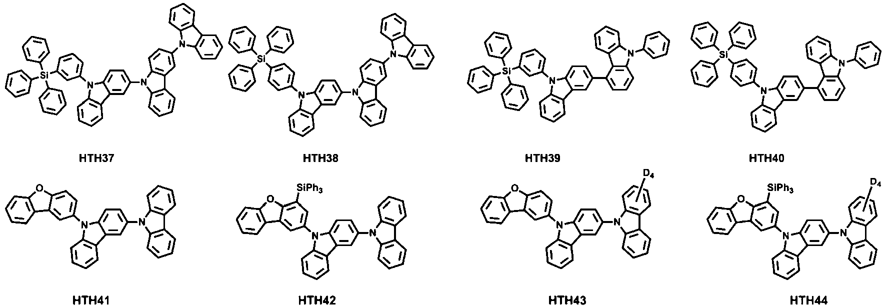

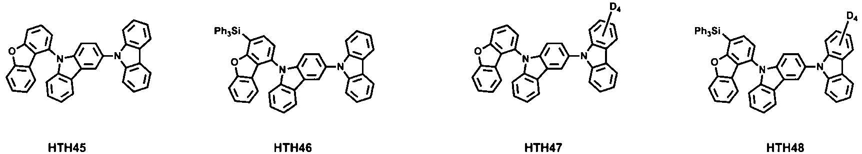

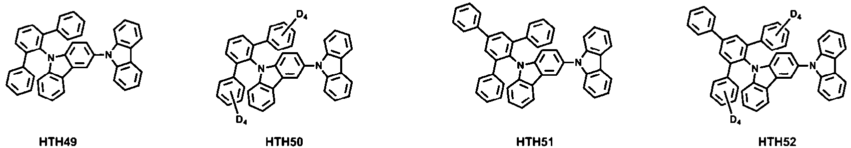

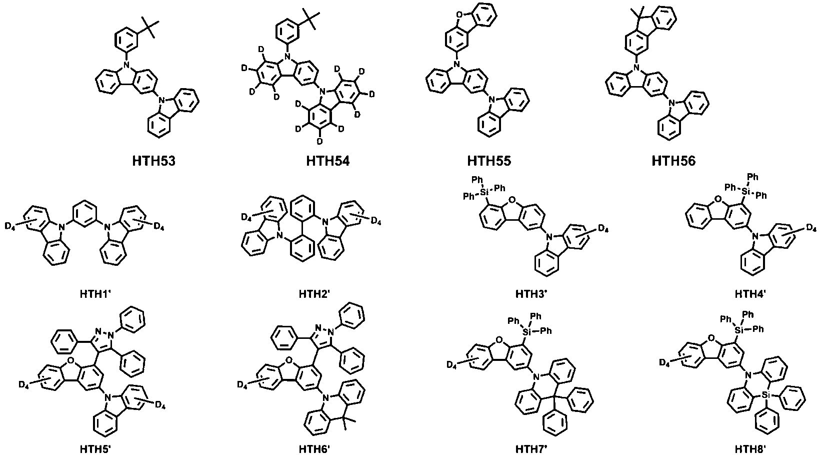

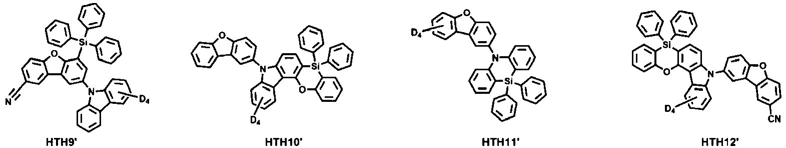

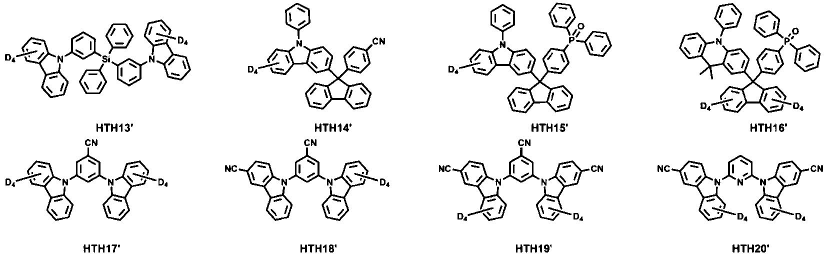

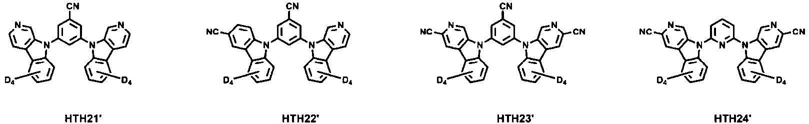

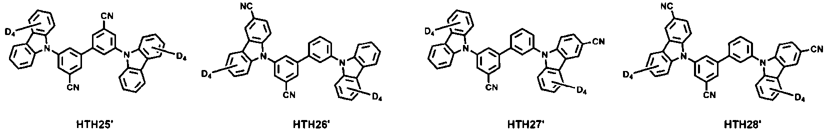

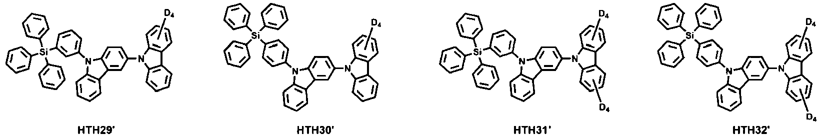

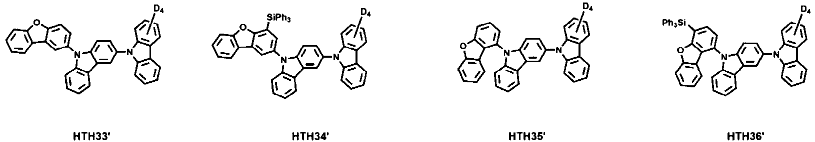

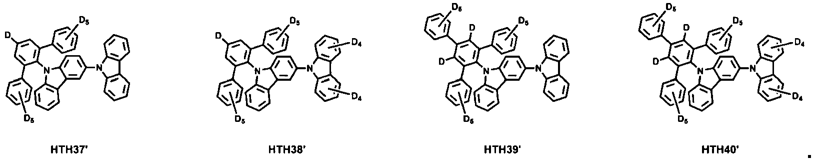

In one or more embodiments, the second host may be represented by Formula 302: 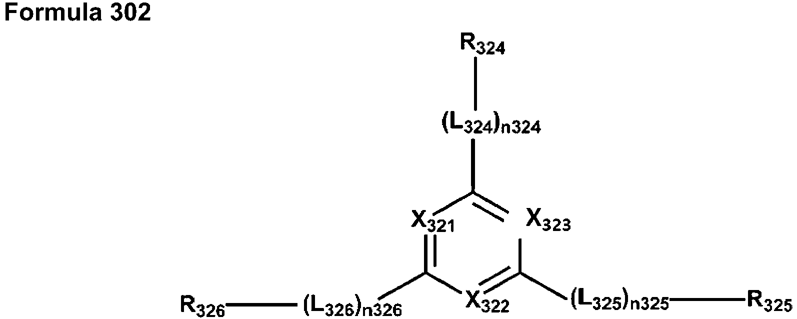
wherein, in Formula 302,
X₃₂₁ may be C(R₃₂₁) or N,
X₃₂₂ may be C(R₃₂₂) or N,
X₃₂₃ may be C(R₃₂₃) or N,
at least one of X₃₂₁ to X₃₂₃ may be N,
L₃₂₄ to L₃₂₆ may each independently be a single bond, a C₃-C₆₀ carbocyclic group unsubstituted or substituted with at least one R₁₀ₐ, a C₁-C₆₀ heterocyclic group unsubstituted or substituted with at least one R₁₀ₐ, *-C(Q₃₂₁)(Q₃₂₂)-*', *-Si(Q₃₂₁)(Q₃₂₂)-*', *-B(Q₃₂₁)-*', or *-N(Q₃₂₁)-*',
n324 to n326 may each independently be an integer from 1 to 5,
R₃₂₁ to R₃₂₆ may each independently be hydrogen, deuterium, -F, -Cl, -Br, -I, a hydroxyl group, a cyano group, a nitro group, a C₁-C₆₀ alkyl group unsubstituted or substituted with at least one R₁₀ₐ, a C₂-C₆₀ alkenyl group unsubstituted or substituted with at least one R₁₀ₐ, a C₂-C₆₀ alkynyl group unsubstituted or substituted with at least one R₁₀ₐ, a C₁-C₆₀ alkoxy group unsubstituted or substituted with at least one R₁₀ₐ, a C₃-C₆₀ carbocyclic group unsubstituted or substituted with at least one R₁₀ₐ, a C₁-C₆₀ heterocyclic group unsubstituted or substituted with at least one R₁₀ₐ, - Si(Q₃₂₃)(Q₃₂₄)(Q₃₂₅), -N(Q₃₂₃)(Q₃₂₄), -B(Q₃₂₃)(Q₃₂₄), -C(=O)(Q₃₂₃), -S(=O)₂(Q₃₂₃), or - P(=O)(Q₃₂₃)(Q₃₂₄),
two or more neighboring groups among Q₃₂₁ to Q₃₂₅ and R₃₂₁ to R₃₂₆ may optionally be bonded to each other to form a C₅-C₃₀ carbocyclic group unsubstituted or substituted with at least one R₁₀ₐ or a C₂-C₃₀ heterocyclic group unsubstituted or substituted with at least one R₁₀ₐ,
* and *' each indicate a binding site to a neighboring atom,
R₁₀ₐ may be as described herein, and
Q₃₂₁ to Q₃₂₅ may each be as described in connection with Q₁.

In one or more embodiments, the second host may be one of (e.g., any one selected from among) Compounds ETH1 to ETH86 or Compounds ETH1' to ETH32', but embodiments are not limited thereto:

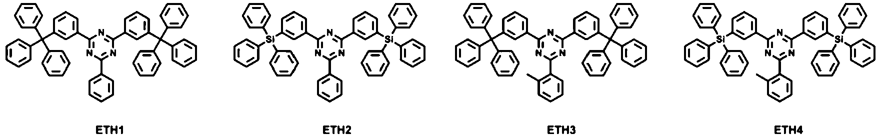

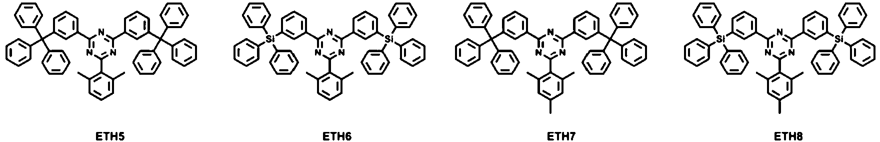

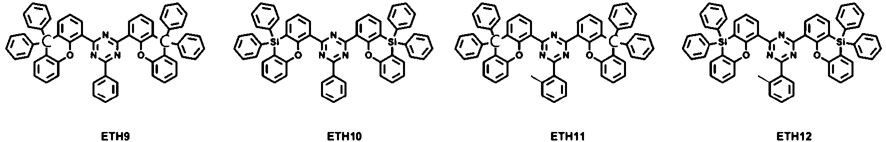

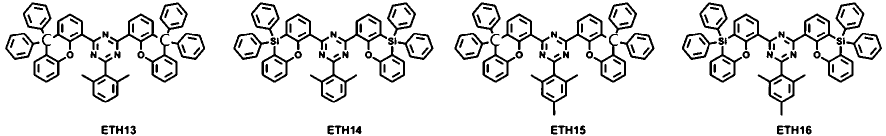

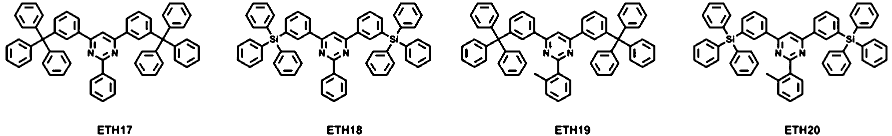

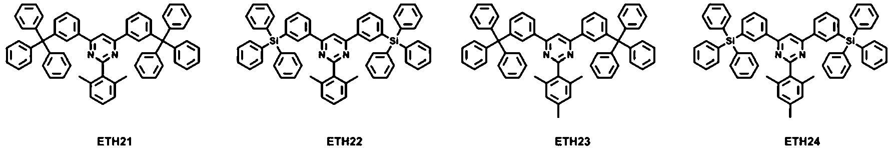

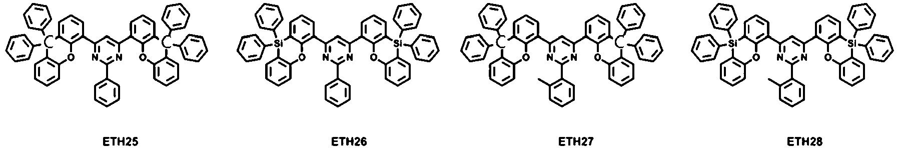

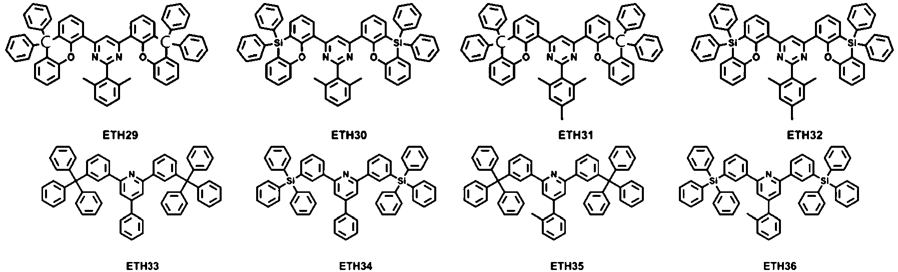

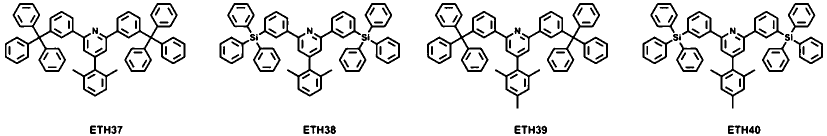

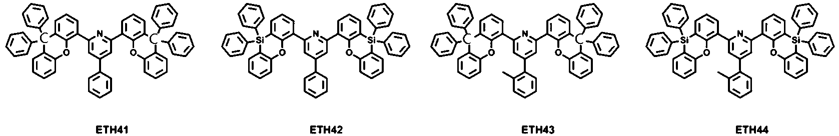

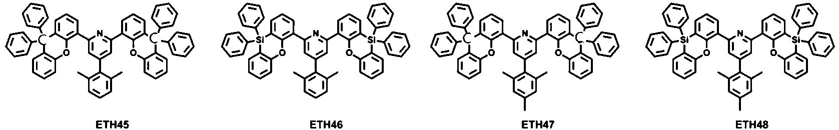

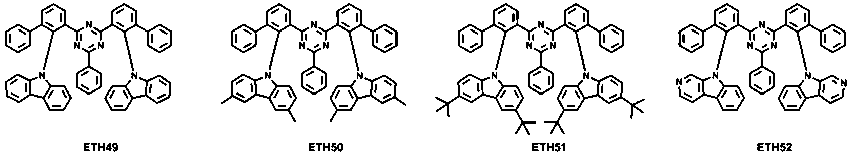

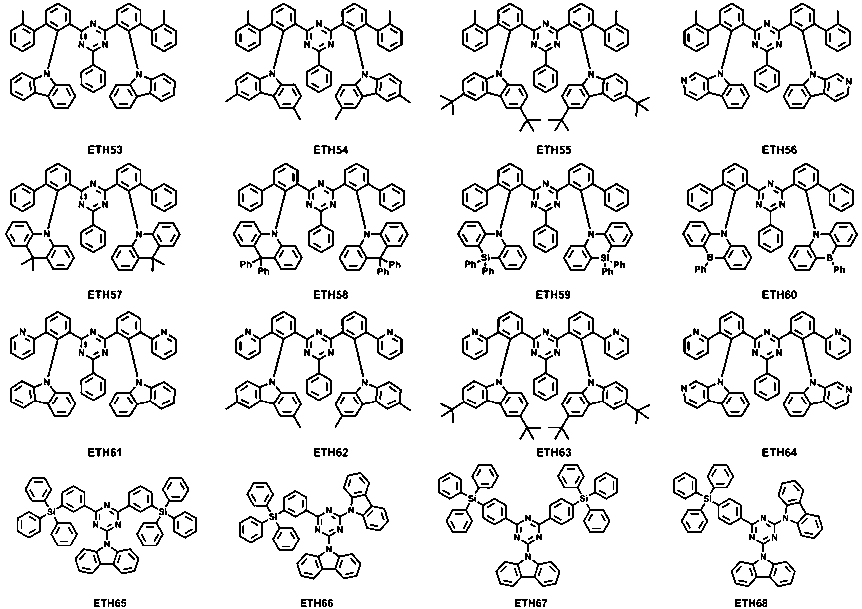

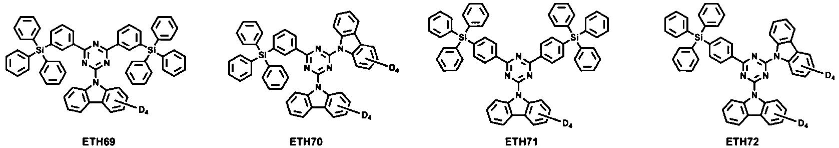

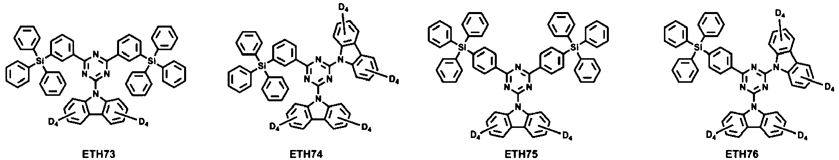

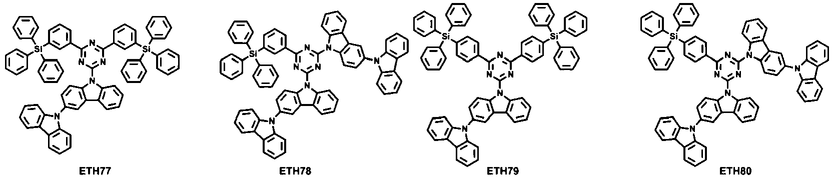

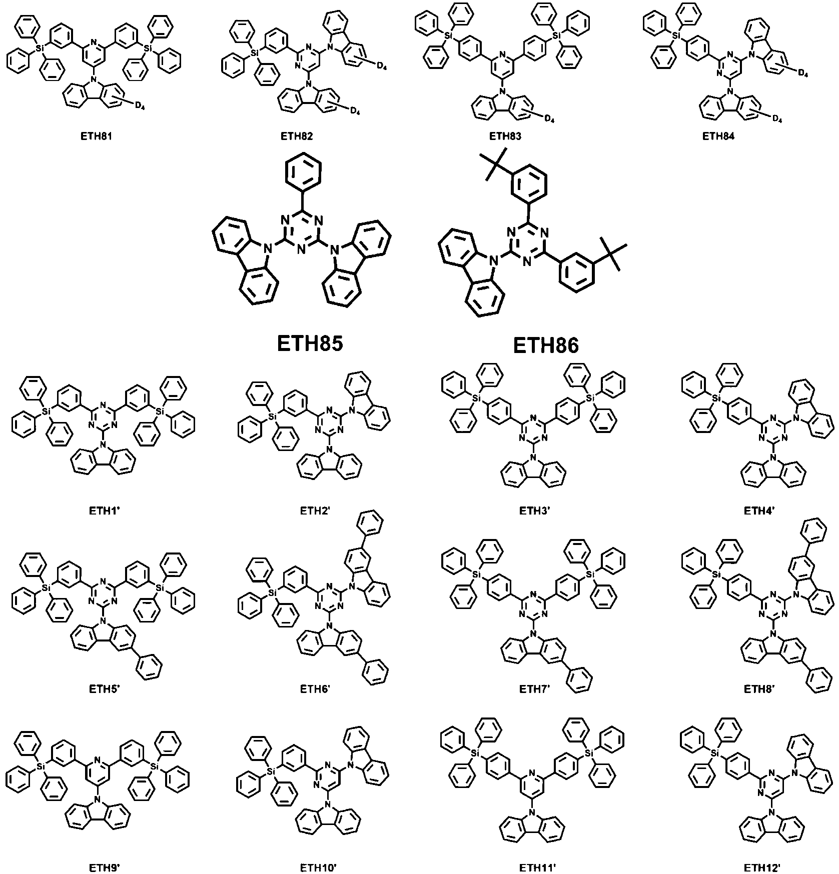

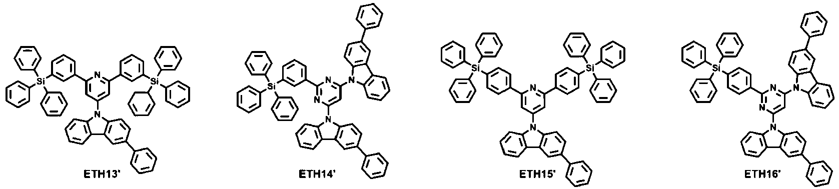

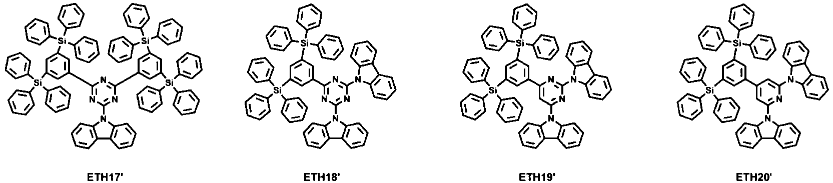

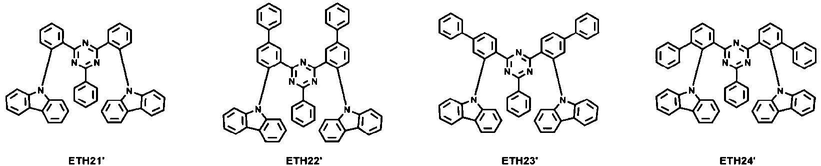

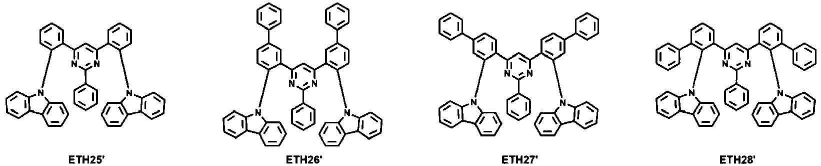

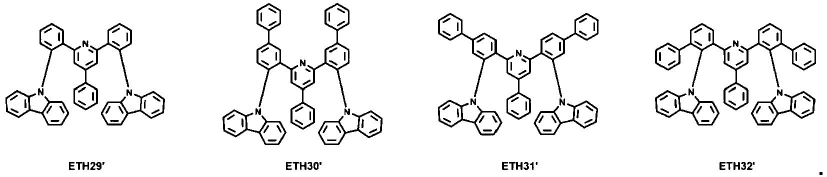

In one or more embodiments, the third compound may be represented by Formula 401A:

**Formula 401A** M₄₀₁(L₄₀₁)n₄₀₁(L₄₀₂)n₄₀₂

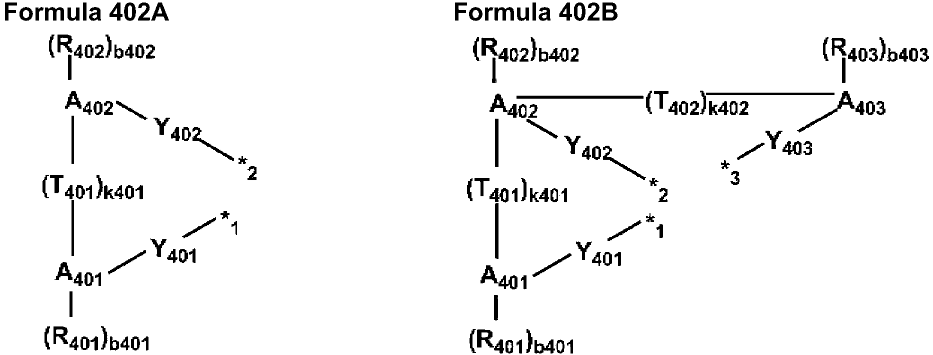

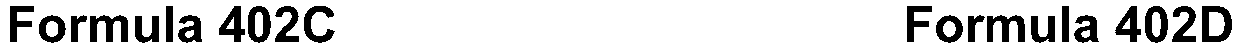

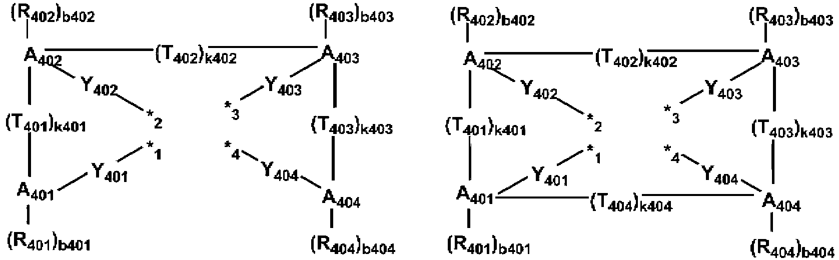

wherein, in Formulae 401A and 402A to 402D,
M₄₀₁ may be a first-row transition metal of the Periodic Table of Elements, a second-row transition metal of the Periodic Table of Elements, or a third-row transition metal of the Periodic Table of Elements,
L₄₀₁ may be a ligand represented by one of Formulae 402A to 402D,
L₄₀₂ may be a monodentate ligand, a bidentate ligand, or a tridentate ligand,
n401 may be 1 or 2,
n402 may be an integer from 0 to 4,
A₄₀₁ to A₄₀₄ may each independently be a C₅-C₃₀ carbocyclic group or a C₁-C₃₀ heterocyclic group,
T₄₀₁ to T₄₀₄ may each independently be a single bond, a double bond, *-O-*', *-S-*', *-C(=O)-*', *-S(=O)-*', *-C(R₄₀₅)(R₄₀₆)-*', *-C(R₄₀₅)=C(R₄₀₆)-*', *-C(R₄₀₅)=*', *-Si(R₄₀₅)(R₄₀₆)-*', *-B(R₄₀₅)-*', *-N(R₄₀₅)-*', or *-P(R₄₀₅)-*',
k401 to k404 may each independently be 1, 2, or 3,
Y₄₀₁ to Y₄₀₄ may each independently be a single bond (e.g., a covalent bond or a coordinate bond), *-O-*', *-S-*', *-C(R₄₀₇)(R₄₀₈)-*', *-Si(R₄₀₇)(R₄₀ₐ)-*', *-B(R₄₀₇)-*', *-N(R₄₀₇)-*', or *-P(R₄₀₇)-*',
*₁, *₂, *₃, and *₄ each indicate a binding site to M₄₀₁,
R₄₀₁ to R₄₀₈ may each independently be hydrogen, deuterium, -F, -Cl, -Br, -I, a hydroxyl group, a cyano group, a nitro group, a C₁-C₆₀ alkyl group unsubstituted or substituted with at least one R₁₀ₐ, a C₂-C₆₀ alkenyl group unsubstituted or substituted with at least one R₁₀ₐ, a C₂-C₆₀ alkynyl group unsubstituted or substituted with at least one R₁₀ₐ, a C₁-C₆₀ alkoxy group unsubstituted or substituted with at least one R₁₀ₐ, a C₃-C₆₀ carbocyclic group unsubstituted or substituted with at least one R₁₀ₐ, a C₁-C₆₀ heterocyclic group unsubstituted or substituted with at least one R₁₀ₐ, a C₆-C₆₀ aryloxy group unsubstituted or substituted with at least one R₁₀ₐ, a C₆-C₆₀ arylthio group unsubstituted or substituted with at least one R₁₀ₐ, -Si(Q₁)(Q₂)(Q₃), -N(Q₁)(Q₂), - B(Q₁)(Q₂), -C(=O)(Q₁), -S(=O)₂(Q₁), or -P(=O)(Q₁)(Q₂),
R₄₀₁ to R₄₀₈ may optionally be bonded to each other to form a C₅-C₆₀ carbocyclic group unsubstituted or substituted with at least one R₁₀ₐ or a C₁-C₆₀ heterocyclic group unsubstituted or substituted with at least one R₁₀ₐ,
b401 to b404 may each independently be an integer from 0 to 10,
* and *' each indicate a binding site to a neighboring atom, and
Q₁ to Q₃ and R₁₀ₐ may each be as described herein.

In one or more embodiments, the compound represented by Formula 401A may be a carbene complex.

The term "carbene complex" as used herein refers to a complex which includes a metal and a ligand bonded to the metal, wherein at least one bond between the metal and the ligand is a bond between the metal and carbon of carbene.

In one or more embodiments, the sensitizer may include the compound represented by Formula 401A.

In one or more embodiments, the third compound may be one of (e.g., any one selected from among) Compounds PD1 to PD41, but embodiments are not limited thereto:

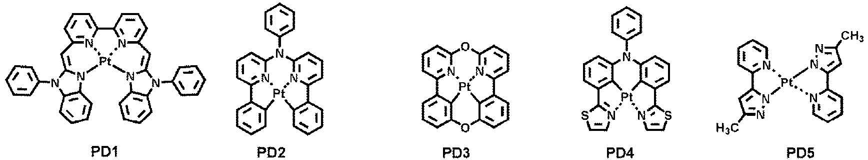

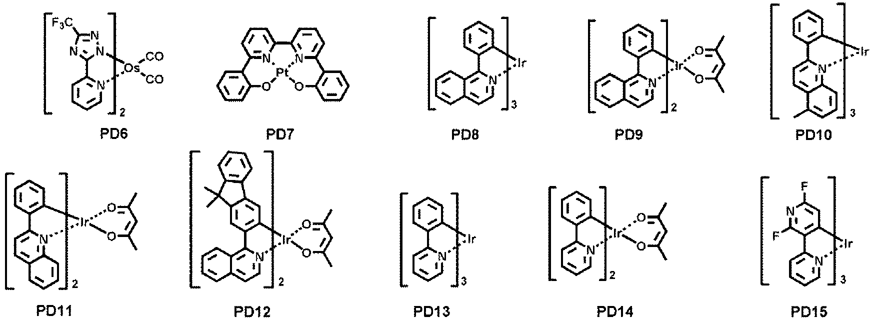

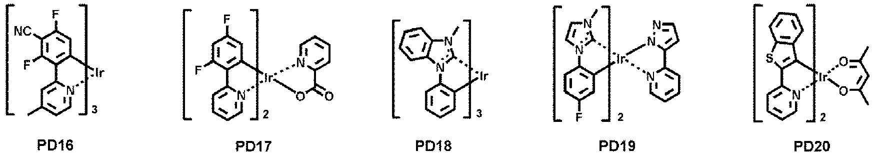

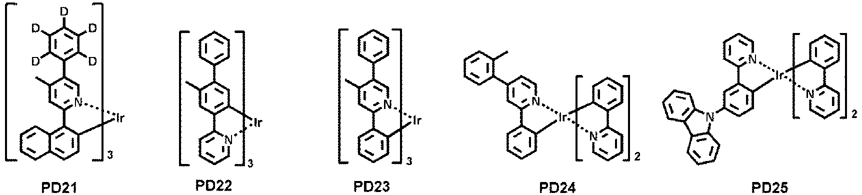

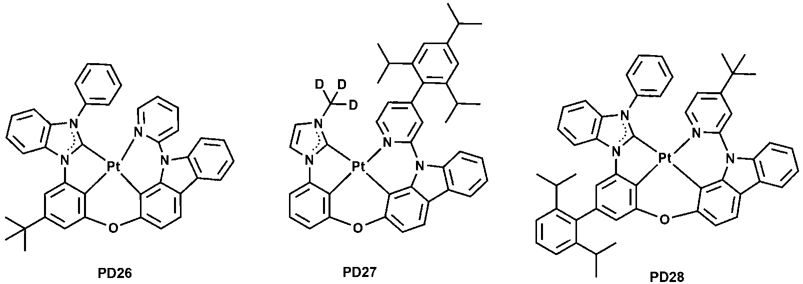

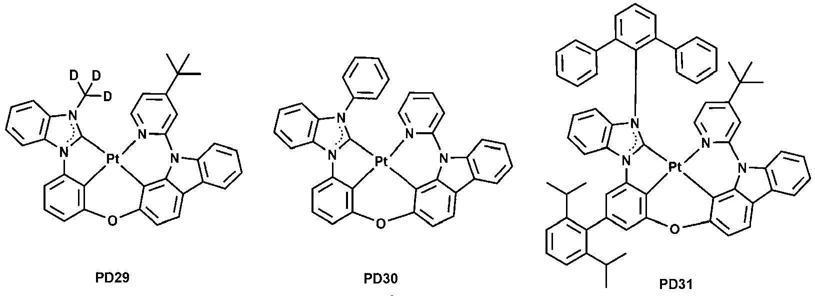

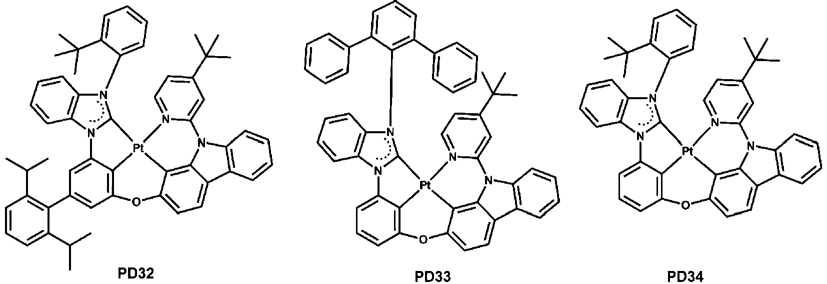

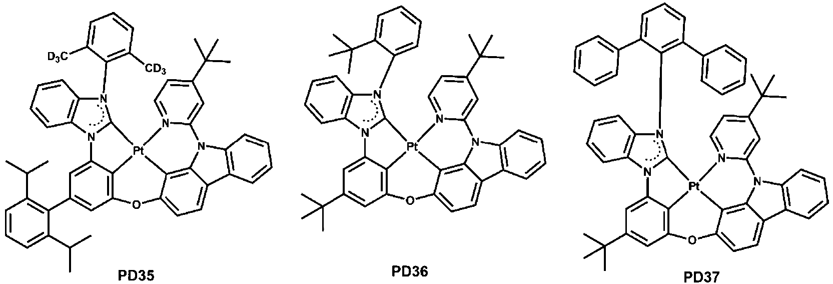

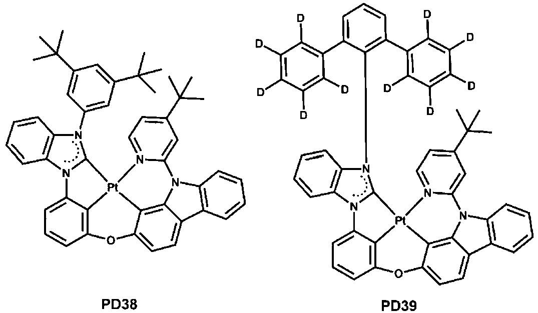

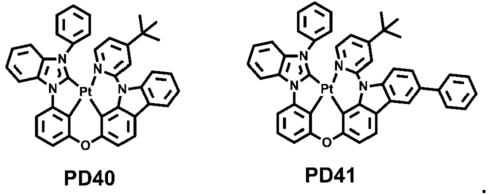

In one or more embodiments, R₃₀₁ to R₃₀₃, R₃₀₄ₐ to R₃₀₆ₐ, R_{304b} to R_{306b}, and R₃₁₁ to R₃₁₄ in Formulae 301-1A and 301-2A, R₃₂₁ to R₃₂₆ in Formula 302, and R₄₀₁ to R₄₀₈ in Formulae 401A and 402A to 402D may each independently be: hydrogen, deuterium, -F, -Cl, -Br, -I, a hydroxyl group, a cyano group, a nitro group, an amidino group, a hydrazine group, a hydrazone group, a C₁-C₂₀ alkyl group, or a C₁-C₂₀ alkoxy group;
a C₁-C₂₀ alkyl group or a C₁-C₂₀ alkoxy group, each substituted with deuterium, -F, -Cl, -Br, -I, -CD₃, -CD₂H, -CDH₂, -CF₃, -CF₂H, -CFH₂, a hydroxyl group, a cyano group, a nitro group, an amidino group, a hydrazine group, a hydrazone group, a C₁-C₁₀ alkyl group, a cyclopentyl group, a cyclohexyl group, a cycloheptyl group, a cyclooctyl group, an adamantanyl group, a norbornanyl group, a norbornenyl group, a cyclopentenyl group, a cyclohexenyl group, a cycloheptenyl group, a phenyl group, a biphenyl group, a naphthyl group, a pyridinyl group, a pyrimidinyl group, or any combination thereof;
a cyclopentyl group, a cyclohexyl group, a cycloheptyl group, a cyclooctyl group, an adamantanyl group, a norbornanyl group, a norbornenyl group, a cyclopentenyl group, a cyclohexenyl group, a cycloheptenyl group, a phenyl group, a biphenyl group, a (C₁-C₁₀ alkyl)phenyl group, a naphthyl group, a tetrahydronaphthyl group, a fluorenyl group, a phenanthrenyl group, an anthracenyl group, a fluoranthenyl group, a triphenylenyl group, a pyrenyl group, a chrysenyl group, a pyrrolyl group, a thiophenyl group, a furanyl group, an imidazolyl group, a pyrazolyl group, a thiazolyl group, an isothiazolyl group, an oxazolyl group, an isoxazolyl group, a pyridinyl group, a pyrazinyl group, a pyrimidinyl group, a pyridazinyl group, an isoindolyl group, an indolyl group, an indazolyl group, a purinyl group, a quinolinyl group, an isoquinolinyl group, a benzoquinolinyl group, a benzoisoquinolinyl group, a phthalazinyl group, a naphthyridinyl group, a quinoxalinyl group, a benzoquinoxalinyl group, a quinazolinyl group, a cinnolinyl group, a carbazolyl group, a phenanthridinyl group, an acridinyl group, a phenanthrolinyl group, a phenazinyl group, a benzimidazolyl group, a benzofuranyl group, a benzothiophenyl group, a benzoisothiazolyl group, a benzoxazolyl group, an benzoisoxazolyl group, a triazolyl group, a tetrazolyl group, an oxadiazolyl group, a triazinyl group, a thiadiazolyl group, a dibenzofuranyl group, a dibenzothiophenyl group, a benzocarbazolyl group, a dibenzocarbazolyl group, an imidazopyridinyl group, an imidazopyrimidinyl group, an azacarbazolyl group, an azadibenzofuranyl group, an azadibenzothiophenyl group, an azafluorenyl group, or an azadibenzosilolyl group, each unsubstituted or substituted with deuterium, -F, -Cl, -Br, - I, -CD₃, -CD₂H, -CDH₂, -CF₃, -CF₂H, -CFH₂, a hydroxyl group, a cyano group, a nitro group, an amidino group, a hydrazine group, a hydrazone group, a C₁-C₂₀ alkyl group, a C₁-C₂₀ alkoxy group, a cyclopentyl group, a cyclohexyl group, a cycloheptyl group, a cyclooctyl group, an adamantanyl group, a norbornanyl group, a norbornenyl group, a cyclopentenyl group, a cyclohexenyl group, a cycloheptenyl group, a phenyl group, a biphenyl group, a (C₁-C₁₀ alkyl)phenyl group, a naphthyl group, a tetrahydronaphthyl group, a fluorenyl group, a phenanthrenyl group, an anthracenyl group, a fluoranthenyl group, a triphenylenyl group, a pyrenyl group, a chrysenyl group, a pyrrolyl group, a thiophenyl group, a furanyl group, an imidazolyl group, a pyrazolyl group, a thiazolyl group, an isothiazolyl group, an oxazolyl group, an isoxazolyl group, a pyridinyl group, a pyrazinyl group, a pyrimidinyl group, a pyridazinyl group, an isoindolyl group, an indolyl group, an indazolyl group, a purinyl group, a quinolinyl group, an isoquinolinyl group, a benzoquinolinyl group, a benzoisoquinolinyl group, a phthalazinyl group, a naphthyridinyl group, a quinoxalinyl group, a benzoquinoxalinyl group, a quinazolinyl group, a cinnolinyl group, a carbazolyl group, a phenanthridinyl group, an acridinyl group, a phenanthrolinyl group, a phenazinyl group, a benzimidazolyl group, a benzofuranyl group, a benzothiophenyl group, a benzoisothiazolyl group, a benzoxazolyl group, an benzoisoxazolyl group, a triazolyl group, a tetrazolyl group, an oxadiazolyl group, a triazinyl group, a thiadiazolyl group, a dibenzofuranyl group, a dibenzothiophenyl group, a benzocarbazolyl group, a dibenzocarbazolyl group, an imidazopyridinyl group, an imidazopyrimidinyl group, an azacarbazolyl group, an azadibenzofuranyl group, an azadibenzothiophenyl group, an azafluorenyl group, an azadibenzosilolyl group, -Si(Q₃₁)(Q₃₂)(Q₃₃), -B(Q₃₁)(Q₃₂), -P(Q₃₁)(Q₃₂), -C(=O)(Q₃₁), - S(=O)₂(Q₃₁), -P(=O)(Q₃₁)(Q₃₂), or any combination thereof; or
-C(Q₁)(Q₂)(Q₃), -Si(Q₁)(Q₂)(Q₃), -N(Q₁)(Q₂), -B(Q₁)(Q₂), -C(=O)(Q₁), - S(=O)₂(Q₁), or -P(=O)(Q₁)(Q₂), and
Q₁ to Q₃ and Q₃₁ to Q₃₃ may each be as described herein.

In one or more embodiments, R₃₀₁ to R₃₀₃, R₃₀₄a to R₃₀₆ₐ, R_{304b} to R_{306b}, and R₃₁₁ to R₃₁₄ in Formulae 301-1A and 301-2A, R₃₂₁ to R₃₂₆ in Formula 302, and R₄₀₁ to R₄₀₈ in Formulae 401A and 402A to 402D may each independently be:
hydrogen, deuterium, -F, -Cl, -Br, -I, -CD₃, -CD₂H, -CDH₂, -CF₃, -CF₂H, - CFH₂, a cyano group, a nitro group, a C₁-C₆₀ alkyl group, a C₂-C₆₀ alkenyl group, a C₂-C₆₀ alkynyl group, or a C₁-C₆₀ alkoxy group;
a group represented by one of Formulae 9-1 to 9-61 or a group represented by one of Formulae 10-1 to 10-348; or
-C(Q₁)(Q₂)(Q₃), -Si(Q₁)(Q₂)(Q₃), -N(Q₁)(Q₂), -B(Q₁)(Q₂), -C(=O)(Q₁), - S(=O)₂(Q₁), or -P(=O)(Q₁)(Q₂): 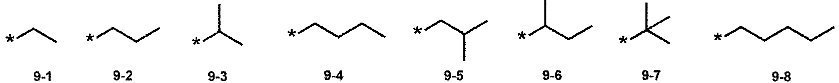 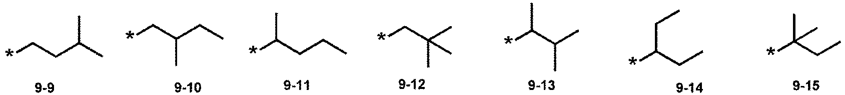 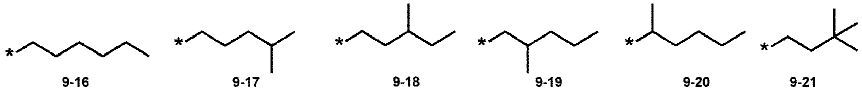 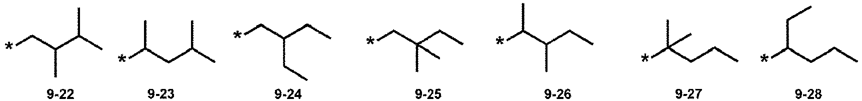 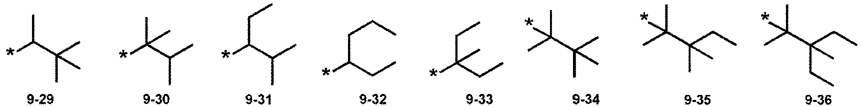 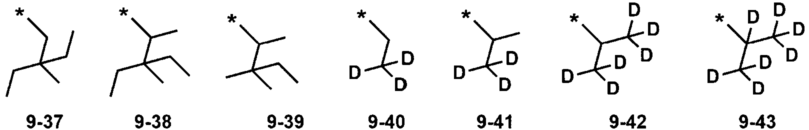 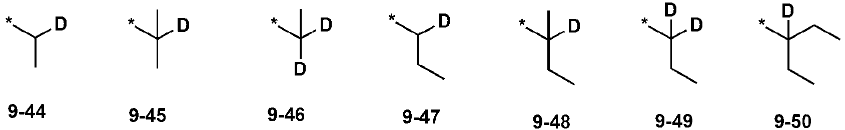 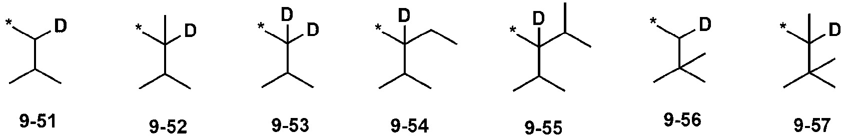 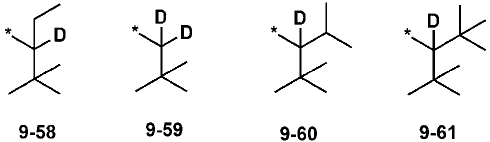 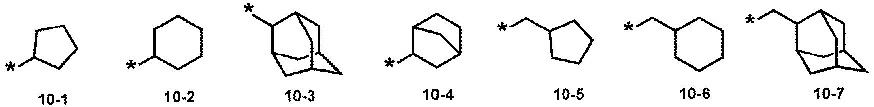 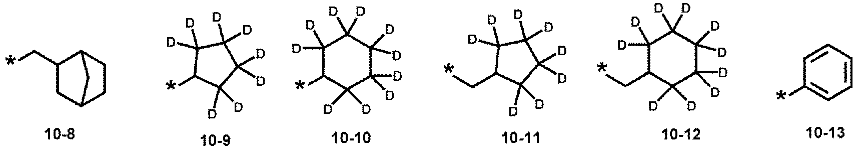 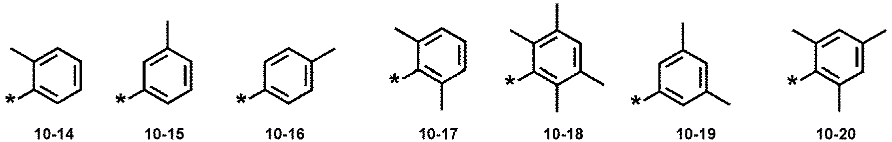 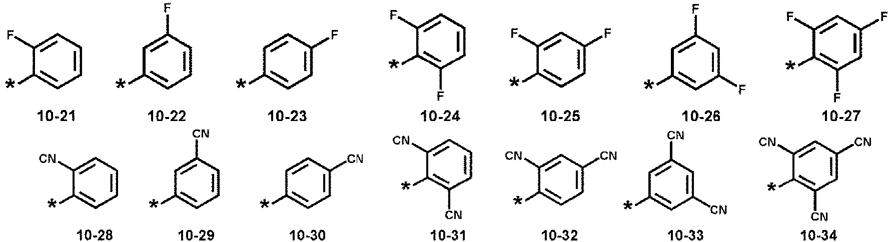 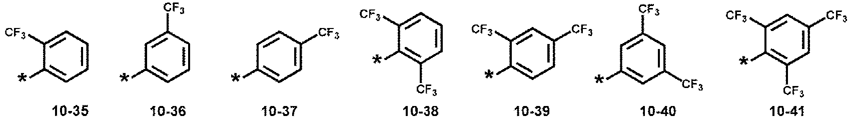 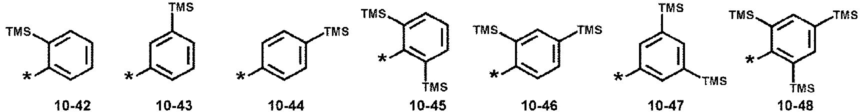 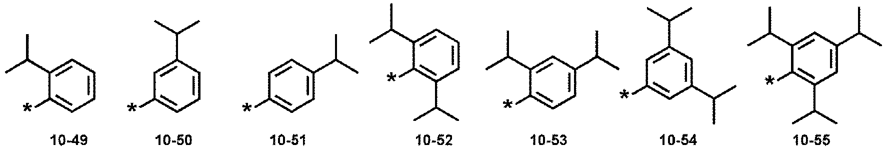 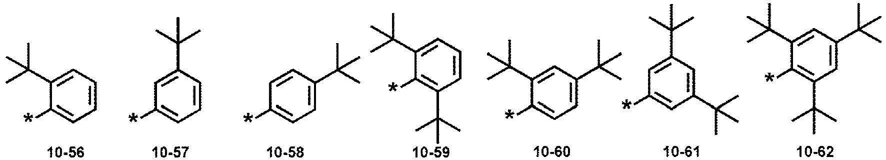 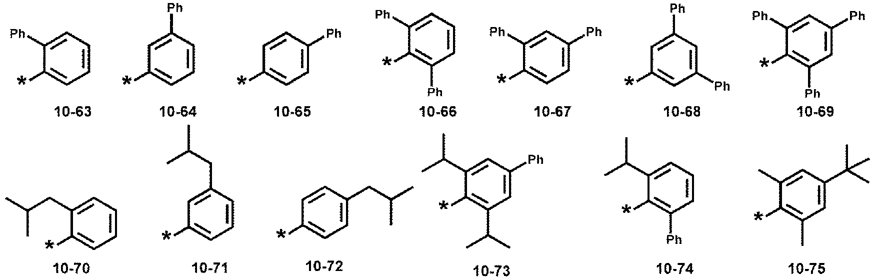 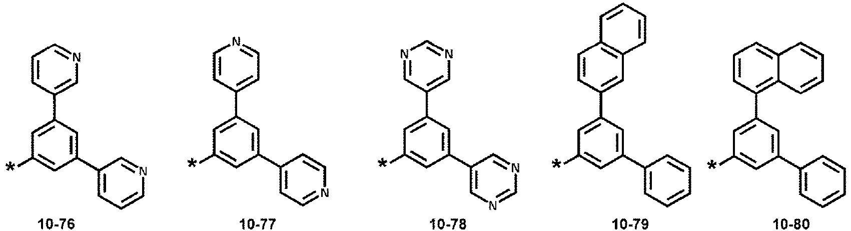 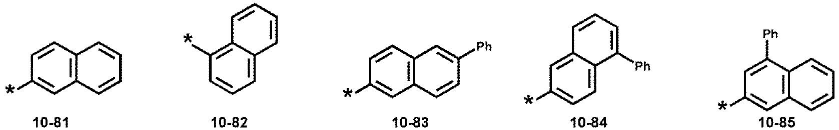 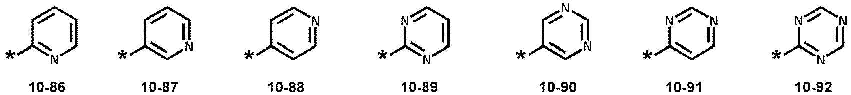 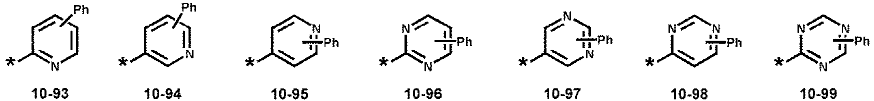 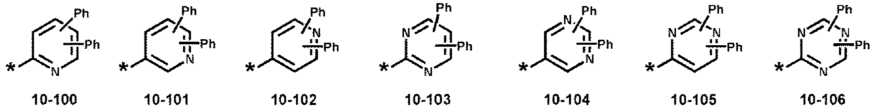 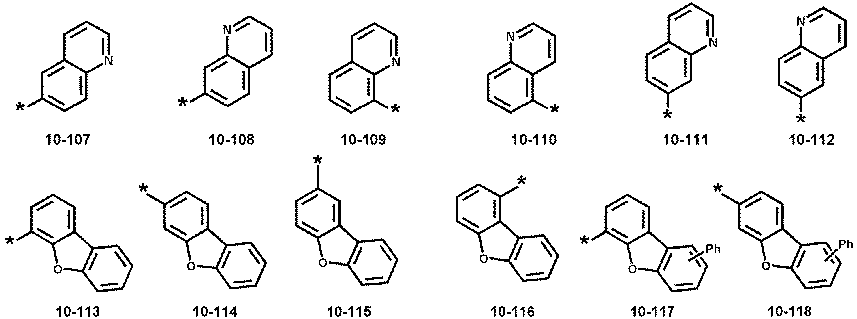 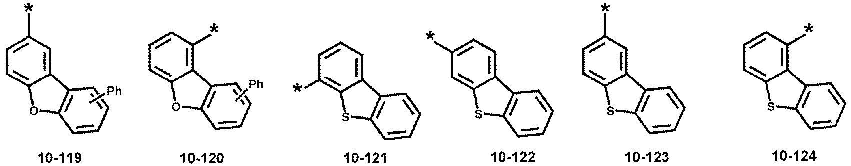 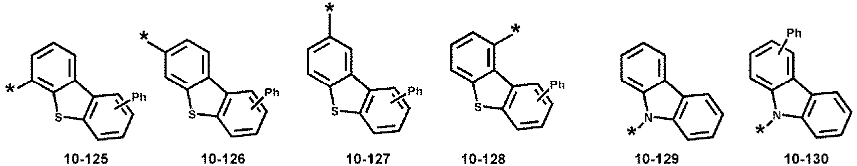 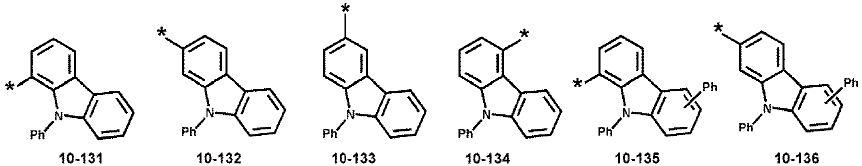 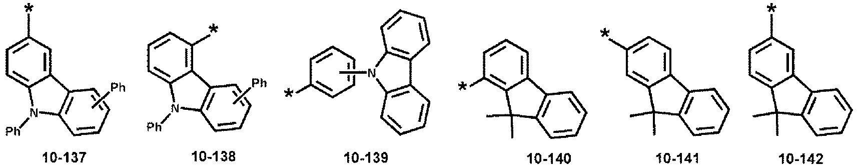 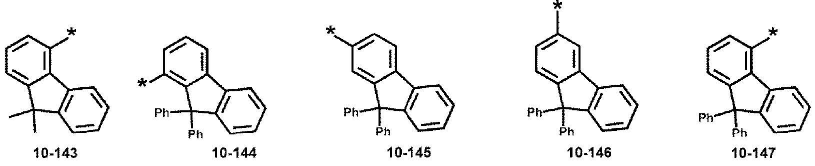 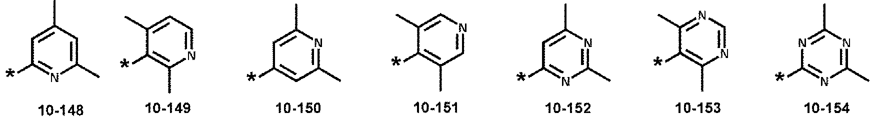 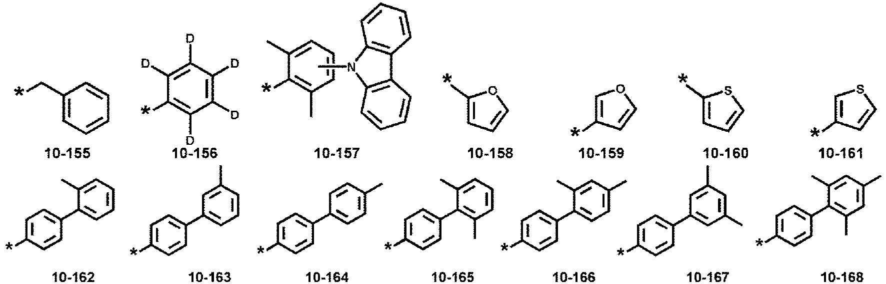 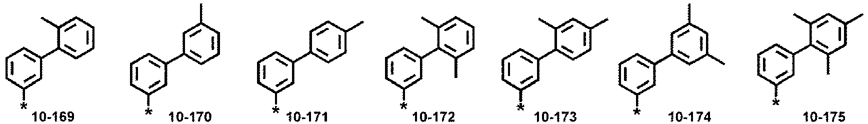 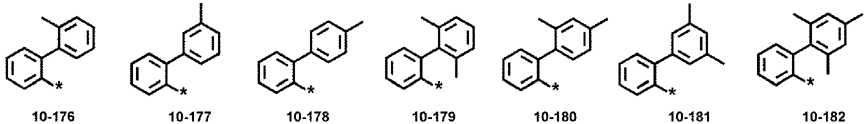 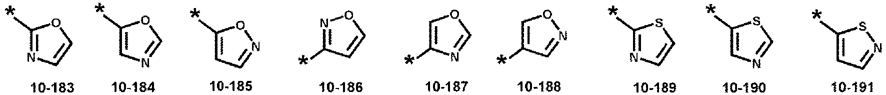 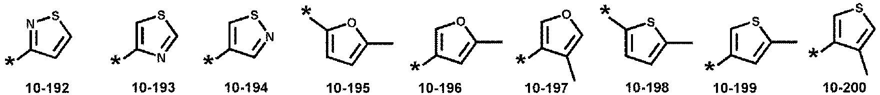 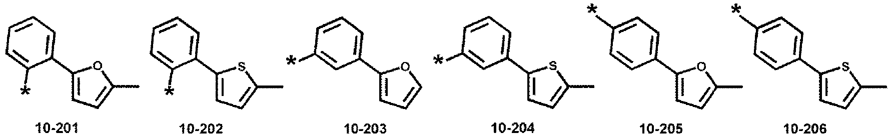 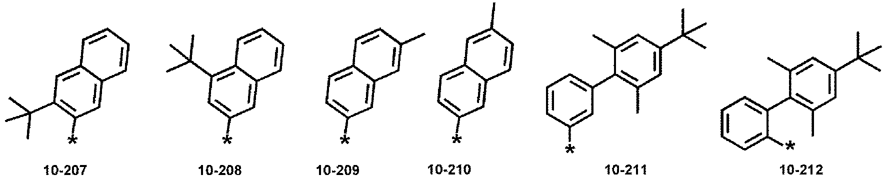 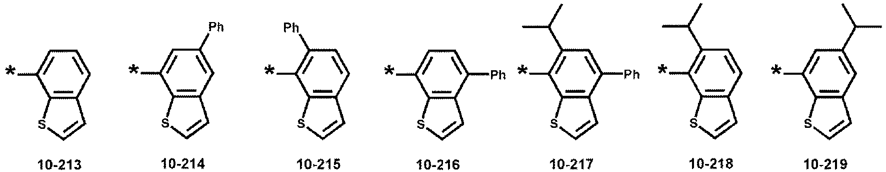 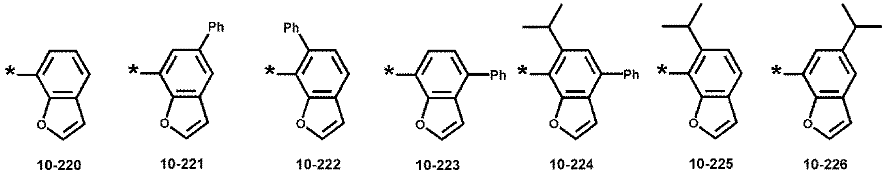 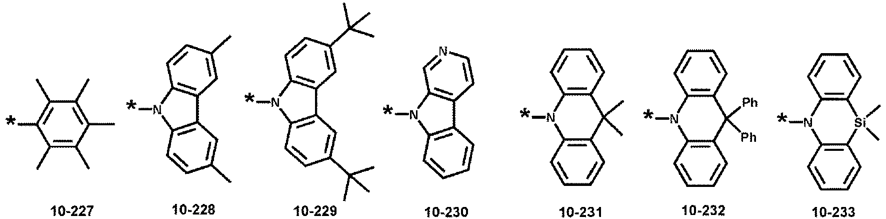 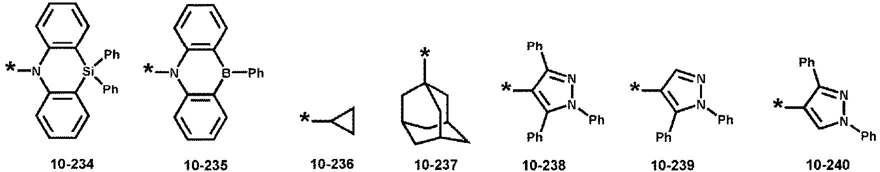 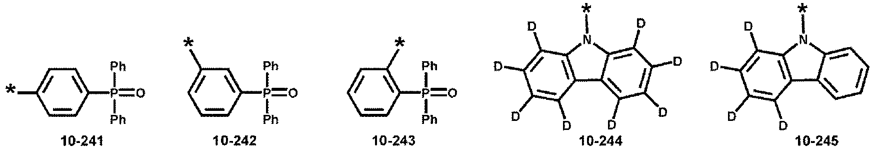 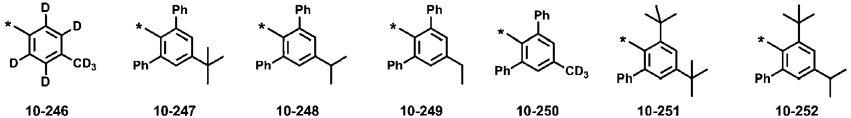 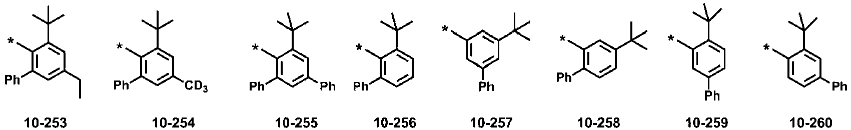 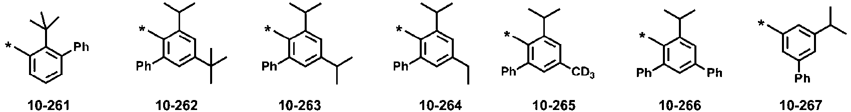 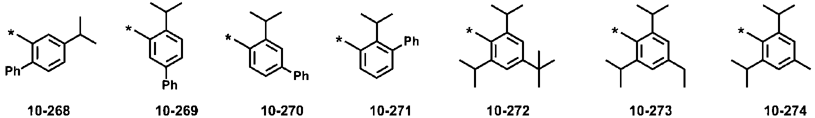 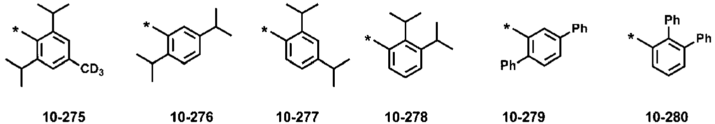 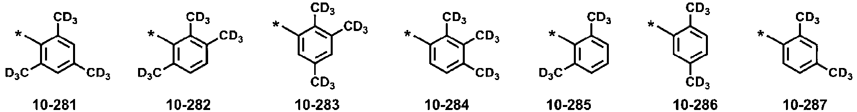 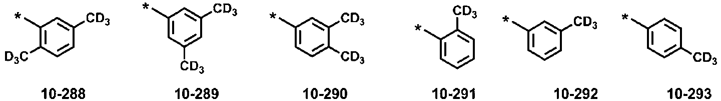 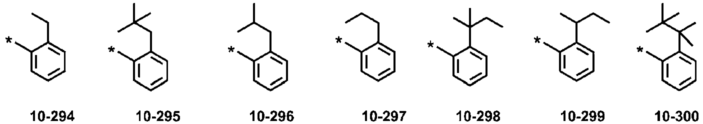 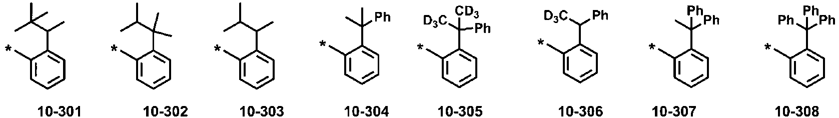 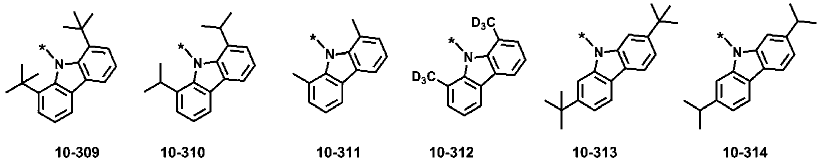 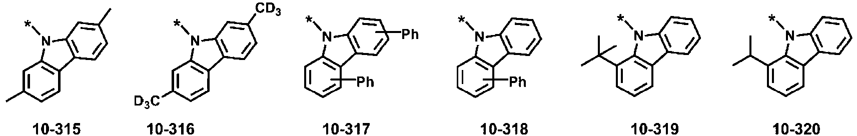 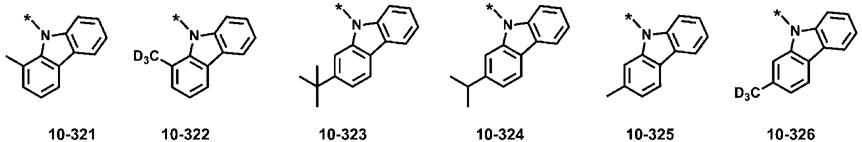 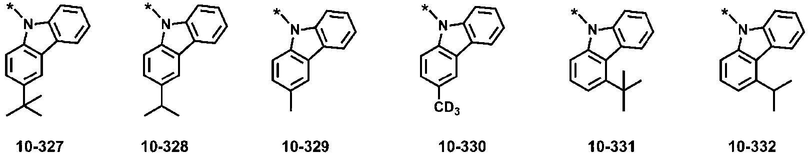 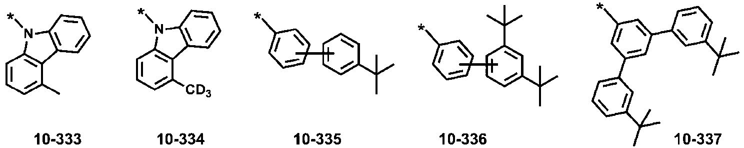 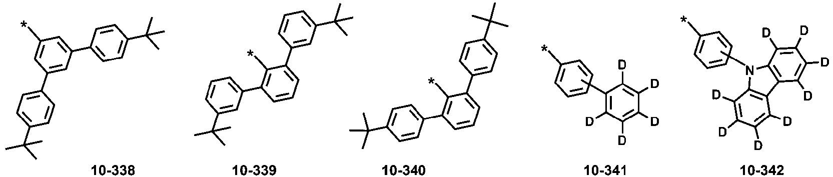 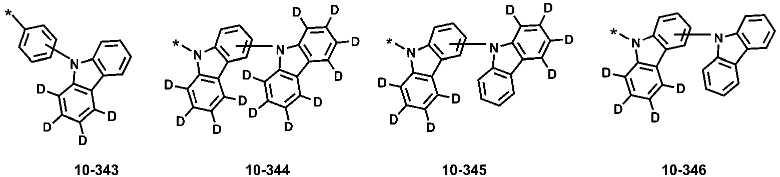 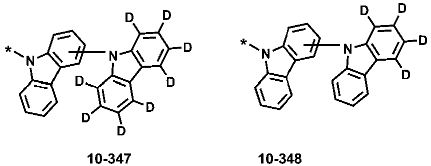
wherein, in Formulae 9-1 to 9-61 and 10-1 to 10-348, * indicates a binding site to a neighboring atom, "Ph" represents a phenyl group, and "TMS" represents a trimethylsilyl group.
Q₁ to Q₃ may each be as described herein.

In one or more embodiments, the electron transport region of the light-emitting device may include a hole-blocking layer, wherein the hole-blocking layer may include a phosphine oxide-containing compound, a silicon-containing compound, or any combination thereof. For example, the hole-blocking layer may directly contact the emission layer.

In one or more embodiments, the light-emitting device may further include a capping layer arranged outside the first electrode or outside the second electrode.

In one or more embodiments, the light-emitting device may further include at least one of a first capping layer arranged outside the first electrode and a second capping layer arranged outside the second electrode, wherein the condensed cyclic compound represented by Formula 1 may be included in at least one of the first capping layer and/or the second capping layer. A detailed description of the first capping layer and/or the second capping layer is provided herein.

In one or more embodiments, the light-emitting device may further include a first capping layer arranged outside the first electrode. For example, the first capping layer may include the condensed cyclic compound represented by Formula 1.

In one or more embodiments, the light-emitting device may further include a second capping layer arranged outside the second electrode. For example, the second capping layer may include the condensed cyclic compound represented by Formula 1.

In one or more embodiments, the light-emitting device may further include a first capping layer arranged outside the first electrode and a second capping layer arranged outside the second electrode. For example, at least one of the first capping layer and/or the second capping layer may include the condensed cyclic compound represented by Formula 1.

The wording "(interlayer and/or capping layer) includes a condensed cyclic compound" as used herein may be understood as "(interlayer and/or capping layer) may include one kind of condensed cyclic compound represented by Formula 1 or two or more different kinds of condensed cyclic compounds, each represented by Formula 1."

In one or more embodiments, the interlayer and/or the capping layer may include Compound 1 only as the condensed cyclic compound. In this regard, Compound 1 may be present in the emission layer of the light-emitting device. In one or more embodiments, the interlayer may include, as the condensed cyclic compound, Compound 1 and Compound 2. In this regard, Compound 1 and Compound 2 may be present in substantially the same layer (e.g., both (e.g., simultaneously) Compound 1 and Compound 2 may be present in the emission layer), or may be present in different layers (e.g., Compound 1 may be present in the emission layer, and Compound 2 may be present in the electron transport region).

The term "interlayer" as used herein refers to a single layer and/or all of multiple layers arranged between the first electrode and the second electrode of the light-emitting device.

Another aspect of the disclosure provides an electronic apparatus including the light-emitting device. The electronic apparatus may further include a thin-film transistor. For example, the electronic apparatus may further include a thin-film transistor including a source electrode and a drain electrode, wherein the first electrode of the light-emitting device may be electrically connected to the source electrode or the drain electrode. In one or more embodiments, the electronic apparatus may further include a color filter, a color conversion layer, a touch screen layer, a polarizing layer, or any combination thereof. A detailed description of the electronic apparatus is provided herein.

Another aspect of the disclosure provides electronic equipment including the electronic apparatus, wherein the electronic equipment may be one of a flat panel display, a curved display, a computer monitor, a medical monitor, a television, a billboard, an indoor light, an outdoor light, a signal light, a head-up display, a fully or partially transparent display, a flexible display, a rollable display, a foldable display, a stretchable display, a laser printer, a telephone, a mobile phone, a tablet, a phablet, a personal digital assistant (PDA), a wearable device, a laptop computer, a digital camera, a camcorder, a viewfinder, a micro display, a 3D display, a virtual reality display, an augmented reality display, a vehicle, a video wall including multiple displays tiled together, a theater screen, a stadium screen, a phototherapy device, and a signboard.

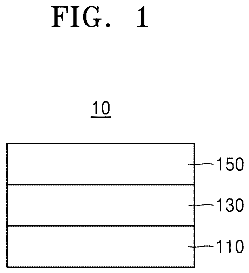

### Description of FIG. 1

FIG. 1 is a schematic cross-sectional view of a light-emitting device 10 according to one or more embodiments. The light-emitting device 10 includes a first electrode 110, an interlayer 130, and a second electrode 150.

Hereinafter, the structure of the light-emitting device 10 according to one or more embodiments and a method of manufacturing the light-emitting device 10 will be described with reference to FIG. 1.

### First electrode 110

In FIG. 1, a substrate may be additionally arranged under the first electrode 110 or on the second electrode 150. As the substrate, a glass substrate or a plastic substrate may be used. In one or more embodiments, the substrate may be a flexible substrate, and may include plastics with excellent or suitable heat resistance and durability, such as polyimide, polyethylene terephthalate (PET), polycarbonate, polyethylene naphthalate, polyarylate (PAR), polyetherimide, or any combination thereof.

The first electrode 110 may be formed by, for example, depositing or sputtering a material for forming the first electrode 110 on the substrate. When the first electrode 110 is an anode, a material for forming the first electrode 110 may be a high-work function material that facilitates injection of holes.

The first electrode 110 may be a reflective electrode, a transflective electrode, or a transmissive electrode. When the first electrode 110 is a transmissive electrode, a material for forming the first electrode 110 may include indium tin oxide (ITO), indium zinc oxide (IZO), tin oxide (SnO₂), zinc oxide (ZnO), or any combination thereof. In one or more embodiments, if (e.g., when) the first electrode 110 is a transflective electrode or a reflective electrode, a material for forming the first electrode 110 may include magnesium (Mg), silver (Ag), silver-lithium (Ag-Li), silver-sodium (AgNa), aluminium (Al), aluminium-lithium (Al-Li), calcium (Ca), magnesium-indium (Mg-In), magnesium-silver (Mg-Ag), or any combination thereof.

The first electrode 110 may have a single-layer structure including (e.g., consisting of) a single layer or a multi-layer structure including multiple layers. For example, the first electrode 110 may have a three-layer structure of ITO/Ag/ITO.

### Interlayer 130

The interlayer 130 is arranged on the first electrode 110. The interlayer 130 includes an emission layer.

The interlayer 130 may further include a hole transport region arranged between the first electrode 110 and the emission layer and an electron transport region arranged between the emission layer and the second electrode 150.

The interlayer 130 may further include, in addition to one or more suitable organic materials, a metal-containing compound such as an organometallic compound, an inorganic material such as a quantum dot, and/or the like.

### Hole transport region in interlayer 130

The hole transport region may have i) a single-layer structure including (e.g., consisting of) a single layer including (e.g., consisting of) a single material, ii) a single-layer structure including (e.g., consisting of) a single layer including multiple different materials, or iii) a multi-layer structure including multiple layers including multiple different materials.

The hole transport region may include a hole injection layer, a hole transport layer, an emission auxiliary layer, an electron-blocking layer, or any combination thereof.

In one or more embodiments, the hole transport region may have a multi-layer structure including a hole injection layer/hole transport layer structure, a hole injection layer/hole transport layer/emission auxiliary layer structure, a hole injection layer/emission auxiliary layer structure, a hole transport layer/emission auxiliary layer structure, or a hole injection layer/hole transport layer/electron-blocking layer structure, wherein constituent layers of each structure are stacked sequentially from the first electrode 110.

The hole transport region may include a compound represented by Formula 201, a compound represented by Formula 202, or any combination thereof: 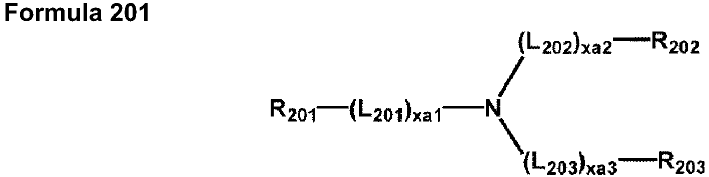 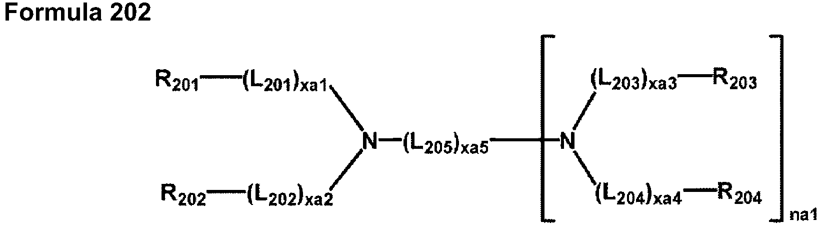
wherein, in Formulae 201 and 202,
L₂₀₁ to L₂₀₄ may each independently be a C₃-C₆₀ carbocyclic group unsubstituted or substituted with at least one R₁₀ₐ or a C₁-C₆₀ heterocyclic group unsubstituted or substituted with at least one R₁₀ₐ,
L₂₀₅ may be *-O-*', *-S-*', *-N(Q₂₀₁)-*', a C₁-C₂₀ alkylene group unsubstituted or substituted with at least one R₁₀ₐ, a C₂-C₂₀ alkenylene group unsubstituted or substituted with at least one R₁₀ₐ, a C₃-C₆₀ carbocyclic group unsubstituted or substituted with at least one R₁₀ₐ, or a C₁-C₆₀ heterocyclic group unsubstituted or substituted with at least one R₁₀ₐ,
xa1 to xa4 may each independently be an integer from 0 to 5,
xa5 may be an integer from 1 to 10,
R₂₀₁ to R₂₀₄ and Q₂₀₁ may each independently be a C₃-C₆₀ carbocyclic group unsubstituted or substituted with at least one R₁₀ₐ or a C₁-C₆₀ heterocyclic group unsubstituted or substituted with at least one R₁₀ₐ,
R₂₀₁ and R₂₀₂ may optionally be linked to each other via a single bond, a C₁-C₅ alkylene group unsubstituted or substituted with at least one R₁₀ₐ, or a C₂-C₅ alkenylene group unsubstituted or substituted with at least one R₁₀ₐ, to form a C₈-C₆₀ polycyclic group (e.g., a carbazole group, and/or the like) unsubstituted or substituted with at least one R₁₀ₐ (e.g., Compound HT16, and/or the like),
R₂₀₃ and R₂₀₄ may optionally be linked to each other via a single bond, a C₁-C₅ alkylene group unsubstituted or substituted with at least one R₁₀ₐ, or a C₂-C₅ alkenylene group unsubstituted or substituted with at least one R₁₀ₐ, to form a C₈-C₆₀ polycyclic group unsubstituted or substituted with at least one R₁₀ₐ, and
na1 may be an integer from 1 to 4.

In one or more embodiments, each of Formulae 201 and 202 may include at least one of groups represented by Formulae CY201 to CY217: 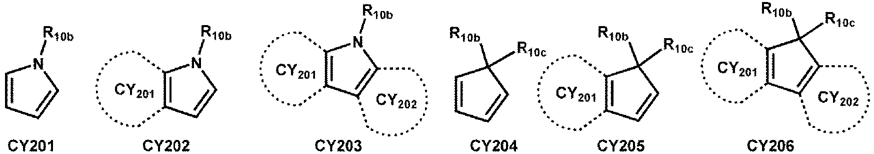 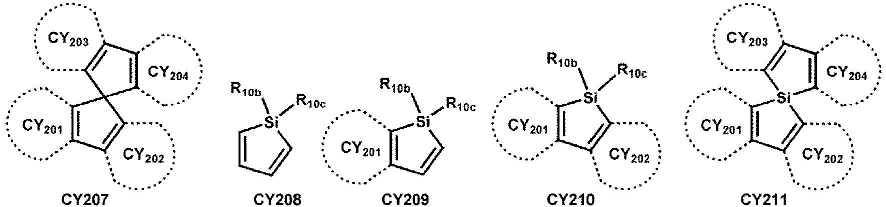 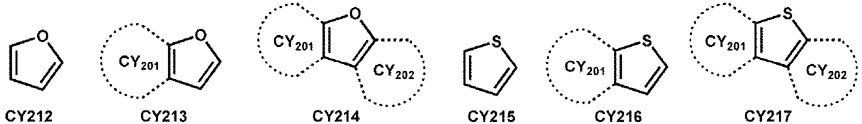 wherein, in Formulae CY201 to CY217, R_{10b} and R_{10c} may each be as described in connection with R₁₀ₐ, ring CY₂₀₁ to ring CY₂₀₄ may each independently be a C₃-C₂₀ carbocyclic group or a C₁-C₂₀ heterocyclic group, and at least one hydrogen in Formulae CY201 to CY217 may be unsubstituted or substituted with R₁₀ₐ.

In one or more embodiments, ring CY₂₀₁ to ring CY₂₀₄ in Formulae CY201 to CY217 may each independently be a benzene group, a naphthalene group, a phenanthrene group, or an anthracene group.

In one or more embodiments, each of Formulae 201 and 202 may include at least one of groups represented by Formulae CY201 to CY203.

In one or more embodiments, Formula 201 may include at least one of groups represented by Formulae CY201 to CY203 and at least one of groups represented by Formulae CY204 to CY217.

In one or more embodiments, in Formula 201, xa1 may be 1, R₂₀₁ may be a group represented by one of Formulae CY201 to CY203, xa2 may be 0, and R₂₀₂ may be a group represented by one of Formulae CY204 to CY207.

In one or more embodiments, each of Formulae 201 and 202 may not include (e.g., may exclude any) groups represented by Formulae CY201 to CY203.

In one or more embodiments, each of Formulae 201 and 202 may not include (e.g., may exclude any) groups represented by Formulae CY201 to CY203, and may include at least one of groups represented by Formulae CY204 to CY217.

In one or more embodiments, each of Formulae 201 and 202 may not include (e.g., may exclude any) groups represented by Formulae CY201 to CY217.

In one or more embodiments, the hole transport region may include: one of (e.g., selected from among) Compounds HT1 to HT46; m-MTDATA; TDATA; 2-TNATA; NPB(NPD); β-NPB; TPD; spiro-TPD; spiro-NPB; methylated NPB; TAPC; HMTPD; 4,4',4"-tris(N-carbazolyl)triphenylamine (TCTA); polyaniline/dodecylbenzenesulfonic acid (PANI/DBSA); poly(3,4-ethylenedioxythiophene)/poly(4-styrenesulfonate) (PEDOT/PSS); polyaniline/camphor sulfonic acid (PANI/CSA); polyaniline/poly(4-styrenesulfonate) (PANI/PSS); or any combination thereof:

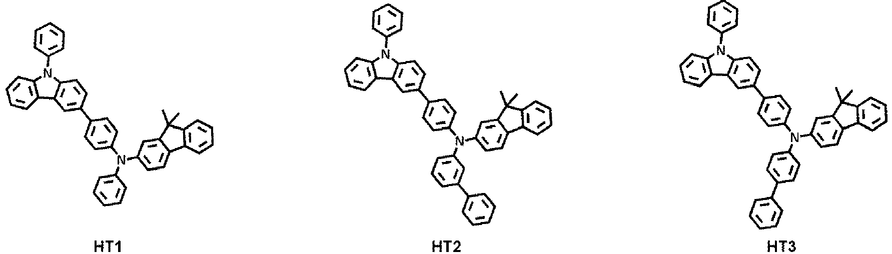

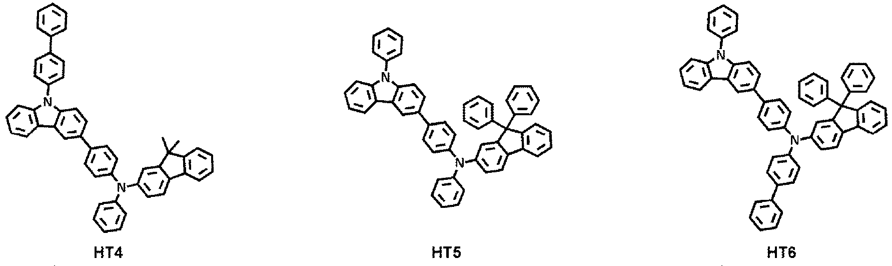

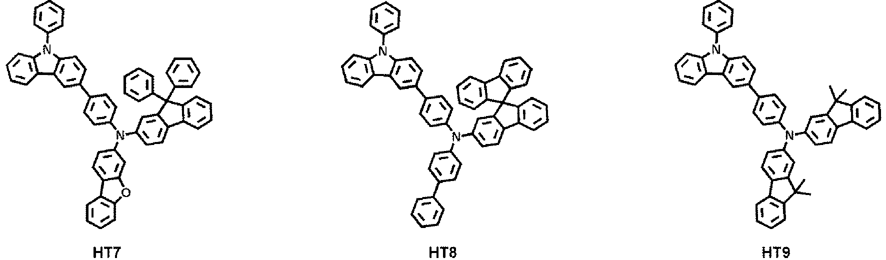

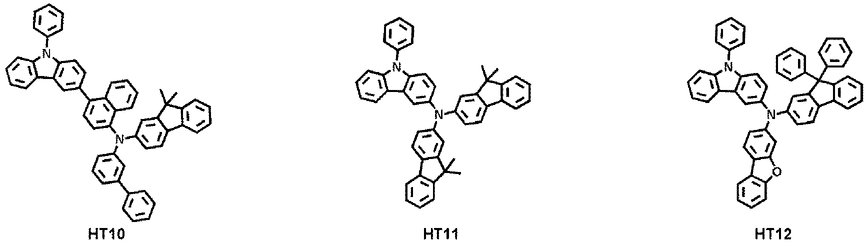

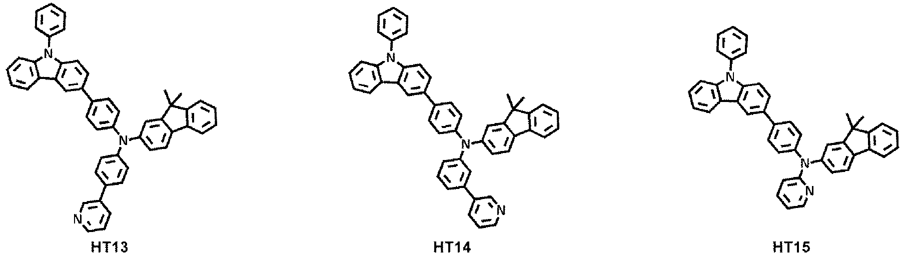

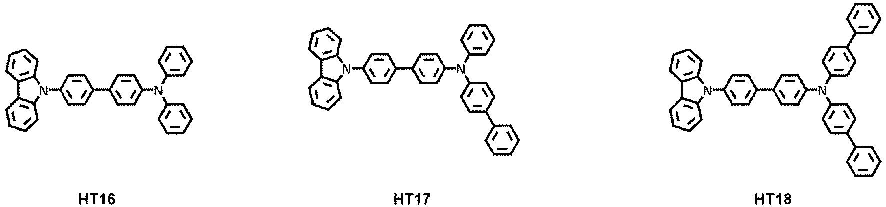

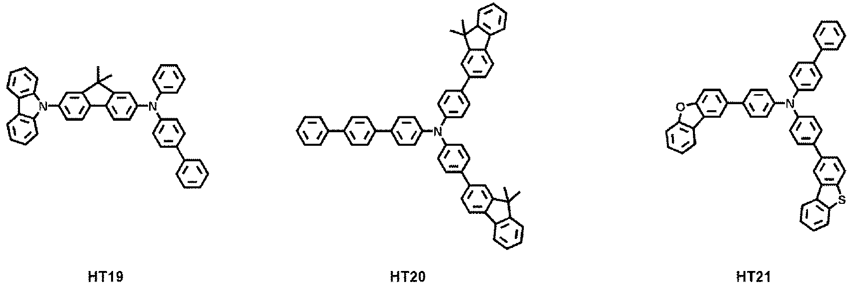

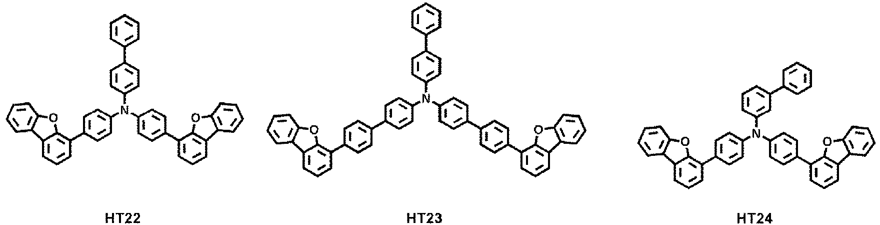

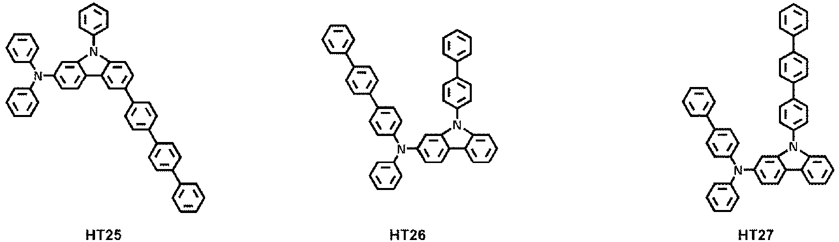

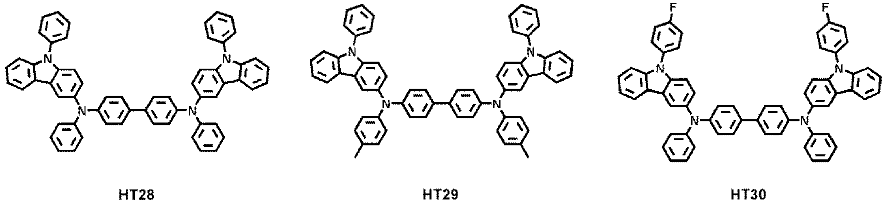

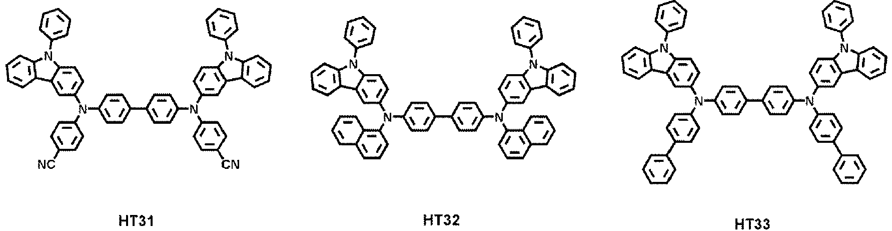

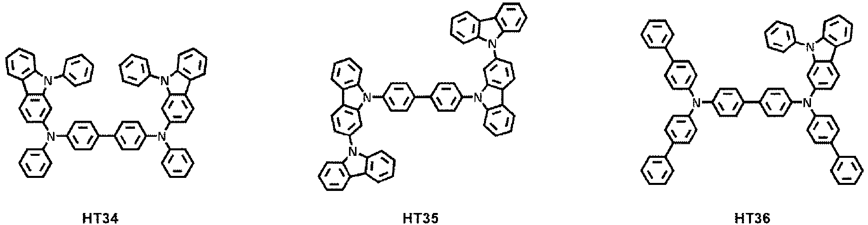

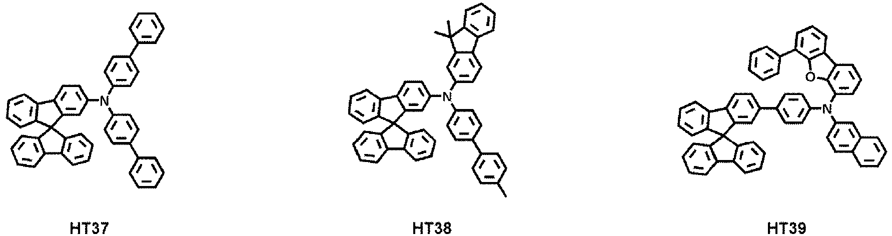

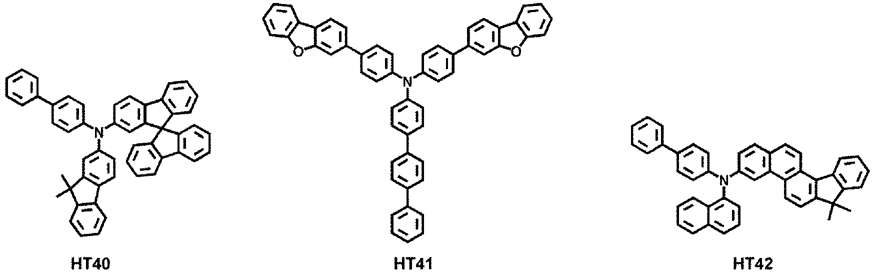

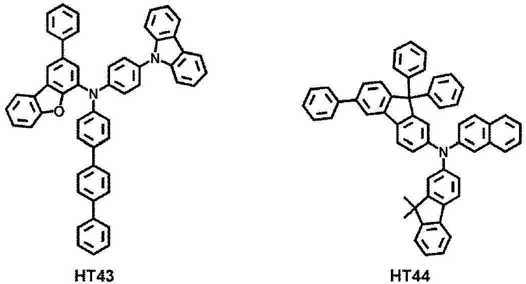

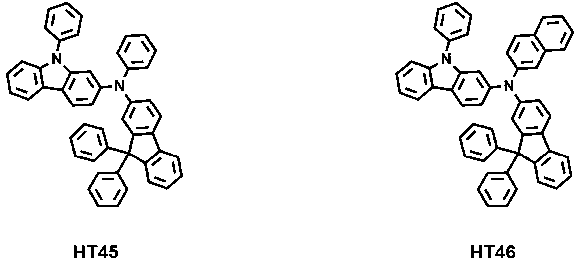

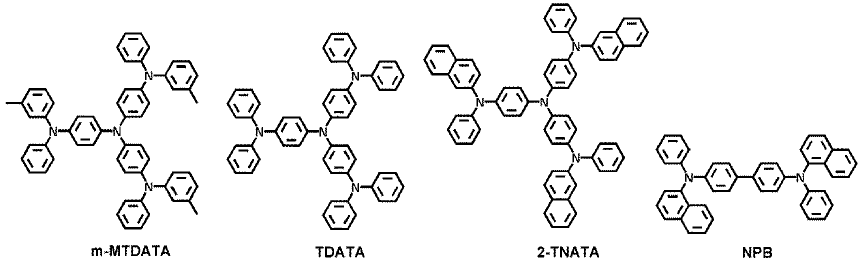

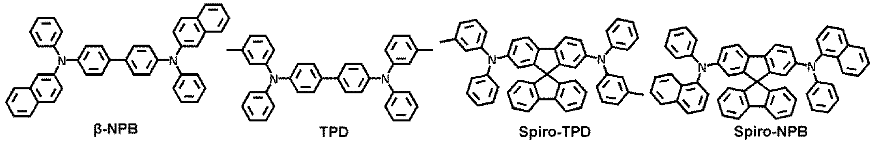

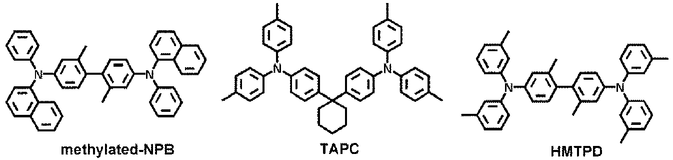

The thickness of the hole transport region may be in a range of about 50 angstrom (Å) to about 10,000 Å, for example, about 100 Å to about 4,000 Å. When the hole transport region includes a hole injection layer, a hole transport layer, or any combination thereof, the thickness of the hole injection layer may be in a range of about 100 Å to about 9,000 Å, for example, about 100 Å to about 1,000 Å, and the thickness of the hole transport layer may be in a range of about 50 Å to about 2,000 Å, for example, about 100 Å to about 1,500 Å. When the thicknesses of the hole transport region, the hole injection layer, and the hole transport layer are within the ranges described herein, satisfactory hole-transporting characteristics may be obtained without a substantial increase in driving voltage.

The emission auxiliary layer may increase light emission efficiency by compensating for an optical resonance distance according to the wavelength of light emitted by the emission layer, and the electron-blocking layer may reduce or block the leakage of electrons from the emission layer to the hole transport region. Materials that may be included in the hole transport region may be included in the emission auxiliary layer and the electron-blocking layer.

### p-dopant

The hole transport region may further include, in addition to the condensed cyclic compound represented by Formula 1, a charge generation material for improving conductivity. The charge generation material may be uniformly (e.g., substantially uniformly) or non-uniformly (e.g., substantially non-uniformly) dispersed in the hole transport region (e.g., in the form of a single layer including (e.g., consisting of) the charge generation material).

The charge generation material may be, for example, a p-dopant.

In one or more embodiments, the p-dopant may have a LUMO energy level of -3.5 electron volt (eV) or less.

In one or more embodiments, the p-dopant may include a quinone derivative, a cyano group-containing compound, a compound including an element EL1 and an element EL2, or any combination thereof.

Examples of the cyano group-containing compound may include a compound represented by Formula 221 and/or the like: 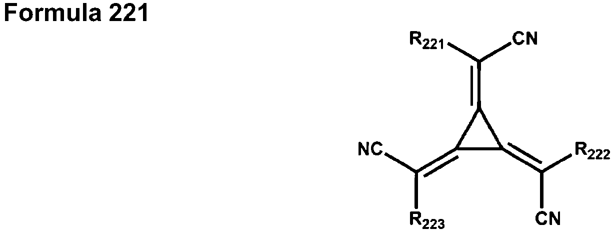
wherein, in Formula 221,
R₂₂₁ to R₂₂₃ may each independently be a C₃-C₆₀ carbocyclic group unsubstituted or substituted with at least one R₁₀ₐ or a C₁-C₆₀ heterocyclic group unsubstituted or substituted with at least one R₁₀ₐ, and
at least one of R₂₂₁ to R₂₂₃ may each independently be a C₃-C₆₀ carbocyclic group or a C₁-C₆₀ heterocyclic group, each substituted with: a cyano group; -F; -Cl; -Br; -I; a C₁-C₂₀ alkyl group substituted with a cyano group, -F, -Cl, -Br, -I, or any combination thereof; or any combination thereof.

In the compound including the element EL1 and the element EL2, the element EL1 may be a metal, a metalloid, and/or a (e.g., any suitable) combination thereof, and the element EL2 may be a non-metal, a metalloid, and/or a (e.g., any suitable) combination thereof.

Examples of the metal may include: an alkali metal (e.g., lithium (Li), sodium (Na), potassium (K), rubidium (Rb), cesium (Cs), and/or the like); an alkaline earth metal (e.g., beryllium (Be), magnesium (Mg), calcium (Ca), strontium (Sr), barium (Ba), and/or the like); a transition metal (e.g., titanium (Ti), zirconium (Zr), hafnium (Hf), vanadium (V), niobium (Nb), tantalum (Ta), chromium (Cr), molybdenum (Mo), tungsten (W), manganese (Mn), technetium (Tc), rhenium (Re), iron (Fe), ruthenium (Ru), osmium (Os), cobalt (Co), rhodium (Rh), iridium (Ir), nickel (Ni), palladium (Pd), platinum (Pt), copper (Cu), silver (Ag), gold (Au), and/or the like); a post-transition metal (e.g., zinc (Zn), indium (In), tin (Sn), and/or the like); a lanthanide metal (e.g., lanthanum (La), cerium (Ce), praseodymium (Pr), neodymium (Nd), promethium (Pm), samarium (Sm), europium (Eu), gadolinium (Gd), terbium (Tb), dysprosium (Dy), holmium (Ho), erbium (Er), thulium (Tm), ytterbium (Yb), lutetium (Lu), and/or the like); and/or the like.

Examples of the metalloid may include silicon (Si), antimony (Sb), tellurium (Te), and/or the like.

Examples of the non-metal may include oxygen (O), a halogen (e.g., F, Cl, Br, I, and/or the like), and/or the like.

Examples of the compound including the element EL1 and the element EL2 may include a metal oxide, a metal halide (e.g., a metal fluoride, a metal chloride, a metal bromide, a metal iodide, and/or the like), a metalloid halide (e.g., a metalloid fluoride, a metalloid chloride, a metalloid bromide, a metalloid iodide, and/or the like), a metal telluride, or any combination thereof.

Examples of the metal oxide may include a tungsten oxide (e.g., WO, W₂O₃, WO₂, WO₃, W₂O₅, and/or the like), a vanadium oxide (e.g., VO, V₂O₃, VO₂, V₂O₅, and/or the like), a molybdenum oxide (e.g., MoO, Mo₂O₃, MoO₂, MoO₃, Mo₂O₅, and/or the like), a rhenium oxide (e.g., ReO₃, and/or the like), and/or the like.

Examples of the metal halide may include an alkali metal halide, an alkaline earth metal halide, a transition metal halide, a post-transition metal halide, a lanthanide metal halide, and/or the like.

Examples of the alkali metal halide may include LiF, NaF, KF, RbF, CsF, LiCl, NaCl, KCI, RbCl, CsCl, LiBr, NaBr, KBr, RbBr, CsBr, Lil, Nal, Kl, Rbl, Csl, and/or the like.

Examples of the alkaline earth metal halide may include BeF₂, MgF₂, CaF₂, SrF₂, BaF₂, BeCl₂, MgCl₂, CaCl₂, SrCl₂, BaCl₂, BeBr₂, MgBr₂, CaBr₂, SrBr₂, BaBr₂, BeI₂, MgI₂, CaI₂, SrI₂, BaI₂, and/or the like.

Examples of the transition metal halide may include a titanium halide (e.g., TiF₄, TiCl₄, TiBr₄, TiI₄, and/or the like), a zirconium halide (e.g., ZrF₄, ZrCl₄, ZrBr₄, ZrI₄, and/or the like), a hafnium halide (e.g., HfF₄, HfCl₄, HfBr₄, HfI₄, and/or the like), a vanadium halide (e.g., VF₃, VCl₃, VBr₃, VI₃, and/or the like.), a niobium halide (e.g., NbF₃, NbCl₃, NbBr₃, NbI₃, and/or the like), a tantalum halide (e.g., TaF₃, TaCl₃, TaBr₃, TaI₃, and/or the like), a chromium halide (e.g., CrF₃, CrCl₃, CrBr₃, CrI₃, and/or the like), a molybdenum halide (e.g., MoF₃, MoCl₃, MoBr₃, MoI₃, and/or the like), a tungsten halide (e.g., WF₃, WCl₃, WBr₃, WI₃, and/or the like), a manganese halide (e.g., MnF₂, MnCl₂, MnBr₂, MnI₂, and/or the like), a technetium halide (e.g., TcF₂, TcCl₂, TcBr₂, TcI₂, and/or the like), a rhenium halide (e.g., ReF₂, ReCl₂, ReBr₂, ReI₂, and/or the like), an Iron(II) halide (e.g., FeF₂, FeCl₂, FeBr₂, FeI₂, and/or the like), a ruthenium halide (e.g., RuF₂, RuCl₂, RuBr₂, RuI₂, and/or the like), an osmium halide (e.g., OsF₂, OsCl₂, OsBr₂, OsI₂, and/or the like), a cobalt halide (e.g., CoF₂, CoCl₂, CoBr₂, CoI₂, and/or the like), a rhodium halide (e.g., RhF₂, RhCl₂, RhBr₂, RhI₂, and/or the like), an iridium halide (e.g., IrF₂, IrCl₂, IrBr₂, IrI₂, and/or the like), a nickel halide (e.g., NiF₂, NiCl₂, NiBr₂, NiI₂, and/or the like), a palladium halide (e.g., PdF₂, PdCl₂, PdBr₂, PdI₂, and/or the like), a platinum halide (e.g., PtF₂, PtCl₂, PtBr₂, PtI₂, and/or the like), a Copper(I) halide (e.g., CuF, CuCl, CuBr, Cul, and/or the like), a silver halide (e.g., AgF, AgCl, AgBr, Agl, and/or the like), a gold halide (e.g., AuF, AuCl, AuBr, Aul, and/or the like), and/or the like.

Examples of the post-transition metal halide may include a zinc halide (e.g., ZnF₂, ZnCl₂, ZnBr₂, ZnI₂, and/or the like), an indium halide (e.g., InI₃, and/or the like), a tin halide (e.g., SnI₂, and/or the like), and/or the like.

Examples of the lanthanide metal halide may include YbF, YbF₂, YbF₃, SmF₃, YbCl, YbCl₂, YbCl₃, SmCl₃, YbBr, YbBr₂, YbBr₃, SmBr₃, Ybl, YbI₂, YbI₃, SmI₃, and/or the like.

Examples of the metalloid halide may include an antimony halide (e.g., SbCl₅, and/or the like) and/or the like.

Examples of the metal telluride may include an alkali metal telluride (e.g., Li₂Te, Na₂Te, K₂Te, Rb₂Te, Cs₂Te, and/or the like), an alkaline earth metal telluride (e.g., BeTe, MgTe, CaTe, SrTe, BaTe, and/or the like), a transition metal telluride (e.g., TiTe₂, ZrTe₂, HfTe₂, V₂Te₃, Nb₂Te₃, Ta₂Te₃, Cr₂Te₃, Mo₂Te₃, W₂Te₃, MnTe, TcTe, ReTe, FeTe, RuTe, OsTe, CoTe, RhTe, IrTe, NiTe, PdTe, PtTe, Cu₂Te, CuTe, Ag₂Te, AgTe, Au₂Te, and/or the like), a post-transition metal telluride (e.g., ZnTe, and/or the like), a lanthanide metal telluride (e.g., LaTe, CeTe, PrTe, NdTe, PmTe, EuTe, GdTe, TbTe, DyTe, HoTe, ErTe, TmTe, YbTe, LuTe, and/or the like), and/or the like.

### Emission layer in interlayer 130

When the light-emitting device 10 is a full-color light-emitting device, the emission layer may be patterned into a red emission layer, a green emission layer, and/or a blue emission layer, according to a subpixel. In one or more embodiments, the emission layer may have a stacked structure of two or more layers of a red emission layer, a green emission layer, and a blue emission layer, in which the two or more layers contact each other or are separated from each other, to emit white light. In one or more embodiments, the emission layer may include two or more materials of a red light-emitting material, a green light-emitting material, and a blue light-emitting material, in which the two or more materials are mixed with each other in a single layer, to emit white light.

The emission layer may include a host and a dopant. The dopant may include a phosphorescent dopant, a fluorescent dopant, or any combination thereof.

The amount of the dopant in the emission layer may be in a range of about 0.01 parts by weight to about 15 parts by weight based on 100 parts by weight of the host.

In one or more embodiments, the emission layer may include a quantum dot.

In one or more embodiments, the emission layer may include a delayed fluorescence material. The delayed fluorescence material may act as a host or a dopant in the emission layer.

The thickness of the emission layer may be in a range of about 100 Å to about 1,000 Å, for example, about 200 Å to about 600 Å. When the thickness of the emission layer is within the range described herein, excellent or suitable luminescence characteristics may be obtained without a substantial increase in driving voltage.

### [Host]

The host may further include a compound represented by Formula 301:

**Formula 301** [Ar₃₀₁]_{xb11}-[(L₃₀₁)_{xb1}-R₃₀₁]_{xb21}

wherein, in Formula 301,
Ar₃₀₁ and L₃₀₁ may each independently be a C₃-C₆₀ carbocyclic group unsubstituted or substituted with at least one R₁₀ₐ or a C₁-C₆₀ heterocyclic group unsubstituted or substituted with at least one R₁₀ₐ,
xb11 may be 1, 2, or 3,
xb1 may be an integer from 0 to 5,
R₃₀₁ may be hydrogen, deuterium, -F, -Cl, -Br, -I, a hydroxyl group, a cyano group, a nitro group, a C₁-C₆₀ alkyl group unsubstituted or substituted with at least one R₁₀ₐ, a C₂-C₆₀ alkenyl group unsubstituted or substituted with at least one R₁₀ₐ, a C₂-C₆₀ alkynyl group unsubstituted or substituted with at least one R₁₀ₐ, a C₁-C₆₀ alkoxy group unsubstituted or substituted with at least one R₁₀ₐ, a C₃-C₆₀ carbocyclic group unsubstituted or substituted with at least one R₁₀ₐ, a C₁-C₆₀ heterocyclic group unsubstituted or substituted with at least one R₁₀ₐ, -Si(Q₃₀₁)(Q₃₀₂)(Q₃₀₃), -N(Q₃₀₁)(Q₃₀₂), -B(Q₃₀₁)(Q₃₀₂), -C(=O)(Q₃₀₁), -S(=O)₂(Q₃₀₁), or -P(=O)(Q₃₀₁)(Q₃₀₂),
xb21 may be an integer from 1 to 5, and
Q₃₀₁ to Q₃₀₃ may each be as described in connection with Q₁.

In one or more embodiments, if (e.g., when) xb11 in Formula 301 is 2 or more, two or more of Ar₃₀₁ may be linked to each other via a single bond.

In one or more embodiments, the host may include a compound represented by Formula 301-1, a compound represented by Formula 301-2, or any combination thereof: 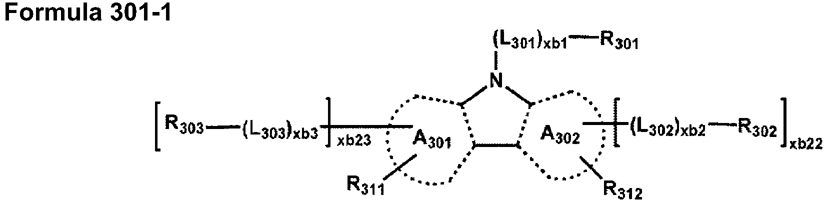 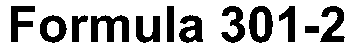 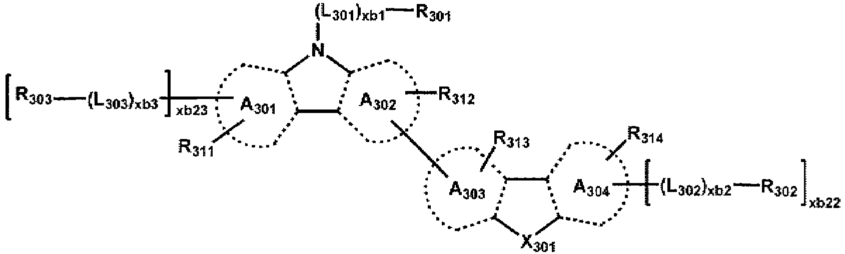
wherein, in Formulae 301-1 and 301-2,
ring A₃₀₁ to ring A₃₀₄ may each independently be a C₃-C₆₀ carbocyclic group unsubstituted or substituted with at least one R₁₀ₐ or a C₁-C₆₀ heterocyclic group unsubstituted or substituted with at least one R₁₀ₐ,
X₃₀₁ may be O, S, N-[(L₃₀₄)_{xb4}-R₃₀₄], C(R₃₀₄)(R₃₀₅), or Si(R₃₀₄)(R₃₀₅),
xb22 and xb23 may each independently be 0, 1, or 2,
L₃₀₁, xb1, and R₃₀₁ may each be as described herein,
L₃₀₂ to L₃₀₄ may each independently be as described in connection with L₃₀₁,
xb2 to xb4 may each independently be as described in connection with xb1, and
R₃₀₂ to R₃₀₅ and R₃₁₁ to R₃₁₄ may each be as described in connection with R301.

In one or more embodiments, the host may include an alkaline earth metal complex, a post-transition metal complex, or any combination thereof. For example, the host may include a Be complex (e.g., Compound H55), a Mg complex, a Zn complex, or any combination thereof.

In one or more embodiments, the host may include: one of (e.g., at least one selected from among) Compounds H1 to H128; 9,10-di(2-naphthyl)anthracene (ADN); 2-methyl-9,10-bis(naphthalen-2-yl)anthracene (MADN); 9,10-di-(2-naphthyl)-2-t-butyl-anthracene (TBADN); 4,4'-bis(N-carbazolyl)-1,1'-biphenyl (CBP);1,3-di(carbazol-9-yl)benzene (mCP); 1,3,5-tri(carbazol-9-yl)benzene (TCP); or any combination thereof:

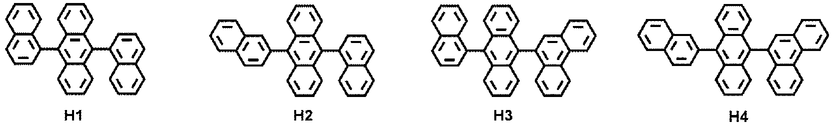

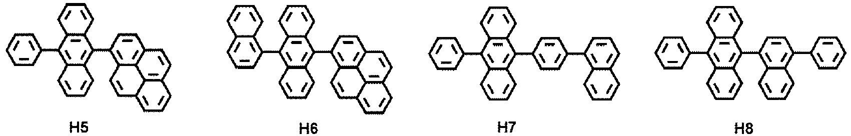

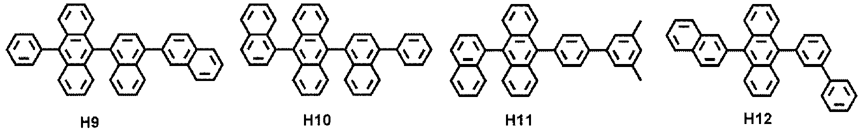

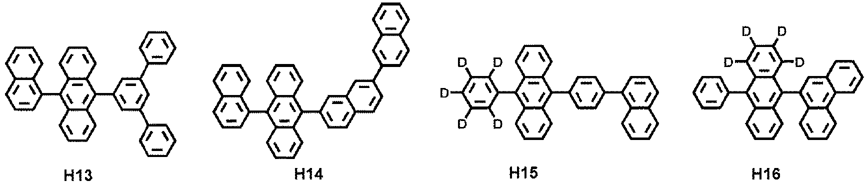

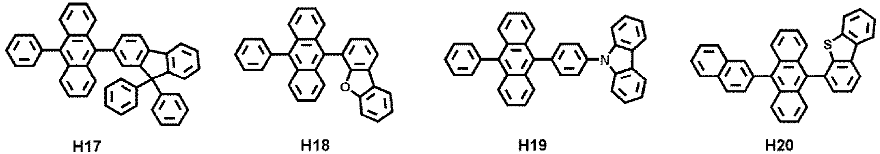

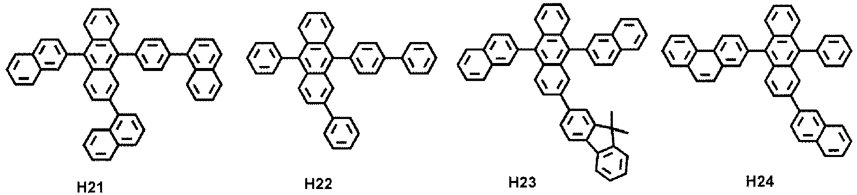

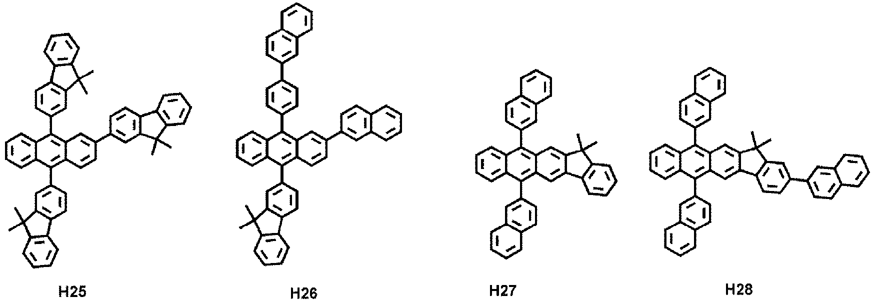

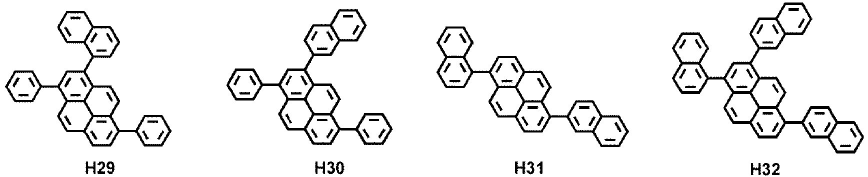

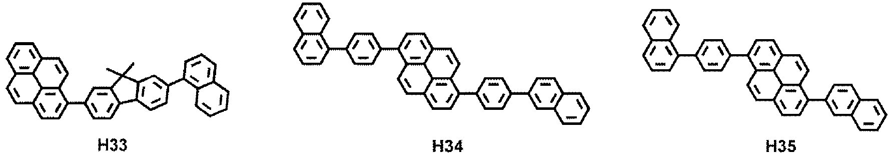

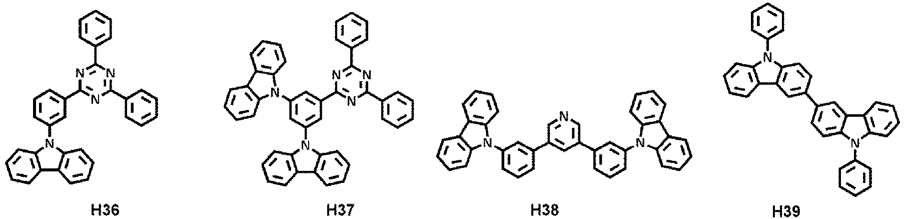

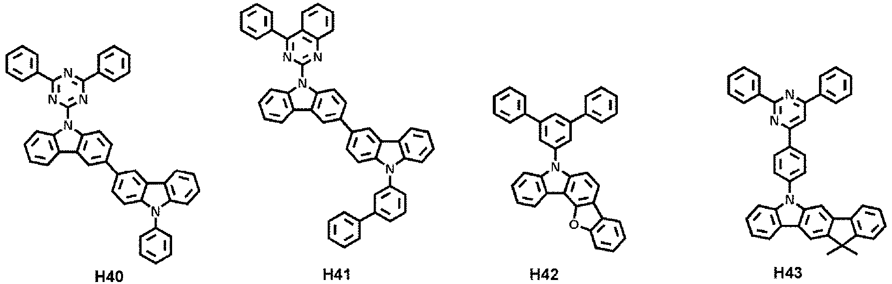

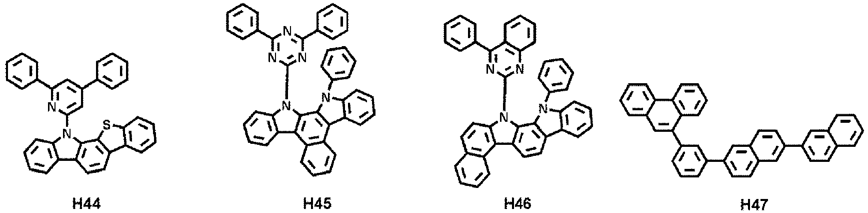

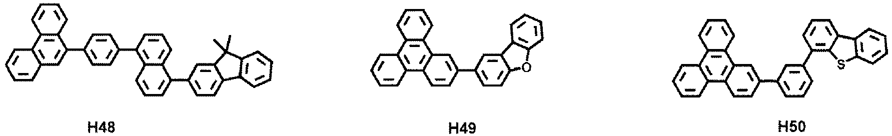

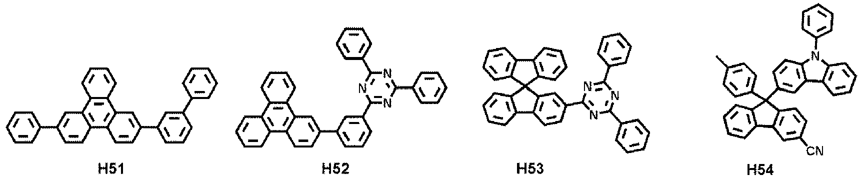

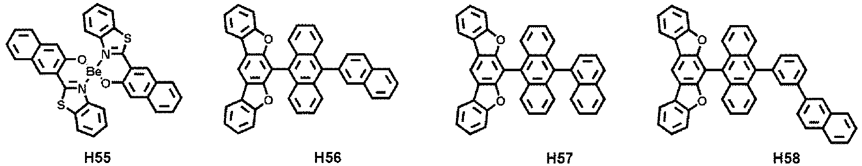

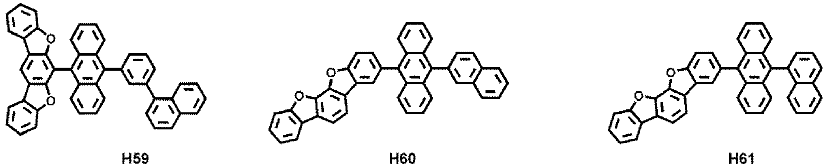

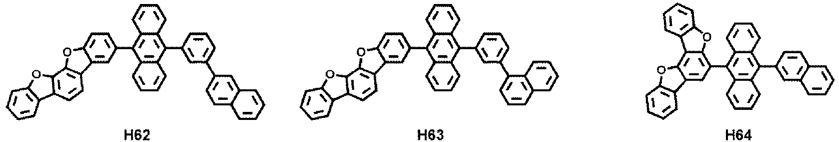

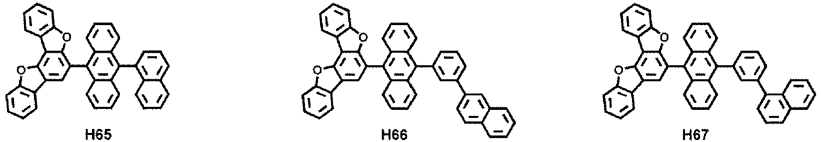

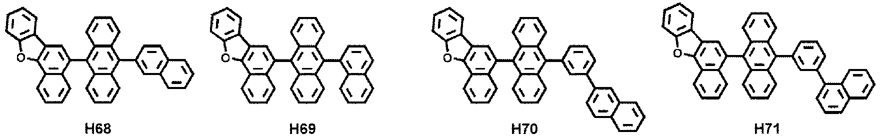

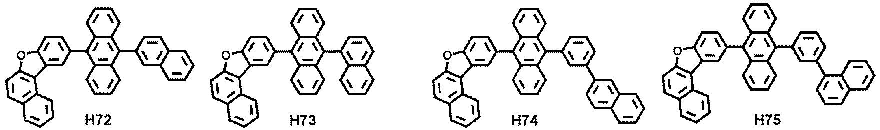

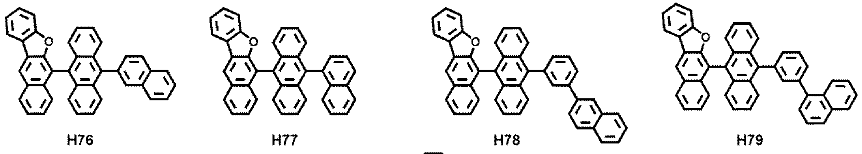

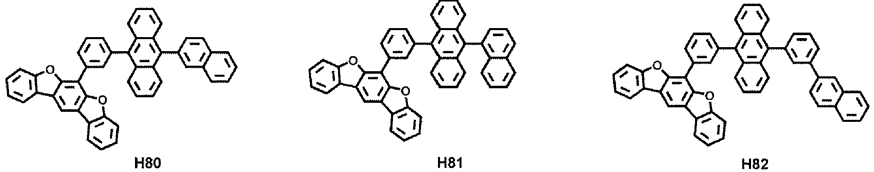

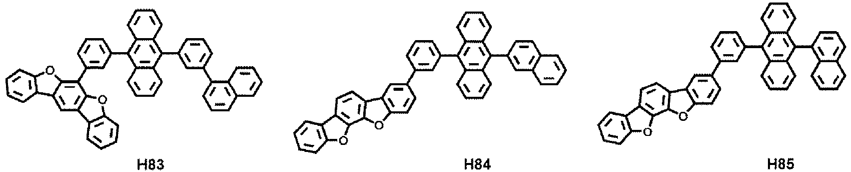

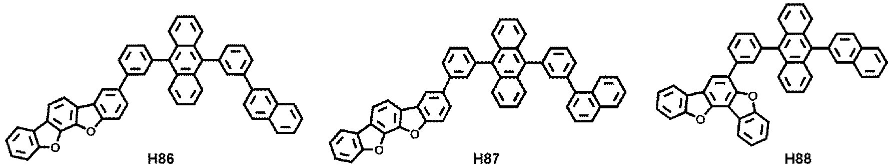

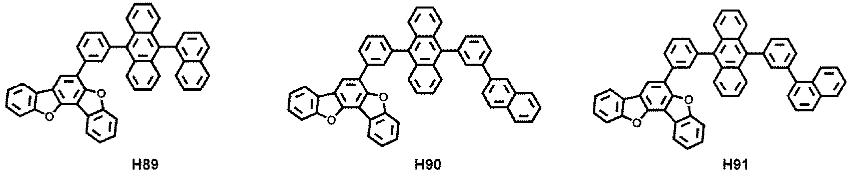

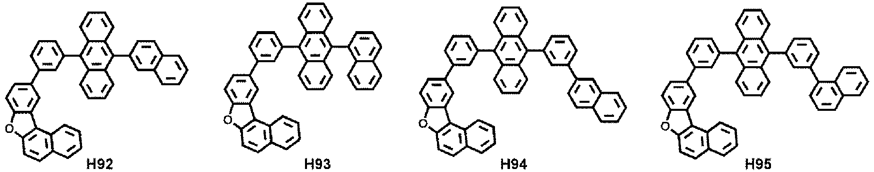

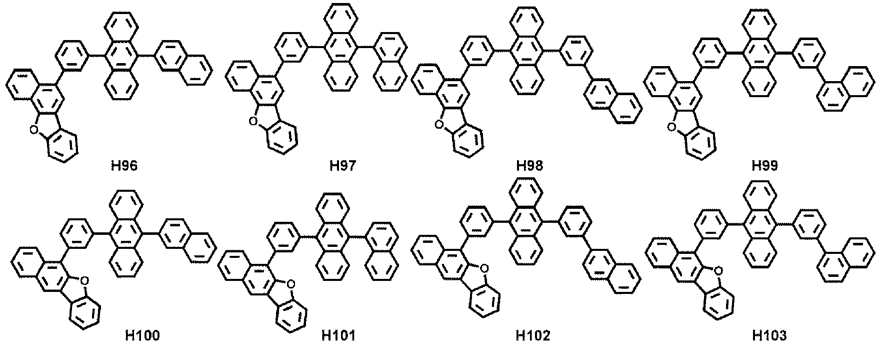

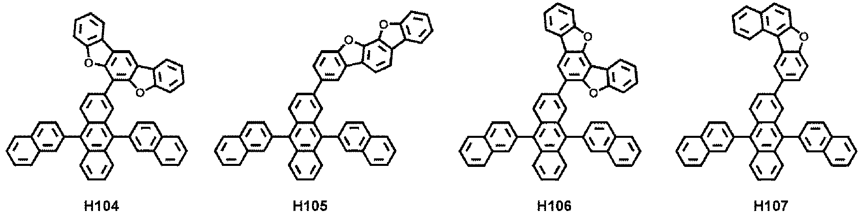

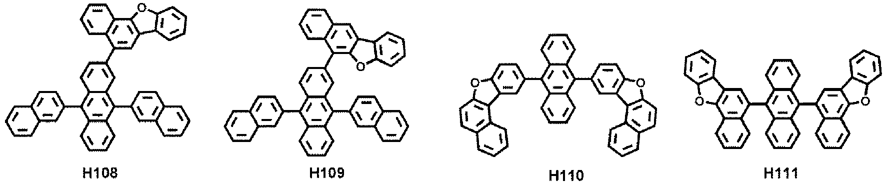

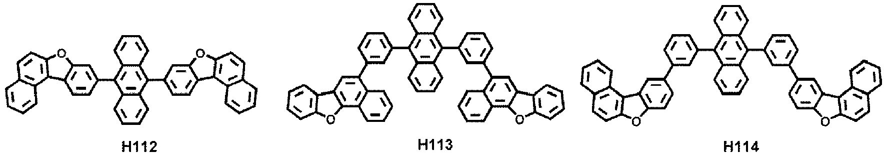

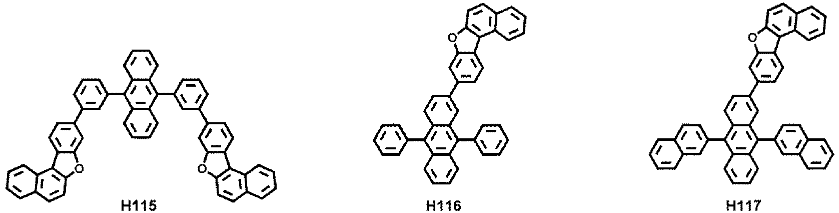

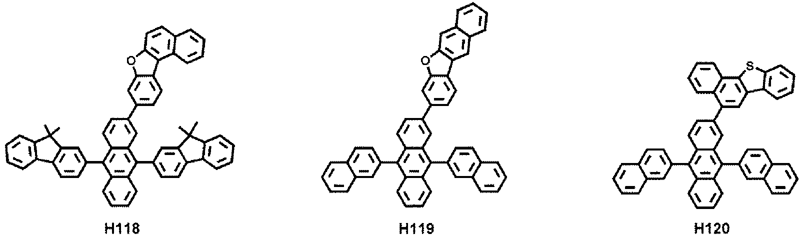

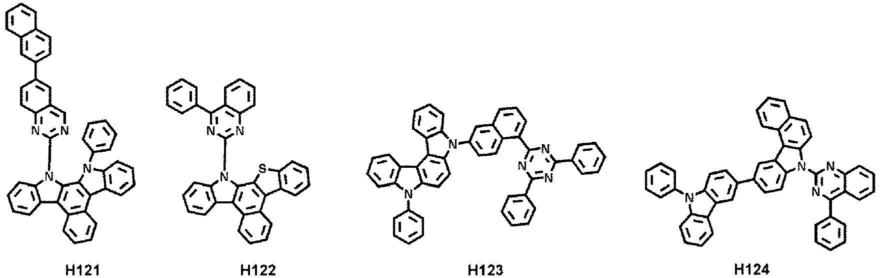

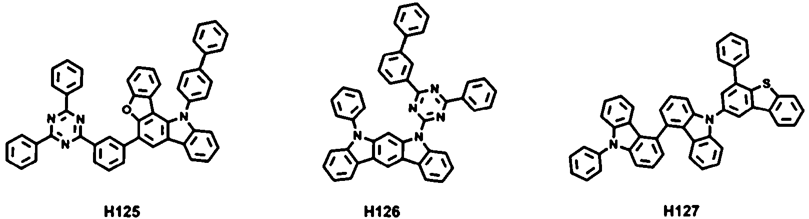

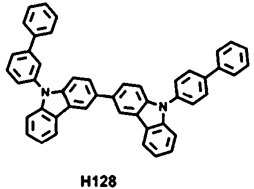

### Phosphorescent dopant

The phosphorescent dopant may include at least one transition metal as a central metal.

The phosphorescent dopant may include a monodentate ligand, a bidentate ligand, a tridentate ligand, a tetradentate ligand, a pentadentate ligand, a hexadentate ligand, or any combination thereof.

The phosphorescent dopant may be electrically neutral.

In one or more embodiments, the phosphorescent dopant may include an organometallic compound represented by Formula 401:

**Formula 401** M(L₄₀₁)_{xc1}(L₄₀₂)_{xc2}

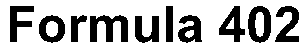

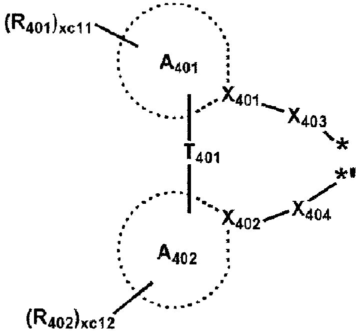

wherein, in Formulae 401 and 402,
M may be a transition metal (e.g., iridium (Ir), platinum (Pt), palladium (Pd), osmium (Os), titanium (Ti), gold (Au), hafnium (Hf), europium (Eu), terbium (Tb), rhodium (Rh), rhenium (Re), or thulium (Tm)),
L₄₀₁ may be a ligand represented by Formula 402, and xc1 may be 1, 2, or 3, wherein, if (e.g., when) xc1 is 2 or more, two or more of L₄₀₁ may be substantially identical to or different from each other,
L₄₀₂ may be an organic ligand, and xc2 may be 0, 1, 2, 3, or 4, wherein, if (e.g., when) xc2 is 2 or more, two or more of L₄₀₂ may be substantially identical to or different from each other,
X₄₀₁ and X₄₀₂ may each independently be nitrogen or carbon,
ring A₄₀₁ and ring A₄₀₂ may each independently be a C₃-C₆₀ carbocyclic group or a C₁-C₆₀ heterocyclic group,
T₄₀₁ may be a single bond, *-O-*', *-S-*', *-C(=O)-*', *-N(Q₄₁₁)-*', *-C(Q₄₁₁)(Q₄₁₂)-*', *-C(Q₄₁₁)=C(Q₄₁₂)-*', *-C(Q₄₁₁)=*', or *=C=*',
X₄₀₃ and X₄₀₄ may each independently be a chemical bond (e.g., a covalent bond or a coordinate bond), O, S, N(Q₄₁₃), B(Q₄₁₃), P(Q₄₁₃), C(Q₄₁₃)(Q₄₁₄), or Si(Q₄₁₃)(Q₄₁₄),
Q₄₁₁ to Q₄₁₄ may each be as described in connection with Q₁,
R₄₀₁ and R₄₀₂ may each independently be hydrogen, deuterium, -F, -Cl, -Br, - I, a hydroxyl group, a cyano group, a nitro group, a C₁-C₂₀ alkyl group unsubstituted or substituted with at least one R₁₀ₐ, a C₁-C₂₀ alkoxy group unsubstituted or substituted with at least one R₁₀ₐ, a C₃-C₆₀ carbocyclic group unsubstituted or substituted with at least one R₁₀ₐ, a C₁-C₆₀ heterocyclic group unsubstituted or substituted with at least one R₁₀ₐ, -Si(Q₄₀₁)(Q₄₀₂)(Q₄₀₃), -N(Q₄₀₁)(Q₄₀₂), -B(Q₄₀₁)(Q₄₀₂), -C(=O)(Q₄₀₁), - S(=O)₂(Q₄₀₁), or -P(=O)(Q₄₀₁)(Q₄₀₂),
Q₄₀₁ to Q₄₀₃ may each be as described in connection with Q₁,
xc11 and xc12 may each independently be an integer from 0 to 10, and
* and *' in Formula 402 each indicate a binding site to M in Formula 401.

In one or more embodiments, in Formula 402, i) X₄₀₁ may be nitrogen, and X₄₀₂ may be carbon, or ii) each of X₄₀₁ and X₄₀₂ may be nitrogen.

In one or more embodiments, if (e.g., when) xc1 in Formula 401 is 2 or more, two rings A₄₀₁ among two or more of L₄₀₁ may optionally be linked to each other via T₄₀₂, which is a linking group, and two rings A₄₀₂ among two or more of L₄₀₁ may optionally be linked to each other via T₄₀₃, which is a linking group (see Compounds PD1 to PD4 and PD7). T₄₀₂ and T₄₀₃ may each be as described in connection with T₄₀₁.

L₄₀₂ in Formula 401 may be an organic ligand. For example, L₄₀₂ may include a halogen group, a diketone group (e.g., an acetylacetonate group), a carboxylic acid group (e.g., a picolinate group), -C(=O), an isonitrile group, a -CN group, a phosphorus group (e.g., a phosphine group, a phosphite group, and/or the like), or any combination thereof.

The phosphorescent dopant may include, for example, one of (e.g., may be any one or include at least one selected from among) Compounds PD1 to PD39, or any combination thereof:

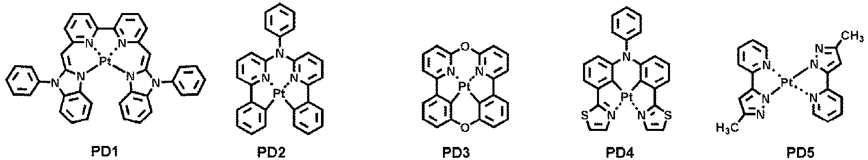

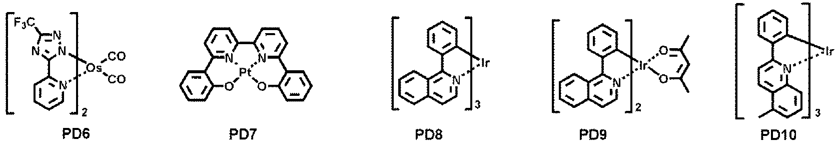

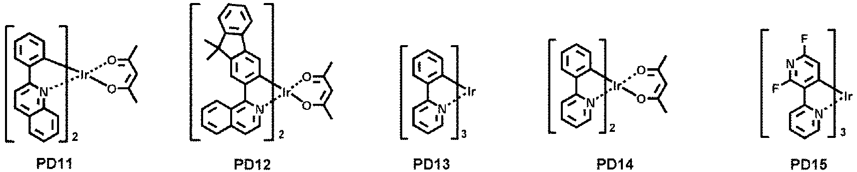

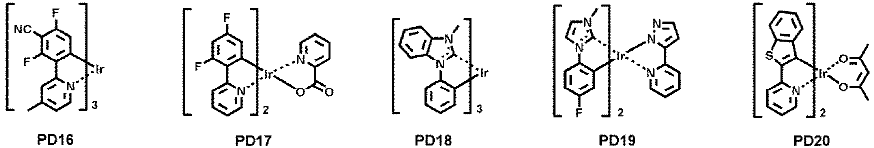

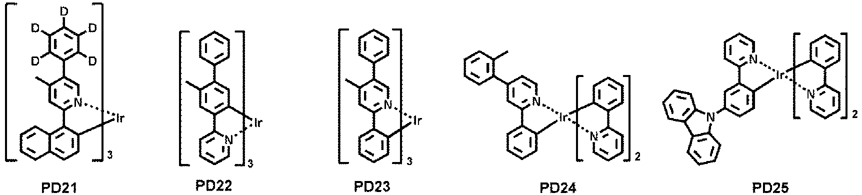

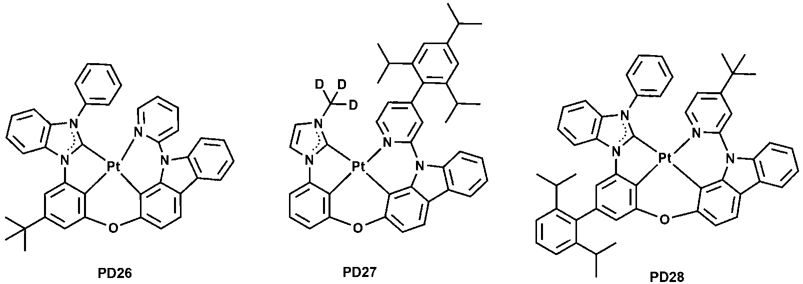

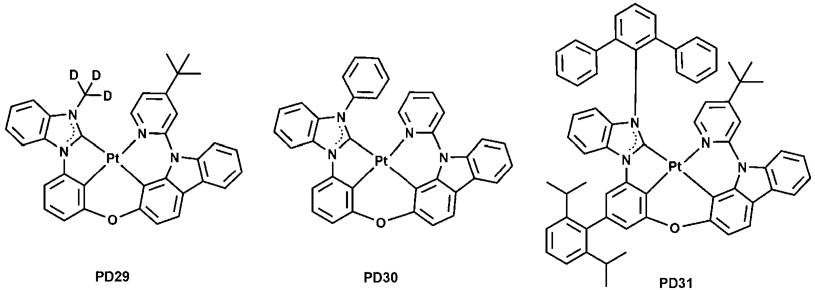

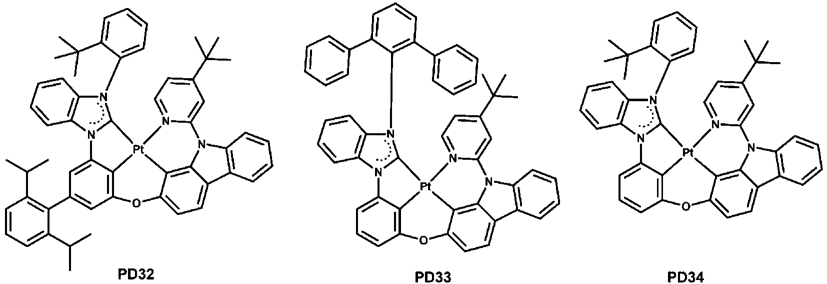

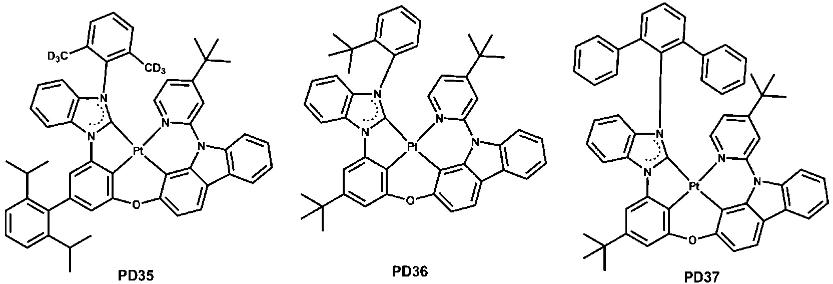

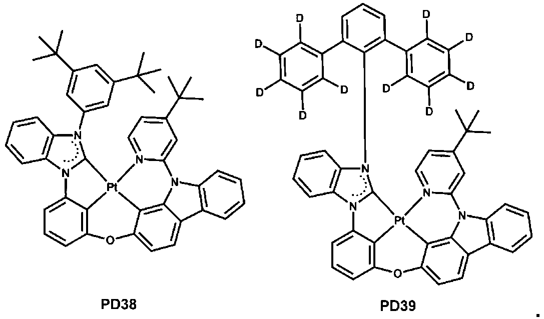

### Fluorescent dopant

The fluorescent dopant may include an amine group-containing compound, a styryl group-containing compound, or any combination thereof.

In one or more embodiments, the fluorescent dopant may include a compound represented by Formula 501: 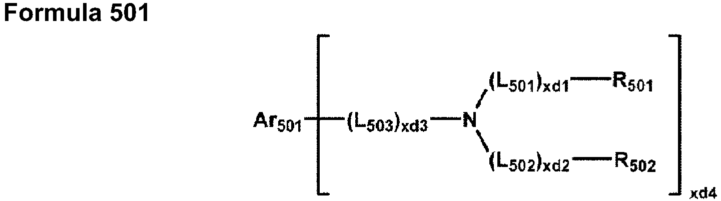
wherein, in Formula 501,
Ar₅₀₁, L₅₀₁ to L₅₀₃, R₅₀₁, and R₅₀₂ may each independently be a C₃-C₆₀ carbocyclic group unsubstituted or substituted with at least one R₁₀ₐ or a C₁-C₆₀ heterocyclic group unsubstituted or substituted with at least one R₁₀ₐ,
xd1 to xd3 may each independently be 0, 1, 2, or 3, and
xd4 may be 1, 2, 3, 4, 5, or 6.

In one or more embodiments, Ar₅₀₁ in Formula 501 may be a condensed cyclic group (e.g., an anthracene group, a chrysene group, a pyrene group, and/or the like) in which three or more monocyclic groups are condensed with each other.

In one or more embodiments, xd4 in Formula 501 may be 2.

In one or more embodiments, the fluorescent dopant may include: one of (e.g., may be any one or include at least one selected from among) Compounds FD1 to FD37; DPVBi; DPAVBi; or any combination thereof:

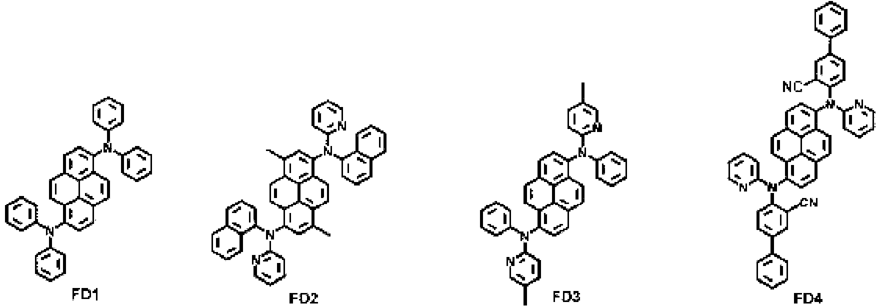

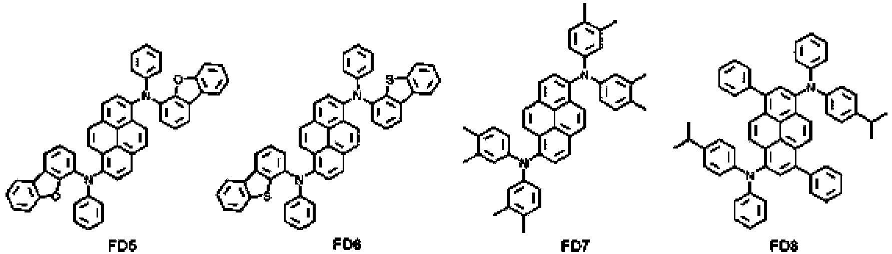

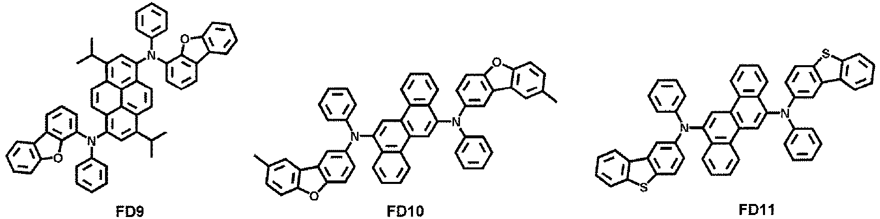

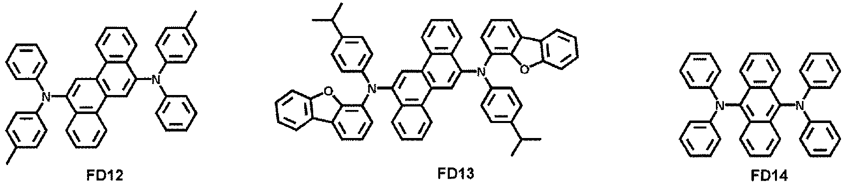

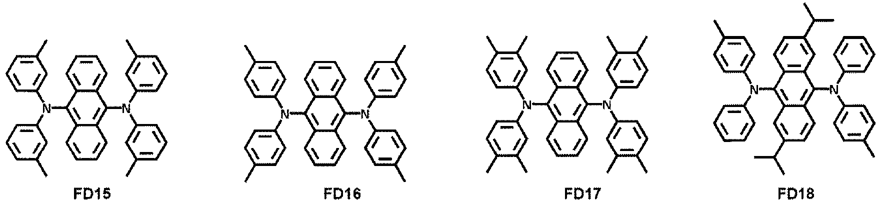

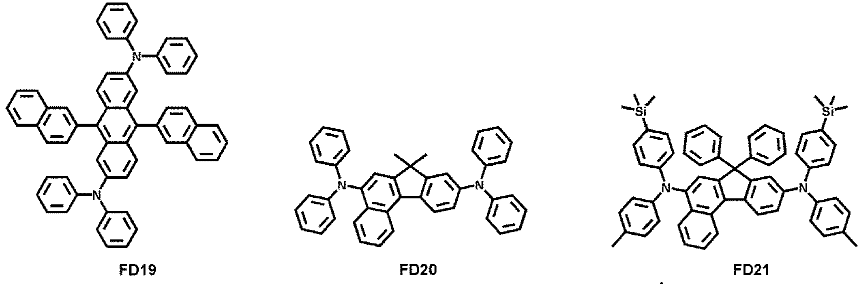

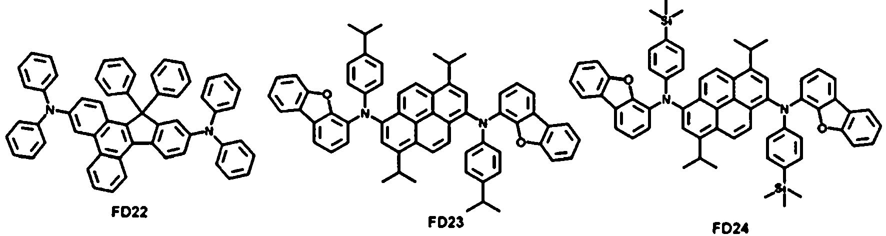

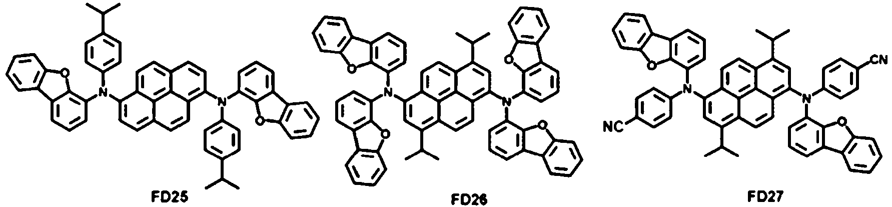

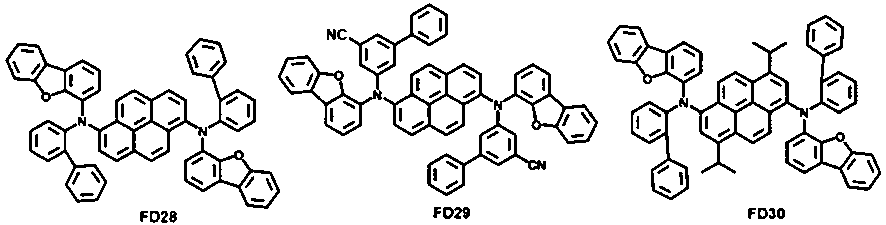

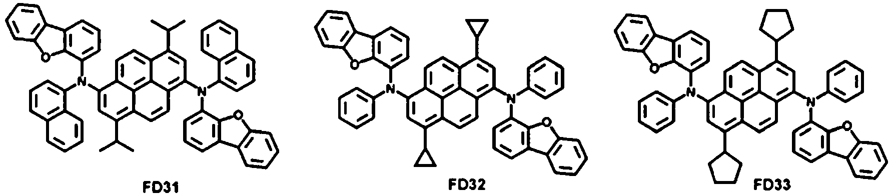

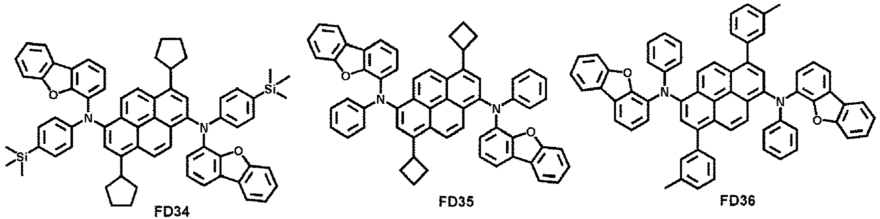

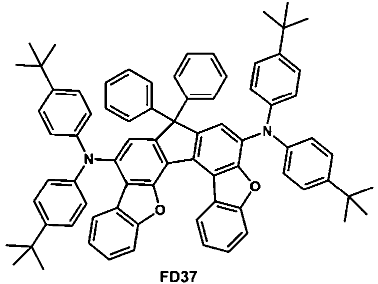

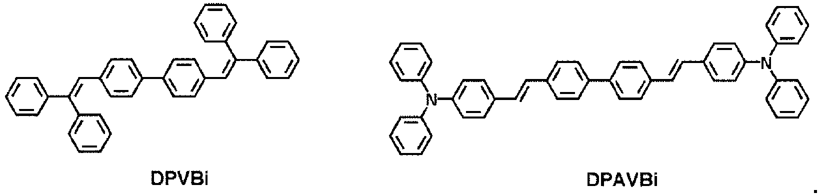

### Delayed fluorescence material

The emission layer may include a delayed fluorescence material.

The delayed fluorescence material described herein may be selected from among compounds capable of emitting delayed fluorescence based on a delayed fluorescence emission mechanism.

The delayed fluorescence material included in the emission layer may act as a host or a dopant depending on the type (kind) of other materials included in the emission layer.

In one or more embodiments, a difference between a triplet energy level (eV) of the delayed fluorescence material and a singlet energy level (eV) of the delayed fluorescence material may be at least 0 eV but not more than 0.5 eV. When the difference between the triplet energy level (eV) of the delayed fluorescence material and the singlet energy level (eV) of the delayed fluorescence material is within the range described herein, up-conversion from the triplet state to the singlet state of the delayed fluorescence material may effectively occur, and thus, the light-emitting device 10 may have improved luminescence efficiency.

In one or more embodiments, the delayed fluorescence material may include i) a material including at least one electron donor (e.g., a π electron-rich C₃-C₆₀ cyclic group such as a carbazole group, and/or the like) and at least one electron acceptor (e.g., a sulfoxide group, a cyano group, a π electron-deficient nitrogen-containing C₁-C₆₀ cyclic group, and/or the like), ii) a material including a C₈-C₆₀ polycyclic group in which two or more cyclic groups are condensed while sharing boron (B), and/or the like.

The delayed fluorescence material may be represented by Formula 701 or 702: 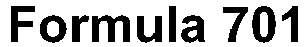 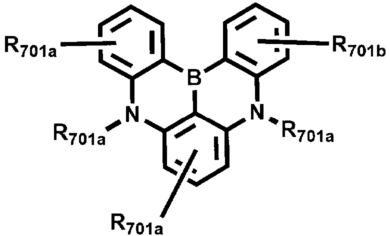 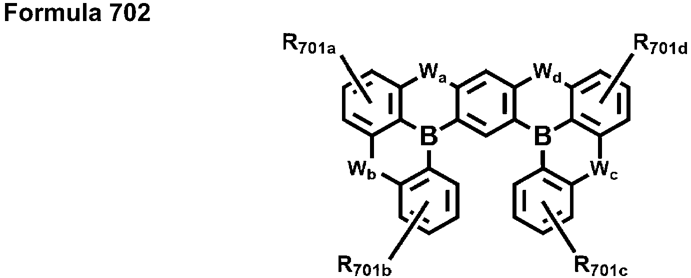
wherein, in Formulae 701 and 702,
Wₐ to W_{d} may each independently be selected from among N(R₇₀₁ₑ), C(R₇₀₁ₑ)(R_{701f}), O, and S,
R₇₀₁ₐ to R_{701f} may each independently be hydrogen, deuterium, -F, -Cl, -Br, - I, a hydroxyl group, a cyano group, a nitro group, a C₁-C₆₀ alkyl group unsubstituted or substituted with at least one R₁₀ₐ, a C₂-C₆₀ alkenyl group unsubstituted or substituted with at least one R₁₀ₐ, a C₂-C₆₀ alkynyl group unsubstituted or substituted with at least one R₁₀ₐ, a C₁-C₆₀ alkoxy group unsubstituted or substituted with at least one R₁₀ₐ, a C₃-C₆₀ carbocyclic group unsubstituted or substituted with at least one R₁₀ₐ, a C₁-C₆₀ heterocyclic group unsubstituted or substituted with at least one R₁₀ₐ, -C(Q₁)(Q₂)(Q₃), - Si(Q₁)(Q₂)(Q₃), -N(Q₁)(Q₂), -B(Q₁)(Q₂), -C(=O)(Q₁), -S(=O)₂(Q₁), or -P(=O)(Q₁)(Q₂),
R₁₀ₐ may be:
deuterium, -F, -Cl, -Br, -I, a hydroxyl group, a cyano group, or a nitro group;
a C₁-C₆₀ alkyl group, a C₂-C₆₀ alkenyl group, a C₂-C₆₀ alkynyl group, or a C₁-C₆₀ alkoxy group, each unsubstituted or substituted with deuterium, -F, -Cl, -Br, -I, a hydroxyl group, a cyano group, a nitro group, a C₃-C₆₀ carbocyclic group, a C₁-C₆₀ heterocyclic group, a C₆-C₆₀ aryloxy group, a C₆-C₆₀ arylthio group, a C₇-C₆₀ arylalkyl group, a C₂-C₆₀ heteroarylalkyl group, -Si(Q₁₁)(Q₁₂)(Q₁₃), -N(Q₁₁)(Q₁₂), -B(Q₁₁)(Q₁₂), - C(=O)(Q₁₁), -S(=O)₂(Q₁₁), -P(=O)(Q₁₁)(Q₁₂), or any combination thereof;
a C₃-C₆₀ carbocyclic group, a C₁-C₆₀ heterocyclic group, a C₆-C₆₀ aryloxy group, a C₆-C₆₀ arylthio group, a C₇-C₆₀ arylalkyl group, or a C₂-C₆₀ heteroarylalkyl group, each unsubstituted or substituted with deuterium, -F, -Cl, -Br, -I, a hydroxyl group, a cyano group, a nitro group, a C₁-C₆₀ alkyl group, a C₂-C₆₀ alkenyl group, a C₂-C₆₀ alkynyl group, a C₁-C₆₀ alkoxy group, a C₃-C₆₀ carbocyclic group, a C₁-C₆₀ heterocyclic group, a C₆-C₆₀ aryloxy group, a C₆-C₆₀ arylthio group, a C₇-C₆₀ arylalkyl group, a C₂-C₆₀ heteroarylalkyl group, -Si(Q₂₁)(Q₂₂)(Q₂₃), -N(Q₂₁)(Q₂₂), -B(Q₂₁)(Q₂₂), - C(=O)(Q₂₁), -S(=O)₂(Q₂₁), -P(=O)(Q₂₁)(Q₂₂), or any combination thereof; or
-Si(Q₃₁)(Q₃₂)(Q₃₃), -N(Q₃₁)(Q₃₂), -B(Q₃₁)(Q₃₂), -C(=O)(Q₃₁), -S(=O)₂(Q₃₁), or - P(=O)(Q₃₁)(Q₃₂), and
Q₁ to Q₃, Q₁₁ to Q₁₃, Q₂₁ to Q₂₃, and Q₃₁ to Q₃₃ may each independently be: hydrogen; deuterium; -F; -Cl; -Br; -I; a hydroxyl group; a cyano group; a nitro group; or a C₁-C₆₀ alkyl group, a C₂-C₆₀ alkenyl group, a C₂-C₆₀ alkynyl group, a C₁-C₆₀ alkoxy group, a C₃-C₆₀ carbocyclic group, or a C₁-C₆₀ heterocyclic group, each unsubstituted or substituted with deuterium, -F, a cyano group, a C₁-C₆₀ alkyl group, a C₁-C₆₀ alkoxy group, a phenyl group, a biphenyl group, or any combination thereof.

Examples of the delayed fluorescence material may include at least one of (e.g., selected from among) Compounds DF1 to DF14 or Compounds DFD1 to DFD29:

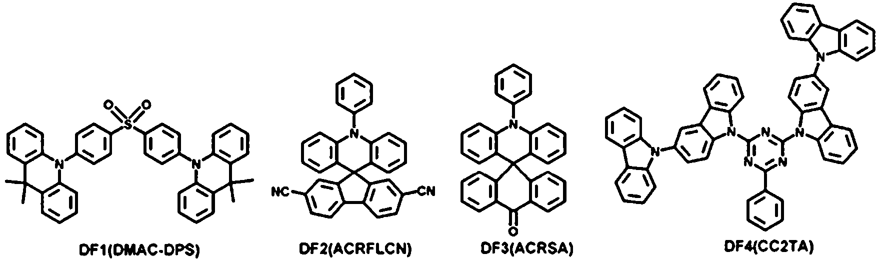

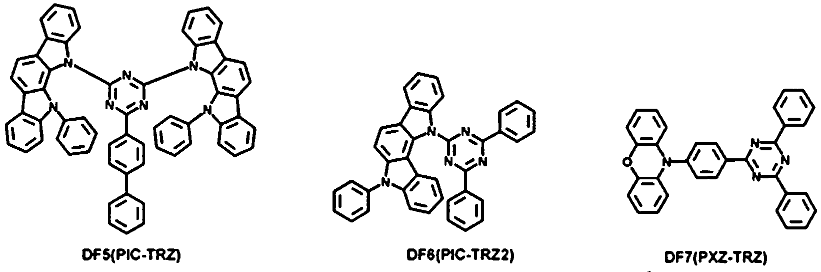

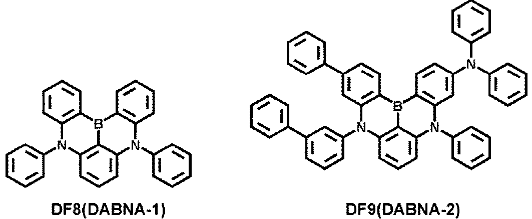

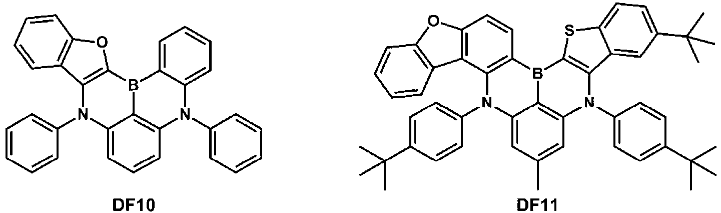

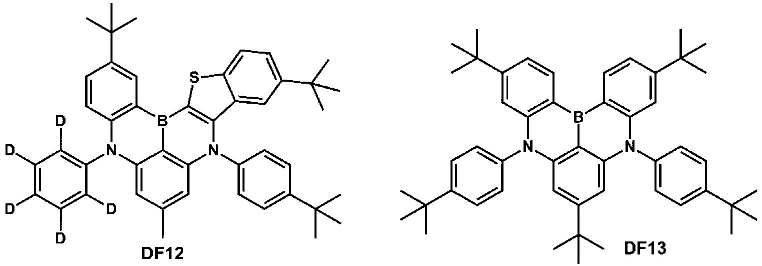

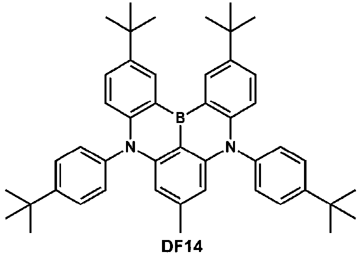

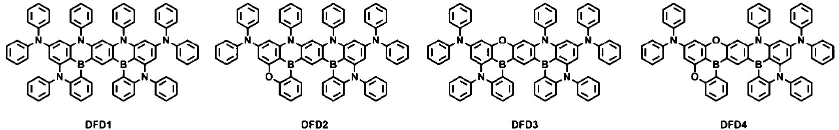

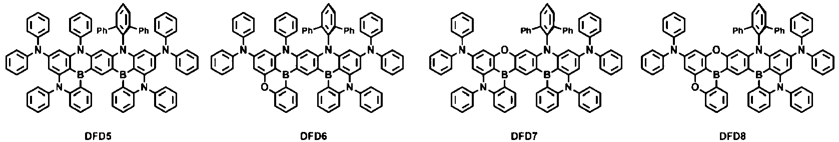

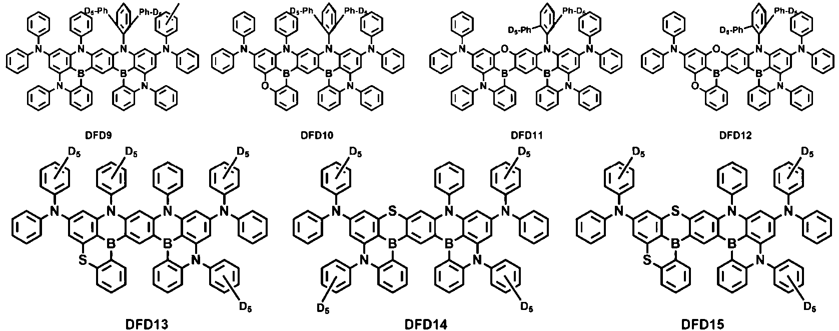

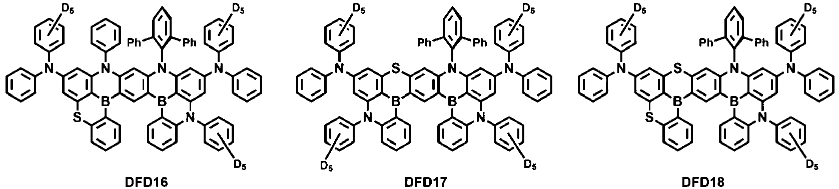

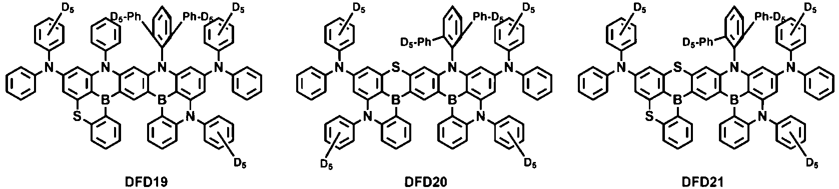

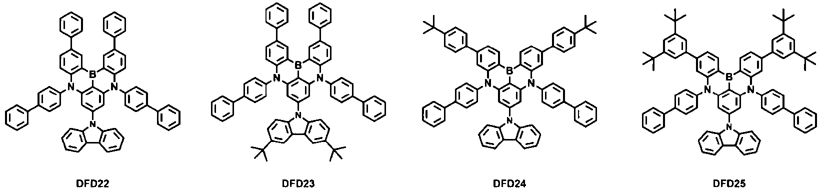

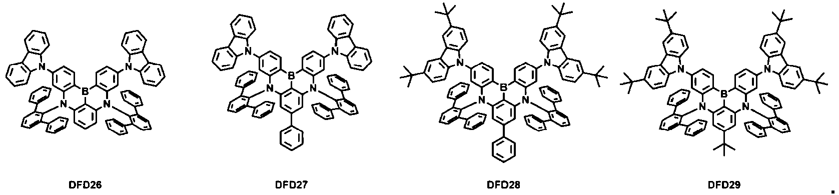

### Quantum dot

The emission layer may include a quantum dot.

The term "quantum dot" as used herein refers to a crystal of a semiconductor compound, and may include any material capable of emitting light of one or more suitable emission wavelengths according to the size of the crystal.

The diameter of the quantum dot may be, for example, in a range of about 1 nanometer (nm) to about 10 nm. A diameter of the quantum dots may be, for example, in a range of about 1 nanometer (nm) to about 10 nm. In the present disclosure, when quantum dot, quantum dots, or quantum dot particles are spherical, "diameter" indicates a particle diameter or an average particle diameter, and when the particles are non-spherical, the "diameter" indicates a major axis length or an average major axis length. The diameter of the particles may be measured utilizing a scanning electron microscope or a particle size analyzer. As the particle size analyzer, for example, HORIBA, LA-950 laser particle size analyzer, may be utilized. When the size of the particles is measured utilizing a particle size analyzer, the average particle diameter is referred to as D50. D50 refers to the average diameter of particles whose cumulative volume corresponds to 50 vol% in the particle size distribution (e.g., cumulative distribution), and refers to the value of the particle size corresponding to 50% from the smallest particle when the total number of particles is 100% in the distribution curve accumulated in the order of the smallest particle size to the largest particle size.

The quantum dot may be synthesized by a wet chemical process, a metal organic chemical vapor deposition process, a molecular beam epitaxy process, or any process similar thereto.

The wet chemical process is a method including mixing a precursor material with an organic solvent and then growing a quantum dot particle crystal. When the crystal grows, the organic solvent naturally acts as a dispersant coordinated on the surface of the quantum dot crystal and controls the growth of the crystal so that the growth of quantum dot particles can be controlled or selected through a process which costs lower, and is easier than vapor deposition methods, such as metal organic chemical vapor deposition (MOCVD) or molecular beam epitaxy (MBE).

The quantum dot may include: a Group II-VI semiconductor compound; a Group III-V semiconductor compound; a Group III-VI semiconductor compound; a Group I-III-VI semiconductor compound; a Group IV-VI semiconductor compound; a Group IV element or compound; or any combination thereof.

Examples of the Group II-VI semiconductor compound may include: a binary compound, such as CdS, CdSe, CdTe, ZnS, ZnSe, ZnTe, ZnO, HgS, HgSe, HgTe, MgSe, or MgS; a ternary compound, such as CdSeS, CdSeTe, CdSTe, ZnSeS, ZnSeTe, ZnSTe, HgSeS, HgSeTe, HgSTe, CdZnS, CdZnSe, CdZnTe, CdHgS, CdHgSe, CdHgTe, HgZnS, HgZnSe, HgZnTe, MgZnSe, or MgZnS; a quaternary compound, such as CdZnSeS, CdZnSeTe, CdZnSTe, CdHgSeS, CdHgSeTe, CdHgSTe, HgZnSeS, HgZnSeTe, or HgZnSTe; or any combination thereof.

Examples of the Group III-V semiconductor compound may include: a binary compound, such as GaN, GaP, GaAs, GaSb, AIN, AlP, AlAs, AlSb, InN, InP, InAs, or InSb; a ternary compound, such as GaNP, GaNAs, GaNSb, GaPAs, GaPSb, AINP, AlNAs, AlNSb, AlPAs, AlPSb, InGaP, InNP, InAlP, InNAs, InNSb, InPAs, or InPSb; a quaternary compound, such as GaAlNP, GaAINAs, GaAINSb, GaAlPAs, GaAlPSb, GalnNP, GalnNAs, GalnNSb, GalnPAs, GalnPSb, InAlNP, InAINAs, InAlNSb, InAlPAs, or InAIPSb; or any combination thereof. In one or more embodiments, the Group III-V semiconductor compound may further include a Group II element. Examples of the Group III-V semiconductor compound further including the Group II element may include InZnP, InGaZnP, InAlZnP, and/or the like.

Examples of the Group III-VI semiconductor compound may include: a binary compound, such as GaS, GaSe, Ga₂Se₃, GaTe, InS, InSe, In₂S₃, In₂Se₃, or InTe; a ternary compound, such as InGaS₃ or InGaSe₃; or any combination thereof.

Examples of the Group I-III-VI semiconductor compound may include: a ternary compound, such as AgInS, AgInS₂, CulnS, CuInS₂, CuGaO₂, AgGaO₂, or AgAlO₂; or any combination thereof.

Examples of the Group IV-VI semiconductor compound may include: a binary compound, such as SnS, SnSe, SnTe, PbS, PbSe, or PbTe; a ternary compound, such as SnSeS, SnSeTe, SnSTe, PbSeS, PbSeTe, PbSTe, SnPbS, SnPbSe, or SnPbTe; a quaternary compound, such as SnPbSSe, SnPbSeTe, or SnPbSTe; or any combination thereof.

The Group IV element or compound may include: a single element compound, such as Si or Ge; a binary compound, such as SiC or SiGe; or any combination thereof.

Each element included in a multi-element compound, such as the binary compound, the ternary compound, and the quaternary compound, may be present at a substantially uniform concentration or non-substantially uniform concentration in a particle.

In one or more embodiments, the quantum dot may have a single structure in which the concentration of each element in the quantum dot is substantially uniform, or a core-shell dual structure. For example, a material included in the core and a material included in the shell may be different from each other.

The shell of the quantum dot may act as a protective layer that prevents chemical degeneration of the core to maintain semiconductor characteristics, and/or as a charging layer that imparts electrophoretic characteristics to the quantum dot. The shell may be a single layer or a multi-layer. The interface between the core and the shell may have a concentration gradient in which the concentration of an element existing in the shell decreases toward the center of the core.

Examples of the shell of the quantum dot may include: an oxide of metal, metalloid, or non-metal; a semiconductor compound; or any combination thereof. Examples of the oxide of metal, metalloid, or non-metal may include: a binary compound, such as SiO₂, Al₂O₃, TiO₂, ZnO, MnO, Mn₂O₃, Mn₃O₄, CuO, FeO, Fe₂O₃, Fe₃O₄, CoO, Co₃O₄, or NiO; a ternary compound, such as MgAl₂O₄, CoFe₂O₄, NiFe₂O₄, or CoMn₂O₄; or any combination thereof. Examples of the semiconductor compound may include: as described herein, a Group II-VI semiconductor compound; a Group III-V semiconductor compound; a Group III-VI semiconductor compound; a Group I-III-VI semiconductor compound; a Group IV-VI semiconductor compound; or any combination thereof. For example, the semiconductor compound may include CdS, CdSe, CdTe, ZnS, ZnSe, ZnTe, ZnSeS, ZnTeS, GaAs, GaP, GaSb, HgS, HgSe, HgTe, InAs, InP, InGaP, InSb, AlAs, AlP, AlSb, or any combination thereof.

The quantum dot may have a full width at half maximum (FWHM) of an emission wavelength spectrum of about 45 nm or less, about 40 nm or less, or for example, about 30 nm or less. When the FWHM of the quantum dot is within these ranges, the quantum dot may have improved color purity or improved color reproducibility. In some embodiments, because light emitted through the quantum dot is emitted in all directions, the wide viewing angle may be improved.

In some embodiments, the quantum dot may be in the form of a spherical particle, a pyramidal particle, a multi-arm particle, a cubic nanoparticle, a nanotube particle, a nanowire particle, a nanofiber particle, or a nanoplate particle.

Because an energy band gap may be adjusted by controlling the size of the quantum dot, light having one or more suitable wavelength bands may be obtained from the quantum dot emission layer. Accordingly, by using quantum dots of different sizes, a light-emitting device that emits light of one or more suitable wavelengths may be implemented. In more detail, the size of the quantum dot may be selected to emit red light, green light, and/or blue light. In some embodiments, the size of the quantum dot may be configured to emit white light by combination of light of one or more suitable colors.

### Electron transport region in interlayer 130

The electron transport region may have i) a single-layer structure including (e.g., consisting of) a single layer including (e.g., consisting of) a single material, ii) a single-layer structure including (e.g., consisting of) a single layer including multiple different materials, or iii) a multi-layer structure including multiple layers including multiple different materials.

The electron transport region may include a buffer layer, a hole-blocking layer, an electron control layer, an electron transport layer, an electron injection layer, or any combination thereof.

In one or more embodiments, the electron transport region may have an electron transport layer/electron injection layer structure, a hole-blocking layer/electron transport layer/electron injection layer structure, an electron control layer/electron transport layer/electron injection layer structure, or a buffer layer/electron transport layer/electron injection layer structure, wherein constituent layers of each structure are sequentially stacked from the emission layer.

The electron transport region (e.g., the buffer layer, the hole-blocking layer, the electron control layer, or the electron transport layer in the electron transport region) may include a metal-free compound including at least one π electron-deficient nitrogen-containing C₁-C₆₀ cyclic group.

In one or more embodiments, the electron transport region may include a compound represented by Formula 601:

**Formula 601** [Ar₆₀₁]ₓₑ₁₁-[(L₆₀₁)ₓₑ₁-R₆₀₁]ₓₑ₂₁

wherein, in Formula 601,
Ar₆₀₁ and L₆₀₁ may each independently be a C₃-C₆₀ carbocyclic group unsubstituted or substituted with at least one R₁₀ₐ or a C₁-C₆₀ heterocyclic group unsubstituted or substituted with at least one R₁₀ₐ,
xe11 may be 1, 2, or 3,
xe1 may be 0, 1, 2, 3, 4, or 5,
R₆₀₁ may be a C₃-C₆₀ carbocyclic group unsubstituted or substituted with at least one R₁₀ₐ, a C₁-C₆₀ heterocyclic group unsubstituted or substituted with at least one R₁₀ₐ, -Si(Q₆₀₁)(Q₆₀₂)(Q₆₀₃), -C(=O)(Q₆₀₁), -S(=O)₂(Q₆₀₁), or -P(=O)(Q₆₀₁)(Q₆₀₂),
Q₆₀₁ to Q₆₀₃ may each be as described in connection with Q₁,
xe21 may be 1, 2, 3, 4, or 5, and
at least one of Ar₆₀₁, L₆₀₁, and R₆₀₁ may each independently be a π electron-deficient nitrogen-containing C₁-C₆₀ cyclic group unsubstituted or substituted with at least one R₁₀ₐ.

In one or more embodiments, if (e.g., when) xe11 in Formula 601 is 2 or more, two or more of Ar₆₀₁ may be linked to each other via a single bond.

In one or more embodiments, Ar₆₀₁ in Formula 601 may be a substituted or unsubstituted anthracene group.

In one or more embodiments, the electron transport region may include a compound represented by Formula 601-1: 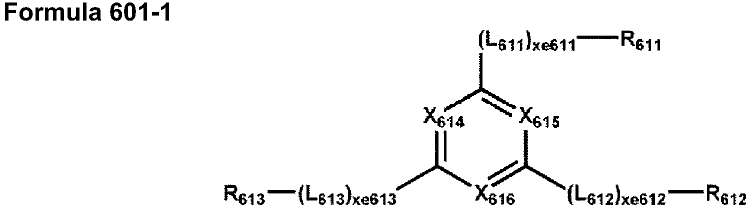
wherein, in Formula 601-1,
X₆₁₄ may be N or C(R₆₁₄), X₆₁₅ may be N or C(R₆₁₅), X₆₁₆ may be N or C(R₆₁₆), and at least one of X₆₁₄ to X₆₁₆ may be N,
L₆₁₁ to L₆₁₃ may each be as described in connection with L₆₀₁,
xe611 to xe613 may each be as described in connection with xe1,
R₆₁₁ to R₆₁₃ may each be as described in connection with R₆₀₁, and
R₆₁₄ to R₆₁₆ may each independently be hydrogen, deuterium, -F, -Cl, -Br, -I, a hydroxyl group, a cyano group, a nitro group, a C₁-C₂₀ alkyl group, a C₁-C₂₀ alkoxy group, a C₃-C₆₀ carbocyclic group unsubstituted or substituted with at least one R₁₀ₐ, or a C₁-C₆₀ heterocyclic group unsubstituted or substituted with at least one R₁₀ₐ.

In one or more embodiments, xe1 and xe611 to xe613 in Formulae 601 and 601-1 may each independently be 0, 1, or 2.

In one or more embodiments, the electron transport region may include: one of (e.g., at least one selected from among) Compounds ET1 to ET45; 2,9-dimethyl-4,7-diphenyl-1,10-phenanthroline (BCP); 4,7-diphenyl-1,10-phenanthroline (Bphen); Alq₃; BAlq; TAZ; NTAZ; or any combination thereof:

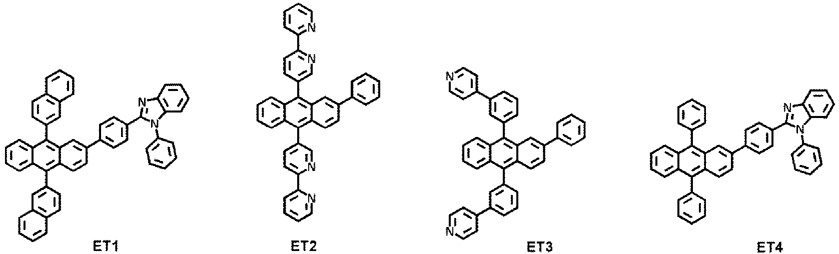

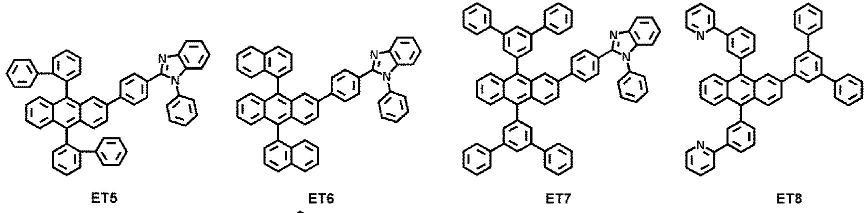

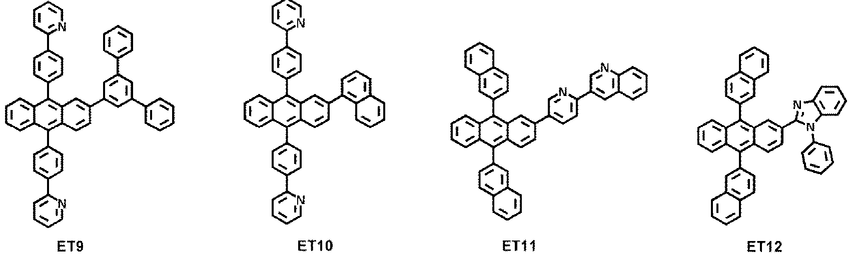

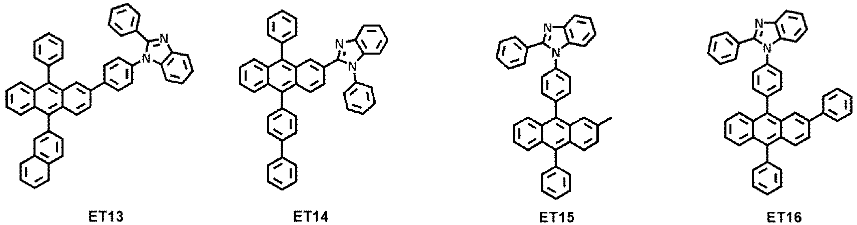

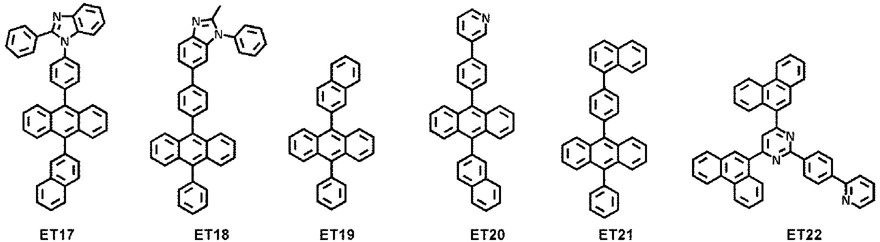

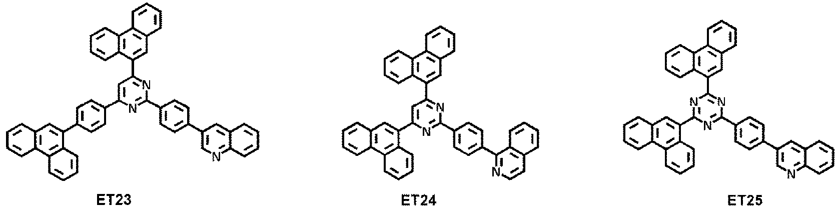

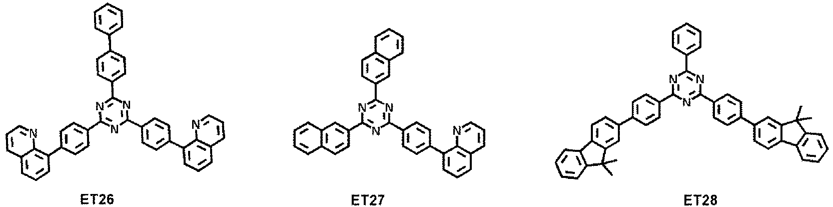

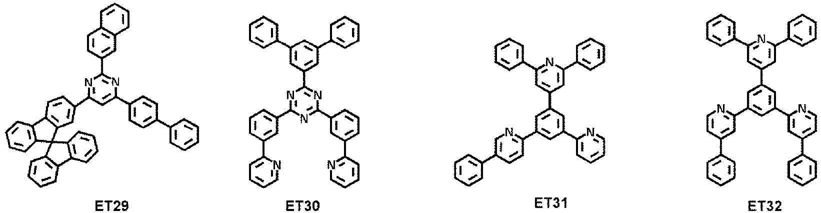

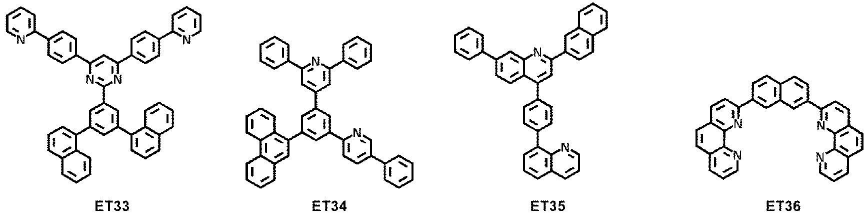

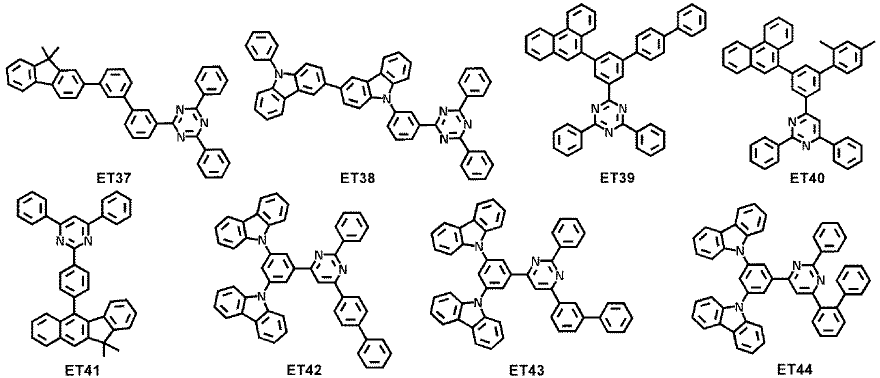

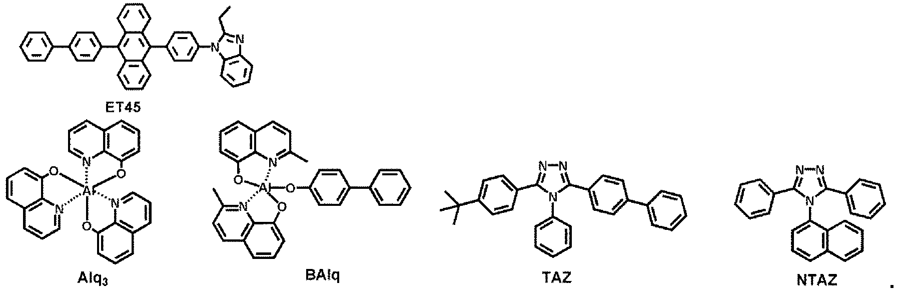

The thickness of the electron transport region may be in a range of about 100 Å to about 5,000 Å, for example, about 160 Å to about 4,000 Å. When the electron transport region includes a buffer layer, a hole-blocking layer, an electron control layer, an electron transport layer, or any combination thereof, the thickness of the buffer layer, the hole-blocking layer, or the electron control layer may each independently be in a range of about 20 Å to about 1,000 Å, for example, about 30 Å to about 300 Å, and the thickness of the electron transport layer may be in a range of about 100 Å to about 1,000 Å, for example, about 150 Å to about 500 Å. When the thicknesses of the buffer layer, the hole-blocking layer, the electron control layer, the electron transport layer, and/or the electron transport region are within the ranges described herein, satisfactory electron-transporting characteristics may be obtained without a substantial increase in driving voltage.

The electron transport region (e.g., the electron transport layer in the electron transport region) may further include, in addition to the materials described herein, a metal-containing material.

The metal-containing material may include an alkali metal complex, an alkaline earth metal complex, or any combination thereof. A metal ion of the alkali metal complex may be a Li ion, a Na ion, a K ion, a Rb ion, or a Cs ion, and a metal ion of the alkaline earth metal complex may be a Be ion, a Mg ion, a Ca ion, a Sr ion, or a Ba ion. A ligand coordinated with the metal ion of the alkali metal complex or the alkaline earth-metal complex may include hydroxyquinoline, hydroxyisoquinoline, hydroxybenzoquinoline, hydroxyacridine, hydroxyphenanthridine, hydroxyphenyloxazole, hydroxyphenylthiazole, hydroxyphenyloxadiazole, hydroxyphenylthiadiazole, hydroxyphenylpyridine, hydroxyphenylbenzimidazole, hydroxyphenylbenzothiazole, bipyridine, phenanthroline, cyclopentadiene, or any combination thereof.

In one or more embodiments, the metal-containing material may include a Li complex. The Li complex may include, for example, Compound ET-D1 (LiQ) or ET-D2:

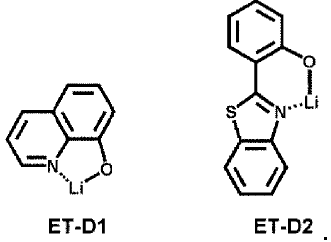

The electron transport region may include an electron injection layer that facilitates the injection of electrons from the second electrode 150. The electron injection layer may directly contact the second electrode 150.

The electron injection layer may have i) a single-layer structure including (e.g., consisting of) a single layer including (e.g., consisting of) a single material, ii) a single-layer structure including (e.g., consisting of) a single layer including multiple different materials, or iii) a multi-layer structure including multiple layers including multiple different materials.

The electron injection layer may include an alkali metal, an alkaline earth metal, a rare earth metal, an alkali metal-containing compound, an alkaline earth metal-containing compound, a rare earth metal-containing compound, an alkali metal complex, an alkaline earth metal complex, a rare earth metal complex, or any combination thereof.

The alkali metal may include Li, Na, K, Rb, Cs, or any combination thereof. The alkaline earth metal may include Mg, Ca, Sr, Ba, or any combination thereof. The rare earth metal may include Sc, Y, Ce, Tb, Yb, Gd, or any combination thereof.

The alkali metal-containing compound, the alkaline earth metal-containing compound, and the rare earth metal-containing compound may include oxides, halides (e.g., fluorides, chlorides, bromides, iodides, and/or the like), or tellurides of the alkali metal, the alkaline earth metal, and the rare earth metal, or any combination thereof.

The alkali metal-containing compound may include: an alkali metal oxide, such as Li₂O, Cs₂O, or K₂O; an alkali metal halide, such as LiF, NaF, CsF, KF, Lil, Nal, Csl, or Kl; or any combination thereof. The alkaline earth metal-containing compound may include an alkaline earth metal compound, such as BaO, SrO, CaO, BaₓSr₁₋ₓO (wherein x is a real number satisfying 0<x<1), or BaₓCa₁₋ₓO (wherein x is a real number satisfying 0<x<1). The rare earth metal-containing compound may include YbF₃, ScF₃, Sc₂O₃, Y₂O₃, Ce₂O₃, GdF₃, TbF₃, YbI₃, ScI₃, TbI₃, or any combination thereof. In one or more embodiments, the rare earth metal-containing compound may include a lanthanide metal telluride. Examples of the lanthanide metal telluride may include LaTe, CeTe, PrTe, NdTe, PmTe, SmTe, EuTe, GdTe, TbTe, DyTe, HoTe, ErTe, TmTe, YbTe, LuTe, La₂Te₃, Ce₂Te₃, Pr₂Te₃, Nd₂Te₃, Pm₂Te₃, Sm₂Te₃, Eu₂Te₃, Gd₂Te₃, Tb₂Te₃, Dy₂Te₃, Ho₂Te₃, Er₂Te₃, Tm₂Te₃, Yb₂Te₃, Lu₂Te₃, and/or the like.

The alkali metal complex, the alkaline earth-metal complex, and the rare earth metal complex may include i) at least one of (e.g., selected from among) ions of the alkali metal, the alkaline earth metal, and the rare earth metal and ii) a ligand bonded to the metal ion, for example, hydroxyquinoline, hydroxyisoquinoline, hydroxybenzoquinoline, hydroxyacridine, hydroxyphenanthridine, hydroxyphenyloxazole, hydroxyphenylthiazole, hydroxyphenyloxadiazole, hydroxyphenylthiadiazole, hydroxyphenylpyridine, hydroxyphenyl benzimidazole, hydroxyphenylbenzothiazole, bipyridine, phenanthroline, cyclopentadiene, or any combination thereof.

The electron injection layer may include (e.g., consist of) an alkali metal, an alkaline earth metal, a rare earth metal, an alkali metal-containing compound, an alkaline earth metal-containing compound, a rare earth metal-containing compound, an alkali metal complex, an alkaline earth metal complex, a rare earth metal complex, or any combination thereof, as described herein. In one or more embodiments, the electron injection layer may further include an organic material (e.g., a compound represented by Formula 601).

In one or more embodiments, the electron injection layer may include (e.g., consist of):
i) an alkali metal-containing compound (e.g., an alkali metal halide), or
ii) a) an alkali metal-containing compound (e.g., an alkali metal halide), and b) an alkali metal, an alkaline earth metal, a rare earth metal, or any combination thereof.

In one or more embodiments, the electron injection layer may be a KI:Yb co-deposited layer, an Rbl:Yb co-deposited layer, a LiF:Yb co-deposited layer, and/or the like.

When the electron injection layer further includes an organic material, the alkali metal, the alkaline earth metal, the rare earth metal, the alkali metal-containing compound, the alkaline earth metal-containing compound, the rare earth metal-containing compound, the alkali metal complex, the alkaline earth-metal complex, the rare earth metal complex, or any combination thereof may be uniformly (e.g., substantially uniformly) or non-uniformly (e.g., substantially non-uniformly) dispersed in a matrix including the organic material.

The thickness of the electron injection layer may be in a range of about 1 Å to about 100 Å, for example, about 3 Å to about 90 Å. When the thickness of the electron injection layer is within the range described herein, satisfactory electron injection characteristics may be obtained without a substantial increase in driving voltage.

### Second electrode 150

The second electrode 150 is arranged on the interlayer 130. The second electrode 150 may be a cathode, which is an electron injection electrode, and as a material for forming the second electrode 150, a metal, an alloy, an electrically conductive compound, or any combination thereof, each having a low-work function, may be used.

The second electrode 150 may include lithium (Li), silver (Ag), silver-lithium (Ag-Li), silver-sodium (AgNa), magnesium (Mg), aluminium (Al), aluminium-lithium (Al-Li), calcium (Ca), magnesium-indium (Mg-In), magnesium-silver (Mg-Ag), ytterbium (Yb), silver-ytterbium (Ag-Yb), ITO, IZO, or any combination thereof. The second electrode 150 may be a transmissive electrode, a transflective electrode, or a reflective electrode.

The second electrode 150 may have a single-layer structure or a multi-layer structure including multiple layers.

### Capping layer

A first capping layer may be arranged outside (and, e.g., on) the first electrode 110, and/or a second capping layer may be arranged outside (and, e.g., on) the second electrode 150. In more detail, the light-emitting device 10 may have a structure in which the first capping layer, the first electrode 110, the interlayer 130, and the second electrode 150 are sequentially stacked in the stated order, a structure in which the first electrode 110, the interlayer 130, the second electrode 150, and the second capping layer are sequentially stacked in the stated order, or a structure in which the first capping layer, the first electrode 110, the interlayer 130, the second electrode 150, and the second capping layer are sequentially stacked in the stated order.

Light generated in the emission layer of the interlayer 130 of the light-emitting device 10 may be extracted toward the outside through the first electrode 110 which is a transflective electrode or a transmissive electrode, and the first capping layer. Light generated in the emission layer of the interlayer 130 of the light-emitting device 10 may be extracted toward the outside through the second electrode 150 which is a transflective electrode or a transmissive electrode, and the second capping layer.

The first capping layer and the second capping layer may increase external emission efficiency according to the principle of constructive interference. Accordingly, the light extraction efficiency of the light-emitting device 10 may be increased, and accordingly, the luminescence efficiency of the light-emitting device 10 may be enhanced or improved.

Each of the first capping layer and the second capping layer may include a material having a refractive index of 1.6 or more (at 589 nm).

The first capping layer and the second capping layer may each independently be an organic capping layer including an organic material, an inorganic capping layer including an inorganic material, or an organic-inorganic composite capping layer including an organic material and an inorganic material.

At least one of the first capping layer and/or the second capping layer may each independently include a carbocyclic compound, a heterocyclic compound, an amine group-containing compound, a porphine derivative, a phthalocyanine derivative, a naphthalocyanine derivative, an alkali metal complex, an alkaline earth metal complex, or any combination thereof. The carbocyclic compound, the heterocyclic compound, and the amine group-containing compound may optionally be substituted with a substituent including O, N, S, Se, Si, F, Cl, Br, I, or any combination thereof. In one or more embodiments, at least one of the first capping layer and/or the second capping layer may each independently include an amine group-containing compound.

In one or more embodiments, at least one of the first capping layer and/or the second capping layer may each independently include a compound represented by Formula 201, a compound represented by Formula 202, or any combination thereof.

In one or more embodiments, at least one of the first capping layer and/or the second capping layer may each independently include: one of (e.g., at least one selected from among) Compounds HT28 to HT33; one of (e.g., at least one selected from among) Compounds CP1 to CP6; β-NPB; or any combination thereof:

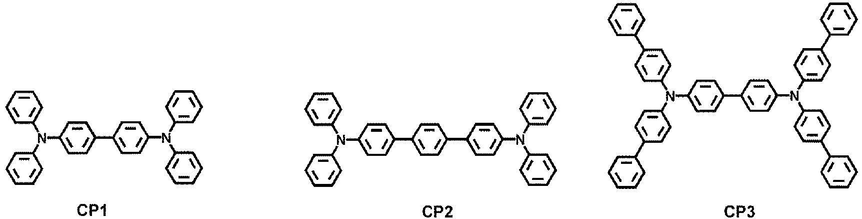

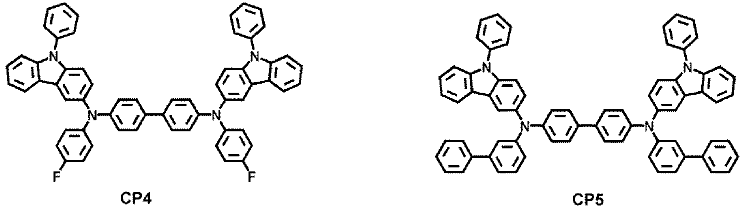

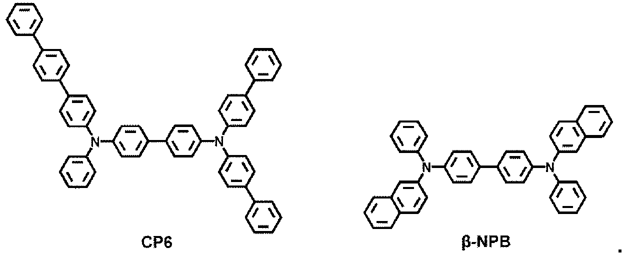

### Film

The condensed cyclic compound represented by Formula 1 may be included in one or more suitable films. Accordingly, another aspect of the disclosure provides a film including the condensed cyclic compound represented by Formula 1. The film may be, for example, an optical member (or a light control component) (e.g., a color filter, a color conversion member, a capping layer, a light extraction efficiency enhancement layer, a selective light-absorbing layer, a polarizing layer, a quantum dot-containing layer, and/or the like), a light-blocking member (e.g., a light-reflecting layer, a light-absorbing layer, and/or the like), a protective member (e.g., an insulating layer, a dielectric layer, and/or the like), and/or the like.

### Electronic apparatus

The light-emitting device may be included in one or more suitable electronic apparatuses. For example, the electronic apparatus including the light-emitting device may be a light-emitting apparatus, an authentication apparatus, and/or the like.

The electronic apparatus (e.g., a light-emitting apparatus) may further include, in addition to the light-emitting device, i) a color filter, ii) a color conversion layer, or iii) a color filter and a color conversion layer. The color filter and/or the color conversion layer may be arranged in at least one direction in which light emitted from the light-emitting device travels. For example, the light emitted from the light-emitting device may be blue light or white light. A detailed description of the light-emitting device is provided herein. In one or more embodiments, the color conversion layer may include a quantum dot. The quantum dot may be, for example, a quantum dot as described herein.

The electronic apparatus may include a first substrate. The first substrate may include a plurality of subpixel areas, the color filter may include a plurality of color filter areas respectively corresponding to the subpixel areas, and the color conversion layer may include a plurality of color conversion areas respectively corresponding to the subpixel areas.

A pixel-defining film may be arranged among the subpixel areas to define each of the subpixel areas.

The color filter may further include a plurality of color filter areas and light-shielding patterns arranged among the color filter areas, and the color conversion layer may further include a plurality of color conversion areas and light-shielding patterns arranged among the color conversion areas.

The plurality of color filter areas (or the plurality of color conversion areas) may include a first area emitting first color light, a second area emitting second color light, and/or a third area emitting third color light, wherein the first color light, the second color light, and/or the third color light may have different maximum emission wavelengths. For example, the first color light may be red light, the second color light may be green light, and the third color light may be blue light. For example, the plurality of color filter areas (or the plurality of color conversion areas) may include quantum dots. In more detail, the first area may include a red quantum dot, the second area may include a green quantum dot, and the third area may not include (e.g., may exclude) a quantum dot. A detailed description of the quantum dots is provided herein. The first area, the second area, and/or the third area may each further include a scatterer.

In one or more embodiments, the light-emitting device may be to emit first light, the first area may be to absorb the first light to emit first-1 color light, the second area may be to absorb the first light to emit second-1 color light, and the third area may be to absorb the first light to emit third-1 color light. In this regard, the first-1 color light, the second-1 color light, and the third-1 color light may have different maximum emission wavelengths. In more detail, the first light may be blue light, the first-1 color light may be red light, the second-1 color light may be green light, and the third-1 color light may be blue light.

The electronic apparatus may further include a thin-film transistor, in addition to the light-emitting device as described herein. The thin-film transistor may include a source electrode, a drain electrode, and an active layer, wherein one of the source electrode and the drain electrode may be electrically connected to one of the first electrode and the second electrode of the light-emitting device.

The thin-film transistor may further include a gate electrode, a gate insulating film, and/or the like.

The active layer may include crystalline silicon, amorphous silicon, an organic semiconductor, an oxide semiconductor, and/or the like.

The electronic apparatus may further include a sealing portion for sealing the light-emitting device. The sealing portion may be arranged between the color filter and/or the color conversion layer and the light-emitting device. The sealing portion allows light from the light-emitting device to be extracted to the outside, and concurrently (e.g., simultaneously) prevents ambient air and moisture from penetrating into the light-emitting device. The sealing portion may be a sealing substrate including a transparent glass substrate or a plastic substrate. The sealing portion may be a thin-film encapsulation layer including at least one layer of an organic layer and/or an inorganic layer. When the sealing portion is a thin-film encapsulation layer, the electronic apparatus may be flexible.

Various functional layers may be additionally arranged on the sealing portion, in addition to the color filter and/or the color conversion layer, according to the use of the electronic apparatus. Examples of the functional layers may include a touch screen layer, a polarizing layer, and/or the like. The touch screen layer may be a pressure-sensitive touch screen layer, a capacitive touch screen layer, or an infrared touch screen layer. The authentication apparatus may be, for example, a biometric authentication apparatus that authenticates an individual by using biometric information of a living body (e.g., fingertips, pupils, and/or the like).

The authentication apparatus may further include, in addition to the light-emitting device as described herein, a biometric information collector.

The electronic apparatus may be applied to one or more suitable displays, light sources, lighting, personal computers (e.g., a mobile personal computer), mobile phones, digital cameras, electronic organizers, electronic dictionaries, electronic game machines, medical instruments (e.g., electronic thermometers, sphygmomanometers, blood glucose meters, pulse measurement devices, pulse wave measurement devices, electrocardiogram displays, ultrasonic diagnostic devices, or endoscope displays), fish finders, one or more suitable measuring instruments, meters (e.g., meters for a vehicle, an aircraft, and a vessel), projectors, and/or the like.

### Electronic equipment

The light-emitting device may be included in one or more suitable electronic equipment.

In one or more embodiments, the electronic equipment including the light-emitting device may be at least one of (e.g., selected from among) a flat panel display, a curved display, a computer monitor, a medical monitor, a television, a billboard, an indoor light, an outdoor light, a signal light, a head-up display, a fully or partially transparent display, a flexible display, a rollable display, a foldable display, a stretchable display, a laser printer, a telephone, a mobile phone, a tablet, a phablet, a personal digital assistant (PDA), a wearable device, a laptop computer, a digital camera, a camcorder, a viewfinder, a micro display, a 3D display, a virtual reality display, an augmented reality display, a vehicle, a video wall including multiple displays tiled together, a theater screen, a stadium screen, a phototherapy device, and a signboard.

The light-emitting device may have excellent or suitable luminescence efficiency and a long lifespan, and thus, the electronic equipment including the light-emitting device may have characteristics such as high luminance, high resolution, and low power consumption.

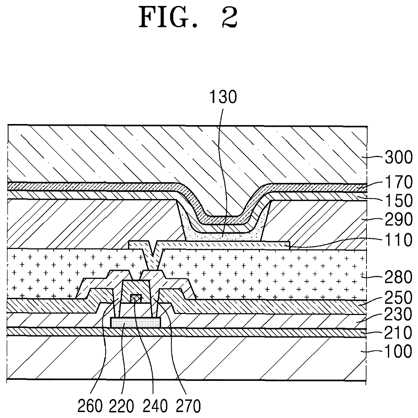

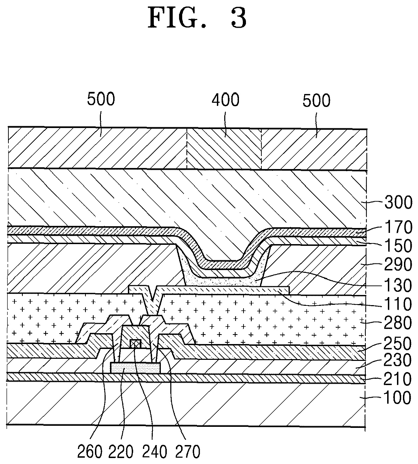

### Descriptions of FIGS. 2 and 3

FIG. 2 is a cross-sectional view of a light-emitting apparatus according to one or more embodiments.

The light-emitting apparatus of FIG. 2 includes a substrate 100, a thin-film transistor (TFT), a light-emitting device, and an encapsulation portion 300 that seals the light-emitting device.

The substrate 100 may be a flexible substrate, a glass substrate, or a metal substrate. A buffer layer 210 may be arranged on the substrate 100. The buffer layer 210 may prevent or reduce penetration of impurities through the substrate 100, and may provide a flat surface on the substrate 100.

A TFT may be arranged on the buffer layer 210. The TFT may include an active layer 220, a gate electrode 240, a source electrode 260, and a drain electrode 270.

The active layer 220 may include an inorganic semiconductor, such as silicon or polysilicon, an organic semiconductor, or an oxide semiconductor, and may include a source region, a drain region, and a channel region.

A gate insulating film 230 for insulating the active layer 220 from the gate electrode 240 may be arranged on the active layer 220, and the gate electrode 240 may be arranged on the gate insulating film 230.

An interlayer insulating film 250 may be arranged on the gate electrode 240. The interlayer insulating film 250 may be arranged between the gate electrode 240 and the source electrode 260 to insulate the gate electrode 240 from the source electrode 260 and between the gate electrode 240 and the drain electrode 270 to insulate the gate electrode 240 from the drain electrode 270.

The source electrode 260 and the drain electrode 270 may be arranged on the interlayer insulating film 250. The interlayer insulating film 250 and the gate insulating film 230 may be formed to expose the source region and the drain region of the active layer 220, and the source electrode 260 and the drain electrode 270 may be arranged in contact with the exposed portions of the source region and the drain region of the active layer 220.

The TFT may be electrically connected to a light-emitting device to drive the light-emitting device, and may be covered and protected by a passivation layer 280. The passivation layer 280 may include an inorganic insulating film, an organic insulating film, or any combination thereof. A light-emitting device may be provided on the passivation layer 280. The light-emitting device may include the first electrode 110, the interlayer 130, and the second electrode 150.

The first electrode 110 may be arranged on the passivation layer 280. The passivation layer 280 may be arranged to expose a portion of the drain electrode 270 without fully covering the drain electrode 270, and the first electrode 110 may be arranged to be connected to the exposed portion of the drain electrode 270.

A pixel-defining film 290 including an insulating material may be arranged on the first electrode 110. The pixel-defining film 290 may expose a certain region of the first electrode 110, and the interlayer 130 may be formed in the exposed region of the first electrode 110. The pixel-defining film 290 may be a polyimide-based organic film or a polyacrylic organic film. In one or more embodiments, at least some layers of the interlayer 130 may extend beyond the upper portion of the pixel-defining film 290 to be arranged in the form of a common layer.

The second electrode 150 may be arranged on the interlayer 130, and a capping layer 170 may be additionally formed on the second electrode 150. The capping layer 170 may be formed to cover the second electrode 150.

The encapsulation portion 300 may be arranged on the capping layer 170. The encapsulation portion 300 may be arranged on a light-emitting device to protect the light-emitting device from moisture or oxygen. The encapsulation portion 300 may include: an inorganic film including silicon nitride (SiNx), silicon oxide (SiOx), indium tin oxide, indium zinc oxide, or any combination thereof; an organic film including polyethylene terephthalate, polyethylene naphthalate, polycarbonate, polyimide, polyethylene sulfonate, polyoxymethylene, polyarylate, hexamethyldisiloxane, an acrylic resin (e.g., polymethyl methacrylate, polyacrylic acid, and/or the like), an epoxy-based resin (e.g., aliphatic glycidyl ether (AGE), and/or the like), or any combination thereof; or any combination of the inorganic films and the organic films.

FIG. 3 is a cross-sectional view of a light-emitting apparatus according to one or more embodiments.

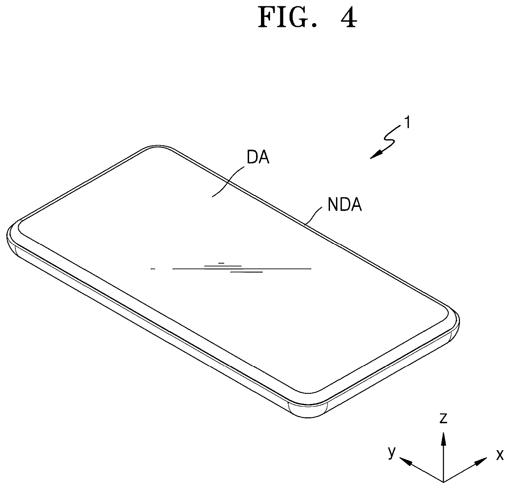

The light-emitting apparatus of FIG. 3 is the same as the light-emitting apparatus of FIG. 2, except that a light-shielding pattern 500 and a functional region 400 are additionally arranged on the encapsulation portion 300. The functional region 400 may be i) a color filter area, ii) a color conversion area, or iii) a combination of the color filter area and the color conversion area. In one or more embodiments, a light-emitting device included in the light-emitting apparatus of FIG. 4 may be a tandem light-emitting device.

### Description of FIG. 4

FIG. 4 is a schematic perspective view of electronic equipment 1 including a light-emitting device according to one or more embodiments. The electronic equipment 1 may be, as an apparatus that displays a moving image or a still image, portable electronic equipment, such as a mobile phone, a smartphone, a tablet personal computer (PC), a mobile communication terminal, an electronic notebook, an electronic book, a portable multimedia player (PMP), a navigation, or an ultra-mobile PC (UMPC), as well as one or more suitable products, such as a television, a laptop, a monitor, a billboard, or an Internet of things (IoT) device. The electronic equipment 1 may be such a product herein or a part thereof. In some embodiments, the electronic equipment 1 may be a wearable device, such as a smart watch, a watch phone, a glasses-type (kind) display, or a head mounted display (HMD), or a part of the wearable device. However, embodiments are not limited thereto. For example, the electronic equipment 1 may be a center information display (CID) arranged on an instrument panel and a center fascia or dashboard of a vehicle, a room mirror display instead of a side mirror of a vehicle, an entertainment display for a rear seat of a vehicle, a display arranged on the back of a front seat, a head up display (HUD) installed in the front of a vehicle or projected on a front window glass, or a computer generated hologram augmented reality head up display (CGH AR HUD). FIG. 4 illustrates one or more embodiments in which the electronic equipment 1 is a smartphone for convenience of explanation.

The electronic equipment 1 may include a display area DA and a non-display area NDA outside the display area DA. A display apparatus may implement an image through an array of a plurality of pixels that are two-dimensionally arranged in the display area DA.

The non-display area NDA may be an area that does not display an image, and may entirely be around (e.g., surround) the display area DA. On the non-display area NDA, a driver for providing electrical signals or power to display devices arranged on the display area DA may be arranged. On the non-display area NDA, a pad, which is an area to which an electronic element or a printed circuit board may be electrically connected, may be arranged.

In the electronic equipment 1, the length in an x-axis direction and the length in a y-axis direction may be different from each other. In one or more embodiments, as shown in FIG. 4, the length in the x-axis direction may be less than the length in the y-axis direction. In one or more embodiments, the length in the x-axis direction may be the same as the length in the y-axis direction. In one or more embodiments, the length in the x-axis direction may be greater than the length in the y-axis direction.

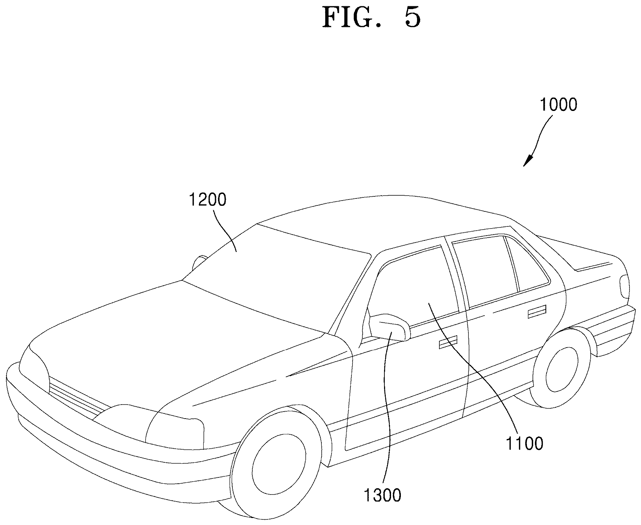

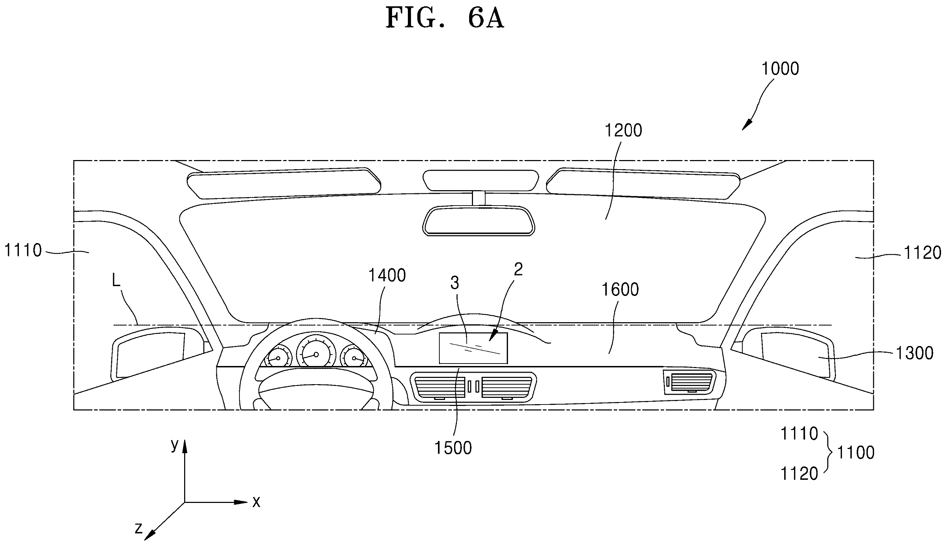

### Descriptions of FIGS. 5 and 6A to 6C

FIG. 5 is a schematic view of the exterior of a vehicle 1000 as electronic equipment including a light-emitting device according to one or more embodiments. FIGS. 6A to 6C are each a schematic view of the interior of the vehicle 1000 according to one or more embodiments.

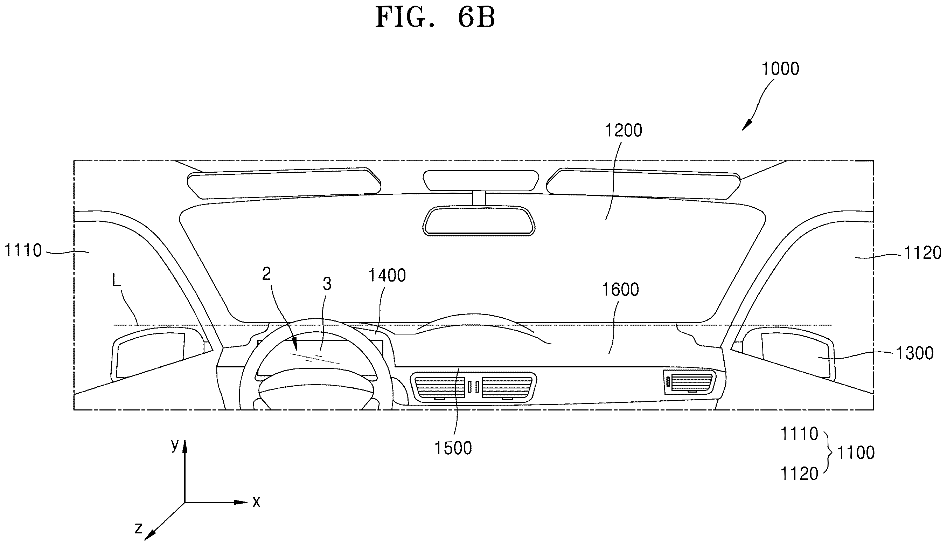

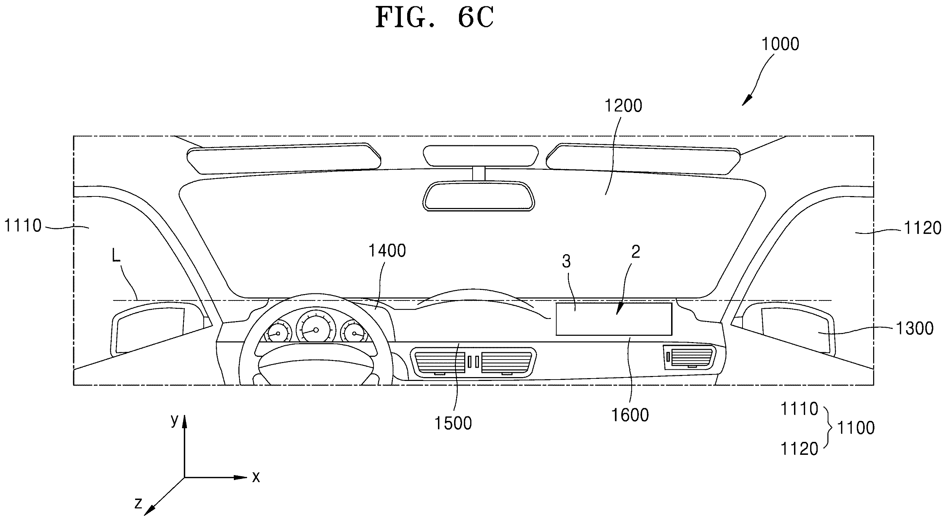

Referring to FIGS. 5, 6A, 6B, and 6C, the vehicle 1000 may refer to one or more suitable apparatuses for moving a subject to be transported, such as a human, an object, or an animal, from a departure point to a destination point. The vehicle 1000 may include a vehicle traveling on a road or a track, a vessel moving over the sea or river, an airplane flying in the sky using the action of air, and/or the like.

The vehicle 1000 may travel on a road or a track. The vehicle 1000 may move in a certain direction according to rotation of at least one wheel. For example, the vehicle 1000 may include a three-wheeled or four-wheeled vehicle, a construction machine, a two-wheeled vehicle, a prime mover device, a bicycle, and a train running on a track.

The vehicle 1000 may include a body having an interior and an exterior, and a chassis in which mechanical apparatuses necessary for driving are installed as other parts except for the body of the vehicle 1000. The exterior of the body of the vehicle 1000 may include a front panel, a bonnet, a roof panel, a rear panel, a trunk, a pillar provided at a boundary between doors, and/or the like. The chassis of the vehicle 1000 may include a power generating device, a power transmitting device, a driving device, a steering device, a braking device, a suspension device, a transmission device, a fuel device, front and rear left and right wheels, and/or the like.

The vehicle 1000 may include a side window glass 1100, a front window glass 1200, a side mirror 1300, a cluster 1400, a center fascia 1500, a passenger seat dashboard 1600, and a display apparatus 2.

The side window glass 1100 and the front window glass 1200 may be partitioned by a pillar arranged between the side window glass 1100 and the front window glass 1200.

The side window glass 1100 may be installed on the side of the vehicle 1000. In one or more embodiments, the side window glass 1100 may be installed on a door of the vehicle 1000. A plurality of side window glasses 1100 may be provided and may face each other. In one or more embodiments, the side window glass 1100 may include a first side window glass 1110 and a second side window glass 1120. In one or more embodiments, the first side window glass 1110 may be arranged adjacent to the cluster 1400. The second side window glass 1120 may be arranged adjacent to the passenger seat dashboard 1600.

In one or more embodiments, the side window glasses 1100 may be spaced and/or apart (e.g., spaced apart or separated) from each other in an x-direction or a -x-direction. For example, the first side window glass 1110 and the second side window glass 1120 may be spaced and/or apart (e.g., spaced apart or separated) from each other in the x-direction or the -x-direction. For example, an imaginary straight line L connecting the side window glasses 1100 may extend in the x-direction or the -x-direction. For example, an imaginary straight line L connecting the first side window glass 1110 and the second side window glass 1120 to each other may extend in the x-direction or the -x-direction.

The front window glass 1200 may be installed in the front of the vehicle 1000. The front window glass 1200 may be arranged between the side window glasses 1100 opposite to (e.g., facing) each other.

The side mirror 1300 may provide a rear view of the vehicle 1000. The side mirror 1300 may be installed on the exterior of the body of the vehicle 1000. In one or more embodiments, a plurality of side mirrors 1300 may be provided. Any one of the plurality of side mirrors 1300 may be arranged outside the first side window glass 1110. Another of the plurality of side mirrors 1300 may be arranged outside the second side window glass 1120.

The cluster 1400 may be arranged in front of a steering wheel. The cluster 1400 may include a tachometer, a speedometer, a coolant thermometer, a fuel gauge, a turn signal indicator, a high beam indicator, a warning light, a seat belt warning light, an odometer, a tachograph, an automatic shift selector indicator, a door open warning light, an engine oil warning light, and/or a low fuel warning light.

The center fascia 1500 may include a control panel on which a plurality of buttons for adjusting an audio device, an air conditioning device, and a seat heater are arranged. The center fascia 1500 may be arranged on one side of the cluster 1400.

The passenger seat dashboard 1600 may be spaced and/or apart (e.g., spaced apart or separated) from the cluster 1400, and the center fascia 1500 may be arranged between the cluster 1400 and the passenger seat dashboard 1600. In one or more embodiments, the cluster 1400 may be arranged to correspond to a driver seat, and the passenger seat dashboard 1600 may be arranged to correspond to a passenger seat. In one or more embodiments, the cluster 1400 may be adjacent to the first side window glass 1110, and the passenger seat dashboard 1600 may be adjacent to the second side window glass 1120.

In one or more embodiments, the display apparatus 2 may include a display panel 3, and the display panel 3 may display an image. The display apparatus 2 may be arranged inside the vehicle 1000. In one or more embodiments, the display apparatus 2 may be arranged between the side window glasses 1100 opposite to (e.g., facing) each other. The display apparatus 2 may be arranged on at least one of the cluster 1400, the center fascia 1500, and the passenger seat dashboard 1600.

The display apparatus 2 may include an organic light-emitting display apparatus, an inorganic light-emitting display apparatus, a quantum dot display apparatus, and/or the like. Hereinafter, as the display apparatus 2 according to one or more embodiments, an organic light-emitting display apparatus including the light-emitting device according to the disclosure will be described as an example, but one or more suitable types (kinds) of display apparatuses as described herein may be used in embodiments.

Referring to FIG. 6A, the display apparatus 2 may be arranged on the center fascia 1500. In one or more embodiments, the display apparatus 2 may display navigation information. In one or more embodiments, the display apparatus 2 may display information regarding audio settings, video setting, or vehicle settings.

Referring to FIG. 6B, the display apparatus 2 may be arranged on the cluster 1400. In this case, the cluster 1400 may display driving information and/or the like through the display apparatus 2. For example, the cluster 1400 may digitally implement driving information and/or the like. The cluster 1400 may digitally display vehicle information and driving information as images. For example, a needle and a gauge of a tachometer and one or more suitable warning light icons may be displayed by digital signals.

Referring to FIG. 6C, the display apparatus 2 may be arranged on the passenger seat dashboard 1600. The display apparatus 2 may be embedded in the passenger seat dashboard 1600 or arranged on the passenger seat dashboard 1600. In one or more embodiments, the display apparatus 2 arranged on the passenger seat dashboard 1600 may display an image related to information displayed on the cluster 1400 and/or information displayed on the center fascia 1500. In one or more embodiments, the display apparatus 2 arranged on the passenger seat dashboard 1600 may display information different from information displayed on the cluster 1400 and/or information displayed on the center fascia 1500.

### Manufacturing method

Layers constituting the hole transport region, the emission layer, and layers constituting the electron transport region may be formed in a certain region by using one or more suitable methods, such as vacuum deposition, spin coating, casting, Langmuir-Blodgett (LB) deposition, ink-jet printing, laser-printing, laser-induced thermal imaging, and/or the like.

When the layers constituting the hole transport region, the emission layer, and the layers constituting the electron transport region are formed by vacuum deposition, the deposition may be performed at a deposition temperature in a range of about 100 °C to about 500 °C, at a vacuum degree in a range of about 10⁻⁸ torr to about 10⁻³ torr, and at a deposition speed in a range of about 0.01 angstrom per second (Å/sec) to about 100 Å/sec, depending on a material to be included in a layer to be formed and the structure of a layer to be formed.

### Definition of terms

The term "C₃-C₆₀ carbocyclic group" as used herein refers to a cyclic group consisting of carbon atoms as the only ring-forming atoms and having 3 to 60 carbon atoms, and the term "C₁-C₆₀ heterocyclic group" as used herein refers to a cyclic group that has 1 to 60 carbon atoms and further includes, in addition to a carbon atom, a heteroatom as a ring-forming atom. The C₃-C₆₀ carbocyclic group and the C₁-C₆₀ heterocyclic group may each be a monocyclic group consisting of one ring or a polycyclic group in which two or more rings are condensed with each other. For example, the number of ring-forming atoms of the C₁-C₆₀ heterocyclic group may be from 3 to 61.

The term "cyclic group" as used herein may include both (e.g., simultaneously) the C₃-C₆₀ carbocyclic group and the C₁-C₆₀ heterocyclic group.

The term "π electron-rich C₃-C₆₀ cyclic group" as used herein refers to a cyclic group that has 3 to 60 carbon atoms and does not include *-N=*' as a ring-forming moiety, and the term "π electron-deficient nitrogen-containing C₁-C₆₀ cyclic group" as used herein refers to a heterocyclic group that has 1 to 60 carbon atoms and includes *-N=*' as a ring-forming moiety.

For example,
the C₃-C₆₀ carbocyclic group may be i) Group T1 or ii) a condensed cyclic group in which two or more of Group T1 are condensed with each other (e.g., a cyclopentadiene group, an adamantane group, a norbornane group, a benzene group, a pentalene group, a naphthalene group, an azulene group, an indacene group, an acenaphthylene group, a phenalene group, a phenanthrene group, an anthracene group, a fluoranthene group, a triphenylene group, a pyrene group, a chrysene group, a perylene group, a pentaphene group, a heptalene group, a naphthacene group, a picene group, a hexacene group, a pentacene group, a rubicene group, a coronene group, an ovalene group, an indene group, a fluorene group, a spiro-bifluorene group, a benzofluorene group, an indenophenanthrene group, or an indenoanthracene group),
the C₁-C₆₀ heterocyclic group may be i) Group T2, ii) a condensed cyclic group in which two or more of Group T2 are condensed with each other, or iii) a condensed cyclic group in which at least one Group T2 and at least one Group T1 are condensed with each other (e.g., a pyrrole group, a thiophene group, a furan group, an indole group, a benzoindole group, a naphthoindole group, an isoindole group, a benzoisoindole group, a naphthoisoindole group, a benzosilole group, a benzothiophene group, a benzofuran group, a carbazole group, a dibenzosilole group, a dibenzothiophene group, a dibenzofuran group, an indenocarbazole group, an indolocarbazole group, a benzofurocarbazole group, a benzothienocarbazole group, a benzosilolocarbazole group, a benzoindolocarbazole group, a benzocarbazole group, a benzonaphthofuran group, a benzonaphthothiophene group, a benzonaphthosilole group, a benzofurodibenzofuran group, a benzofurodibenzothiophene group, a benzothienodibenzothiophene group, a pyrazole group, an imidazole group, a triazole group, an oxazole group, an isoxazole group, an oxadiazole group, a thiazole group, an isothiazole group, a thiadiazole group, a benzopyrazole group, a benzimidazole group, a benzoxazole group, a benzoisoxazole group, a benzothiazole group, a benzoisothiazole group, a pyridine group, a pyrimidine group, a pyrazine group, a pyridazine group, a triazine group, a quinoline group, an isoquinoline group, a benzoquinoline group, a benzoisoquinoline group, a quinoxaline group, a benzoquinoxaline group, a quinazoline group, a benzoquinazoline group, a phenanthroline group, a cinnoline group, a phthalazine group, a naphthyridine group, an imidazopyridine group, an imidazopyrimidine group, an imidazotriazine group, an imidazopyrazine group, an imidazopyridazine group, an azacarbazole group, an azafluorene group, an azadibenzosilole group, an azadibenzothiophene group, an azadibenzofuran group, and/or the like.),
the π electron-rich C₃-C₆₀ cyclic group may be i) Group T1, ii) a condensed cyclic group in which two or more of Group T1 are condensed with each other, iii) Group T3, iv) a condensed cyclic group in which two or more of Group T3 are condensed with each other, or v) a condensed cyclic group in which at least one Group T3 and at least one Group T1 are condensed with each other (e.g., the C₃-C₆₀ carbocyclic group, a 1H-pyrrole group, a silole group, a borole group, a 2H-pyrrole group, a 3H-pyrrole group, a thiophene group, a furan group, an indole group, a benzoindole group, a naphthoindole group, an isoindole group, a benzoisoindole group, a naphthoisoindole group, a benzosilole group, a benzothiophene group, a benzofuran group, a carbazole group, a dibenzosilole group, a dibenzothiophene group, a dibenzofuran group, an indenocarbazole group, an indolocarbazole group, a benzofurocarbazole group, a benzothienocarbazole group, a benzosilolocarbazole group, a benzoindolocarbazole group, a benzocarbazole group, a benzonaphthofuran group, a benzonaphthothiophene group, a benzonaphthosilole group, a benzofurodibenzofuran group, a benzofurodibenzothiophene group, a benzothienodibenzothiophene group, and/or the like.),
the π electron-deficient nitrogen-containing C₁-C₆₀ cyclic group may be i) Group T4, ii) a condensed cyclic group in which two or more of Group T4 are condensed with each other, iii) a condensed cyclic group in which at least one Group T4 and at least one Group T1 are condensed with each other, iv) a condensed cyclic group in which at least one Group T4 and at least one Group T3 are condensed with each other, or v) a condensed cyclic group in which at least one Group T4, at least one Group T1, and at least one Group T3 are condensed with one another (e.g., a pyrazole group, an imidazole group, a triazole group, an oxazole group, an isoxazole group, an oxadiazole group, a thiazole group, an isothiazole group, a thiadiazole group, a benzopyrazole group, a benzimidazole group, a benzoxazole group, a benzoisoxazole group, a benzothiazole group, a benzoisothiazole group, a pyridine group, a pyrimidine group, a pyrazine group, a pyridazine group, a triazine group, a quinoline group, an isoquinoline group, a benzoquinoline group, a benzoisoquinoline group, a quinoxaline group, a benzoquinoxaline group, a quinazoline group, a benzoquinazoline group, a phenanthroline group, a cinnoline group, a phthalazine group, a naphthyridine group, an imidazopyridine group, an imidazopyrimidine group, an imidazotriazine group, an imidazopyrazine group, an imidazopyridazine group, an azacarbazole group, an azafluorene group, an azadibenzosilole group, an azadibenzothiophene group, an azadibenzofuran group, and/or the like.),
Group T1 may be a cyclopropane group, a cyclobutane group, a cyclopentane group, a cyclohexane group, a cycloheptane group, a cyclooctane group, a cyclobutene group, a cyclopentene group, a cyclopentadiene group, a cyclohexene group, a cyclohexadiene group, a cycloheptene group, an adamantane group, a norbornane (or bicyclo[2.2.1]heptane) group, a norbornene group, a bicyclo[1.1.1]pentane group, a bicyclo[2.1.1]hexane group, a bicyclo[2.2.2]octane group, or a benzene group,
Group T2 may be a furan group, a thiophene group, a 1H-pyrrole group, a silole group, a borole group, a 2H-pyrrole group, a 3H-pyrrole group, an imidazole group, a pyrazole group, a triazole group, a tetrazole group, an oxazole group, an isoxazole group, an oxadiazole group, a thiazole group, an isothiazole group, a thiadiazole group, an azasilole group, an azaborole group, a pyridine group, a pyrimidine group, a pyrazine group, a pyridazine group, a triazine group, a tetrazine group, a pyrrolidine group, an imidazolidine group, a dihydropyrrole group, a piperidine group, a tetrahydropyridine group, a dihydropyridine group, a hexahydropyrimidine group, a tetrahydropyrimidine group, a dihydropyrimidine group, a piperazine group, a tetrahydropyrazine group, a dihydropyrazine group, a tetrahydropyridazine group, or a dihydropyridazine group,
Group T3 may be a furan group, a thiophene group, a 1H-pyrrole group, a silole group, or a borole group, and
Group T4 may be a 2H-pyrrole group, a 3H-pyrrole group, an imidazole group, a pyrazole group, a triazole group, a tetrazole group, an oxazole group, an isoxazole group, an oxadiazole group, a thiazole group, an isothiazole group, a thiadiazole group, an azasilole group, an azaborole group, a pyridine group, a pyrimidine group, a pyrazine group, a pyridazine group, a triazine group, or a tetrazine group.

The terms "cyclic group," "C₃-C₆₀ carbocyclic group," "C₁-C₆₀ heterocyclic group," "π electron-rich C₃-C₆₀ cyclic group," and "π electron-deficient nitrogen-containing C₁-C₆₀ cyclic group" as used herein each refer to a group condensed to any cyclic group, a monovalent group, or a polyvalent group (e.g., a divalent group, a trivalent group, a tetravalent group, and/or the like.) according to the structure of a formula for which the corresponding term is used. For example, the "benzene group" may be a benzo group, a phenyl group, a phenylene group, and/or the like, which may be easily understood by one of ordinary skill in the art according to the structure of a formula including the "benzene group."

Depending on context, a divalent group may refer or be a polyvalent group (e.g., trivalent, tetravalent, etc., and not just divalent) per, e.g., the structure of a formula in connection with which of the terms are utilized.

Examples of the monovalent C₃-C₆₀ carbocyclic group and the monovalent C₁-C₆₀ heterocyclic group may include a C₃-C₁₀ cycloalkyl group, a C₁-C₁₀ heterocycloalkyl group, a C₃-C₁₀ cycloalkenyl group, a C₁-C₁₀ heterocycloalkenyl group, a C₆-C₆₀ aryl group, a C₁-C₆₀ heteroaryl group, a monovalent non-aromatic condensed polycyclic group, and a monovalent non-aromatic condensed heteropolycyclic group. Examples of the divalent C₃-C₆₀ carbocyclic group and the monovalent C₁-C₆₀ heterocyclic group may include a C₃-C₁₀ cycloalkylene group, a C₁-C₁₀ heterocycloalkylene group, a C₃-C₁₀ cycloalkenylene group, a C₁-C₁₀ heterocycloalkenylene group, a C₆-C₆₀ arylene group, a C₁-C₆₀ heteroarylene group, a divalent non-aromatic condensed polycyclic group, and a substituted or unsubstituted divalent non-aromatic condensed heteropolycyclic group.

The term "C₁-C₆₀ alkyl group" as used herein refers to a linear or branched aliphatic hydrocarbon monovalent group that has 1 to 60 carbon atoms, and examples thereof may include a methyl group, an ethyl group, an n-propyl group, an isopropyl group, an n-butyl group, a sec-butyl group, an isobutyl group, a tert-butyl group, an n-pentyl group, a tert-pentyl group, a neopentyl group, an isopentyl group, a sec-pentyl group, a 3-pentyl group, a sec-isopentyl group, an n-hexyl group, an isohexyl group, a sec-hexyl group, a tert-hexyl group, an n-heptyl group, an isoheptyl group, a sec-heptyl group, a tert-heptyl group, an n-octyl group, an isooctyl group, a sec-octyl group, a tert-octyl group, an n-nonyl group, an isononyl group, a sec-nonyl group, a tert-nonyl group, an n-decyl group, an isodecyl group, a sec-decyl group, a tert-decyl group, and/or the like. The term "C₁-C₆₀ alkylene group" as used herein refers to a divalent group having the same structure as the C₁-C₆₀ alkyl group.

The term "C₂-C₆₀ alkenyl group" as used herein refers to a monovalent hydrocarbon group having at least one carbon-carbon double bond in the middle or at the terminus of the C₂-C₆₀ alkyl group, and examples thereof may include an ethenyl group, a propenyl group, a butenyl group, and/or the like. The term "C₂-C₆₀ alkenylene group" as used herein refers to a divalent group having the same structure as the C₂-C₆₀ alkenyl group.

The term "C₂-C₆₀ alkynyl group" as used herein refers to a monovalent hydrocarbon group having at least one carbon-carbon triple bond in the middle or at the terminus of the C₂-C₆₀ alkyl group, and examples thereof may include an ethynyl group, a propynyl group, and/or the like. The term "C₂-C₆₀ alkynylene group" as used herein refers to a divalent group having the same structure as the C₂-C₆₀ alkynyl group.

The term "C₁-C₆₀ alkoxy group" as used herein refers to a monovalent group represented by -OA₁₀₁ (wherein A₁₀₁ is the C₁-C₆₀ alkyl group), and examples thereof may include a methoxy group, an ethoxy group, an isopropyloxy group, and/or the like.

The term "C₃-C₁₀ cycloalkyl group" as used herein refers to a monovalent saturated hydrocarbon cyclic group having 3 to 10 carbon atoms, and examples thereof may include a cyclopropyl group, a cyclobutyl group, a cyclopentyl group, a cyclohexyl group, a cycloheptyl group, a cyclooctyl group, an adamantanyl group, a norbornanyl group (or bicyclo[2.2.1]heptyl group), a bicyclo[1.1.1]pentyl group, a bicyclo[2.1.1]hexyl group, a bicyclo[2.2.2]octyl group, and/or the like. The term "C₃-C₁₀ cycloalkylene group" as used herein refers to a divalent group having the same structure as the C₃-C₁₀ cycloalkyl group.

The term "C₁-C₁₀ heterocycloalkyl group" as used herein refers to a monovalent cyclic group of 1 to 10 carbon atoms, further including, in addition to carbon atoms, at least one heteroatom as ring-forming atoms, and examples thereof may include a 1,2,3,4-oxatriazolidinyl group, a tetrahydrofuranyl group, a tetrahydrothiophenyl group, and/or the like. The term "C₁-C₁₀ heterocycloalkylene group" as used herein refers to a divalent group having the same structure as the C₁-C₁₀ heterocycloalkyl group.

The term "C₃-C₁₀ cycloalkenyl group" as used herein refers to a monovalent cyclic group that has 3 to 10 carbon atoms, at least one carbon-carbon double bond in the ring thereof, and no aromaticity, and examples thereof may include a cyclopentenyl group, a cyclohexenyl group, a cycloheptenyl group, and/or the like. The term "C₃-C₁₀ cycloalkenylene group" as used herein refers to a divalent group having the same structure as the C₃-C₁₀ cycloalkenyl group.

The term "C₁-C₁₀ heterocycloalkenyl group" as used herein refers to a monovalent cyclic group of 1 to 10 carbon atoms, further including, in addition to carbon atoms, at least one heteroatom as ring-forming atoms and at least one double bond in the ring thereof. Examples of the C₁-C₁₀ heterocycloalkenyl group may include a 4,5-dihydro-1,2,3,4-oxatriazolyl group, a 2,3-dihydrofuranyl group, a 2,3-dihydrothiophenyl group, and/or the like. The term "C₁-C₁₀ heterocycloalkenylene group" as used herein refers to a divalent group having the same structure as the C₁-C₁₀ heterocycloalkenyl group.

The term "C₆-C₆₀ aryl group" as used herein refers to a monovalent group having a carbocyclic aromatic system of 6 to 60 carbon atoms, and the term "C₆-C₆₀ arylene group" as used herein refers to a divalent group having a carbocyclic aromatic system of 6 to 60 carbon atoms. Examples of the C₆-C₆₀ aryl group may include a phenyl group, a pentalenyl group, a naphthyl group, an azulenyl group, an indacenyl group, an acenaphthyl group, a phenalenyl group, a phenanthrenyl group, an anthracenyl group, a fluoranthenyl group, a triphenylenyl group, a pyrenyl group, a chrysenyl group, a perylenyl group, a pentaphenyl group, a heptalenyl group, a naphthacenyl group, a picenyl group, a hexacenyl group, a pentacenyl group, a rubicenyl group, a coronenyl group, an ovalenyl group, and/or the like. When the C₆-C₆₀ aryl group and the C₆-C₆₀ arylene group each include two or more rings, the two or more rings may be condensed with each other.

The term "C₁-C₆₀ heteroaryl group" as used herein refers to a monovalent group having a heterocyclic aromatic system of 1 to 60 carbon atoms, further including, in addition to carbon atoms, at least one heteroatom, as ring-forming atoms. The term "C₁-C₆₀ heteroarylene group" as used herein refers to a divalent group having a heterocyclic aromatic system of 1 to 60 carbon atoms, further including, in addition to carbon atoms, at least one heteroatom, as ring-forming atoms. Examples of the C₁-C₆₀ heteroaryl group may include a pyridinyl group, a pyrimidinyl group, a pyrazinyl group, a pyridazinyl group, a triazinyl group, a quinolinyl group, a benzoquinolinyl group, an isoquinolinyl group, a benzoisoquinolinyl group, a quinoxalinyl group, a benzoquinoxalinyl group, a quinazolinyl group, a benzoquinazolinyl group, a cinnolinyl group, a phenanthrolinyl group, a phthalazinyl group, a naphthyridinyl group, and/or the like. When the C₁-C₆₀ heteroaryl group and the C₁-C₆₀ heteroarylene group each include two or more rings, the two or more rings may be condensed with each other.

The term "monovalent non-aromatic condensed polycyclic group" as used herein refers to a monovalent group (e.g., having 8 to 60 carbon atoms) having two or more rings condensed to each other, only carbon atoms as ring-forming atoms, and no aromaticity in its entire molecular structure. Examples of the monovalent non-aromatic condensed polycyclic group may include an indenyl group, a fluorenyl group, a spiro-bifluorenyl group, a benzofluorenyl group, an indenophenanthrenyl group, an indenoanthracenyl group, and/or the like. The term "divalent non-aromatic condensed polycyclic group" as used herein refers to a divalent group having the same structure as the monovalent non-aromatic condensed polycyclic group.

The term "monovalent non-aromatic condensed heteropolycyclic group" as used herein refers to a monovalent group (e.g., having 1 to 60 carbon atoms) having two or more rings condensed to each other, further including, in addition to carbon atoms, at least one heteroatom as ring-forming atoms, and having no aromaticity in its entire molecular structure. Examples of the monovalent non-aromatic condensed heteropolycyclic group may include a pyrrolyl group, a thiophenyl group, a furanyl group, an indolyl group, a benzoindolyl group, a naphthoindolyl group, an isoindolyl group, a benzoisoindolyl group, a naphthoisoindolyl group, a benzosilolyl group, a benzothiophenyl group, a benzofuranyl group, a carbazolyl group, a dibenzosilolyl group, a dibenzothiophenyl group, a dibenzofuranyl group, an azacarbazolyl group, an azafluorenyl group, an azadibenzosilolyl group, an azadibenzothiophenyl group, an azadibenzofuranyl group, a pyrazolyl group, an imidazolyl group, a triazolyl group, a tetrazolyl group, an oxazolyl group, an isoxazolyl group, a thiazolyl group, an isothiazolyl group, an oxadiazolyl group, a thiadiazolyl group, a benzopyrazolyl group, a benzimidazolyl group, a benzoxazolyl group, a benzothiazolyl group, a benzoxadiazolyl group, a benzothiadiazolyl group, an imidazopyridinyl group, an imidazopyrimidinyl group, an imidazotriazinyl group, an imidazopyrazinyl group, an imidazopyridazinyl group, an indenocarbazolyl group, an indolocarbazolyl group, a benzofurocarbazolyl group, a benzothienocarbazolyl group, a benzosilolocarbazolyl group, a benzoindolocarbazolyl group, a benzocarbazolyl group, a benzonaphthofuranyl group, a benzonaphthothiophenyl group, a benzonaphthosilolyl group, a benzofurodibenzofuranyl group, a benzofurodibenzothiophenyl group, a benzothienodibenzothiophenyl group, and/or the like. The term "divalent non-aromatic condensed heteropolycyclic group" as used herein refers to a divalent group having the same structure as the monovalent non-aromatic condensed heteropolycyclic group.

The term "C₆-C₆₀ aryloxy group" as used herein refers to -OA₁₀₂ (wherein A₁₀₂ is the C₆-C₆₀ aryl group), and the term "C₆-C₆₀ arylthio group" as used herein refers to -SA₁₀₃ (wherein A₁₀₃ is the C₆-C₆₀ aryl group).

The term "C₇-C₆₀ arylalkyl group" as used herein refers to -A₁₀₄A₁₀₅ (wherein A₁₀₄ is a C₁-C₅₄ alkylene group, and A₁₀₅ is a C₆-C₅₉ aryl group), and the term "C₂-C₆₀ heteroarylalkyl group" as used herein refers to -A₁₀₆A₁₀₇ (wherein A₁₀₆ is a C₁-C₅₉ alkylene group, and A₁₀₇ is a C₁-C₅₉ heteroaryl group).

The term "R₁₀₂" as used herein refers to:
deuterium, -F, -Cl, -Br, -I, a hydroxyl group, a cyano group, or a nitro group;
a C₁-C₆₀ alkyl group, a C₂-C₆₀ alkenyl group, a C₂-C₆₀ alkynyl group, or a C₁-C₆₀ alkoxy group, each unsubstituted or substituted with deuterium, -F, -Cl, -Br, -I, a hydroxyl group, a cyano group, a nitro group, a C₃-C₆₀ carbocyclic group, a C₁-C₆₀ heterocyclic group, a C₆-C₆₀ aryloxy group, a C₆-C₆₀ arylthio group, a C₇-C₆₀ arylalkyl group, a C₂-C₆₀ heteroarylalkyl group, -Si(Q₁₁)(Q₁₂)(Q₁₃), -N(Q₁₁)(Q₁₂), -B(Q₁₁)(Q₁₂), - C(=O)(Q₁₁), -S(=O)₂(Q₁₁), -P(=O)(Q₁₁)(Q₁₂), or any combination thereof;
a C₃-C₆₀ carbocyclic group, a C₁-C₆₀ heterocyclic group, a C₆-C₆₀ aryloxy group, a C₆-C₆₀ arylthio group, a C₇-C₆₀ arylalkyl group, or a C₂-C₆₀ heteroarylalkyl group, each unsubstituted or substituted with deuterium, -F, -Cl, -Br, -I, a hydroxyl group, a cyano group, a nitro group, a C₁-C₆₀ alkyl group, a C₂-C₆₀ alkenyl group, a C₂-C₆₀ alkynyl group, a C₁-C₆₀ alkoxy group, a C₃-C₆₀ carbocyclic group, a C₁-C₆₀ heterocyclic group, a C₆-C₆₀ aryloxy group, a C₆-C₆₀ arylthio group, a C₇-C₆₀ arylalkyl group, a C₂-C₆₀ heteroarylalkyl group, -Si(Q₂₁)(Q₂₂)(Q₂₃), -N(Q₂₁)(Q₂₂), -B(Q₂₁)(Q₂₂), - C(=O)(Q₂₁), -S(=O)₂(Q₂₁), -P(=O)(Q₂₁)(Q₂₂), or any combination thereof; or
-Si(Q₃₁)(Q₃₂)(Q₃₃), -N(Q₃₁)(Q₃₂), -B(Q₃₁)(Q₃₂), -C(=O)(Q₃₁), -S(=O)₂(Q₃₁), or - P(=O)(Q₃₁)(Q₃₂).
Q₁ to Q₃, Q₁₁ to Q₁₃, Q₂₁ to Q₂₃, and Q₃₁ to Q₃₃ used herein may each independently be: hydrogen; deuterium; -F; -Cl; -Br; -I; a hydroxyl group; a cyano group; a nitro group; a C₁-C₆₀ alkyl group; a C₂-C₆₀ alkenyl group; a C₂-C₆₀ alkynyl group; a C₁-C₆₀ alkoxy group; a C₃-C₆₀ carbocyclic group or a C₁-C₆₀ heterocyclic group, each unsubstituted or substituted with deuterium, -F, a cyano group, a C₁-C₆₀ alkyl group, a C₁-C₆₀ alkoxy group, a phenyl group, a biphenyl group, or any combination thereof; a C₇-C₆₀ arylalkyl group; or a C₂-C₆₀ heteroarylalkyl group.

The term "heteroatom" as used herein refers to any atom other than a carbon atom or a hydrogen atom. Examples of the heteroatom may include O, S, N, P, Si, B, Ge, Se, or any combination thereof.

The term "third-row transition metal" used herein includes hafnium (Hf), tantalum (Ta), tungsten (W), rhenium (Re), osmium (Os), iridium (Ir), platinum (Pt), gold (Au), and/or the like.

The term "Ph" as used herein refers to a phenyl group, the term "Me" as used herein refers to a methyl group, the term "Et" as used herein refers to an ethyl group, the term "tert-Bu" or "Bu^{t}" as used herein refers to a tert-butyl group, and the term "OMe" as used herein refers to a methoxy group.

The term "biphenyl group" as used herein refers to "a phenyl group substituted with a phenyl group." For example, the "biphenyl group" is a substituted phenyl group having a C₆-C₆₀ aryl group as a substituent.

The term "terphenyl group" as used herein refers to "a phenyl group substituted with a biphenyl group." For example, the "terphenyl group" is a substituted phenyl group having, as a substituent, a C₆-C₆₀ aryl group substituted with a C₆-C₆₀ aryl group, and includes an o-terphenyl group, an m-terphenyl group, and a p-terphenyl group.
* and *' as used herein, unless defined otherwise, each refer to a binding site to a neighboring atom in a corresponding formula or moiety.

The terms "x-axis", "y-axis", and "z-axis" as used herein are not limited to three axes in an orthogonal coordinate system, and may be interpreted in a broader sense than the aforementioned three axes in an orthogonal coordinate system. For example, the x-axis, y-axis, and z-axis may describe axes that are orthogonal to each other, or may describe axes that are in different directions that are not orthogonal to each other.

Terms such as "substantially," "about," and "approximately" are used as relative terms and not as terms of degree, and are intended to account for the inherent deviations in measured or calculated values that would be recognized by those of ordinary skill in the art. They may be inclusive of the stated value and an acceptable range of deviation as determined by one of ordinary skill in the art, considering the limitations and error associated with measurement of that quantity. For example, "about" may refer to one or more standard deviations, or ± 30%, 20%, 10%, 5% of the stated value.

Numerical ranges disclosed herein include and are intended to disclose all subsumed sub-ranges of the same numerical precision. For example, a range of "1.0 to 10.0" includes all subranges having a minimum value equal to or greater than 1.0 and a maximum value equal to or less than 10.0, such as, for example, 2.4 to 7.6.

The light-emitting device, the electronic device, apparatus and/or equipment, a device of manufacturing thereof, and/or any other relevant devices or components according to embodiments of the present disclosure described herein may be implemented utilizing any suitable hardware, firmware (e.g., an application-specific integrated circuit), software, or a combination of software, firmware, and hardware. For example, the one or more suitable components of the light-emitting device and/or the electronic apparatus, may be formed on one integrated circuit (IC) chip or on separate IC chips. Further, the one or more suitable components of the light-emitting device, the electronic device and/or the electronic apparatus may be implemented on a flexible printed circuit film, a tape carrier package (TCP), a printed circuit board (PCB), or formed on one substrate. Further, the one or more suitable components of the device and/or apparatus may be a process or thread, running on one or more processors, in one or more computing devices, executing computer program instructions and interacting with other system components for performing the one or more suitable functionalities described herein. The computer program instructions are stored in a memory which may be implemented in a computing device using a standard memory device, such as, for example, a random access memory (RAM). The computer program instructions may also be stored in other non-transitory computer readable media such as, for example, a CD-ROM, flash drive, or the like. Also, a person of skill in the art should recognize that the functionality of one or more suitable computing devices may be combined or integrated into a single computing device, or the functionality of a particular computing device may be distributed across one or more other computing devices without departing from the scope of the embodiments of the present disclosure.

Hereinafter, compounds according to one or more embodiments and light-emitting devices according to one or more embodiments will be described in more detail with reference to Synthesis Examples and Examples. The wording "B was used instead of A" used in describing Synthesis Examples refers to that an substantially identical molar equivalent of B was used in place of A.

### Examples

### Synthesis Example 1 (Compound 1)

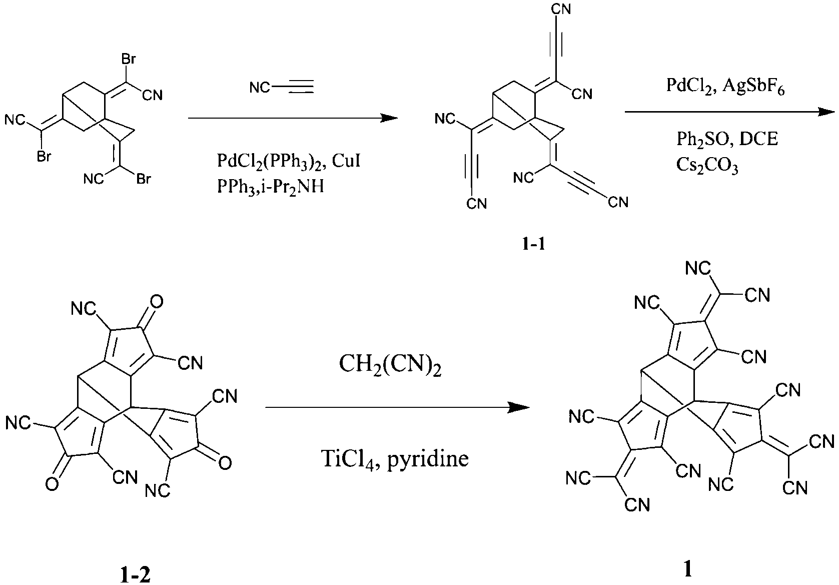

### Synthesis of Intermediate 1-1

In a nitrogen atmosphere, (2E,2'E,2"E)-2,2',2"-(bicyclo[2.2.2]octane-2,5,7-triylidene)tris(2-bromoacetonitrile) (1 eq), propiolonitrile (3 eq), PdCl₂(PPh₃)₂ (0.05 eq), copper iodide (0.05 eq), triphenylphosphine (0.1 eq), and diisopropylamine (0.2 eq) were dissolved in toluene and stirred at 50 °C for 24 hours. After cooling, the mixture was washed with ethyl acetate and water each for three times and separated, and the resultant organic layer was dried with MgSO₄ first and then dried again under reduced pressure. The resultant was purified by column chromatography to thereby obtain Intermediate 1-1. (Yield: 61 %)

### Synthesis of Intermediate 1-2

Intermediate 1-1 (1 eq), PdCl₂ (0.05 eq), silver hexafluoroantimonate(V) (0.1 eq), and diphenylsulfoxide (3 eq) were dissolved in dichloroethylene and stirred at 60 °C for 24 hours. Then, after Cs₂CO₃ (0.05 eq) was added thereto, the mixture was stirred for 12 hours. Subsequently, the mixture was subjected to an extraction process using dichloromethane, and the resultant was added to 35% hydrochloric acid and stirred for 2 hours. After cooling, the mixture was subjected to an extraction process using dichloromethane and NH₄Cl aqueous solution, and the resultant organic layer was dried with MgSO₄ under reduced pressure. The resultant was subjected to column chromatography to thereby obtain Intermediate 1-2. (Yield: 40 %)

### Synthesis of Compound 1

Intermediate 1-2 (1 eq), malononitrile (3 eq), and dichloromethane were stirred for 30 minutes in a nitrogen atmosphere. After titanium tetrachloride (3 eq) was slowly injected thereto, pyridine was added thereto, and the mixture was stirred at room temperature. After cooling, the mixture was subjected to an extraction process using dichloromethane and NH₄Cl aqueous solution, and the resultant organic layer was dried with MgSO₄ under reduced pressure. The resultant was subjected to column chromatography to thereby obtain Compound 1. (Yield: 2.4%)

The resultant compound was identified through MS/FAB.

### Compound 1: C₃₂H₂N₁₂ cal. 554.05, found 554.06

### Synthesis Example 2 (Compound 17)

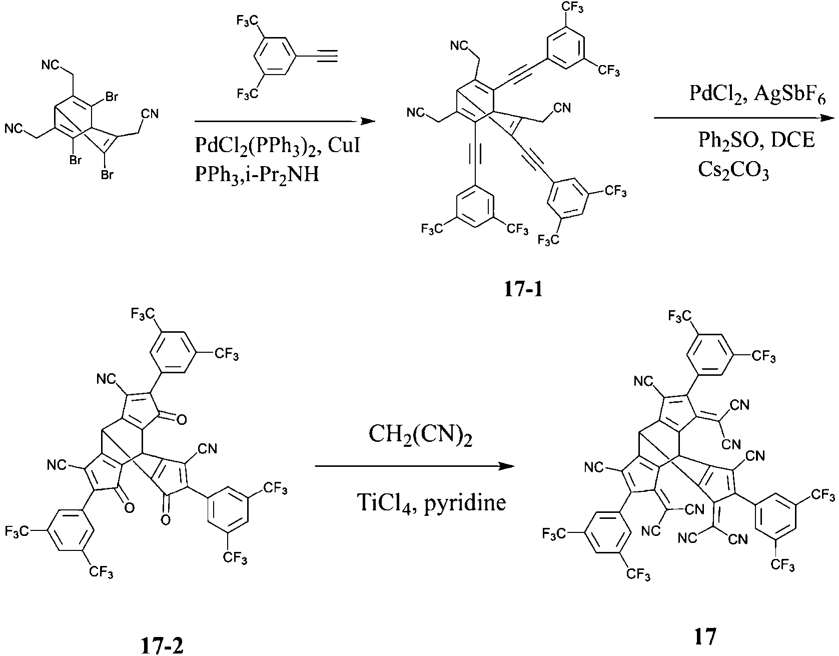

### Synthesis of Intermediate 17-1

In a nitrogen atmosphere, 2,2',2"-(3,6,8-tribromobicyclo[2.2.2]octa-2,5,7-triene-2,5,7-triyl)triacetonitrile (1 eq), 1-ethynyl-3,5-bis(trifluoromethyl)benzene (3 eq), PdCl₂(PPh₃)₂ (0.05 eq), copper iodide (0.05 eq), triphenylphosphine (0.1 eq), and diisopropylamine (0.2 eq) were dissolved in toluene and stirred at 50 °C for 24 hours. After cooling, the mixture was washed with ethyl acetate and water each for three times and separated, and the resultant organic layer was dried with MgSO₄ first and then dried again under reduced pressure. The resultant was purified by column chromatography to thereby obtain Intermediate 17-1. (Yield: 53%)

### Synthesis of Intermediate 17-2

Intermediate 17-1 (1 eq), PdCl₂ (0.05 eq), silver hexafluoroantimonate(V) (0.1 eq), and diphenylsulfoxide (3 eq) were dissolved in dichloroethylene and stirred at 60 °C for 24 hours. Then, after Cs₂CO₃ (0.05 eq) was added thereto, the mixture was stirred for 12 hours. Subsequently, the mixture was subjected to an extraction process using dichloromethane, and the resultant was added to 35% hydrochloric acid and stirred for 2 hours. After cooling, the mixture was subjected to an extraction process using dichloromethane and NH₄Cl aqueous solution, and the resultant organic layer was dried with MgSO₄ under reduced pressure. The resultant was subjected to column chromatography to thereby obtain Intermediate 17-2. (Yield: 33%)

### Synthesis of Compound 17

Intermediate 17-2 (1 eq), malononitrile (3 eq), and dichloromethane were stirred for 30 minutes in a nitrogen atmosphere. After titanium tetrachloride (3 eq) was slowly injected thereto, pyridine was added thereto, and the mixture was stirred at room temperature. After cooling, the mixture was subjected to an extraction process using dichloromethane and NH₄Cl aqueous solution, and the resultant organic layer was dried with MgSO₄ under reduced pressure. The resultant was subjected to column chromatography to thereby obtain Compound 17. (Yield: 1.5%)

The resultant compound was identified through MS/FAB.

### Compound 17: C₅₃H₁₁F₁₈N₉ cal. 1115.08, found 1115.10

### Synthesis Example 3 (Compound 21)

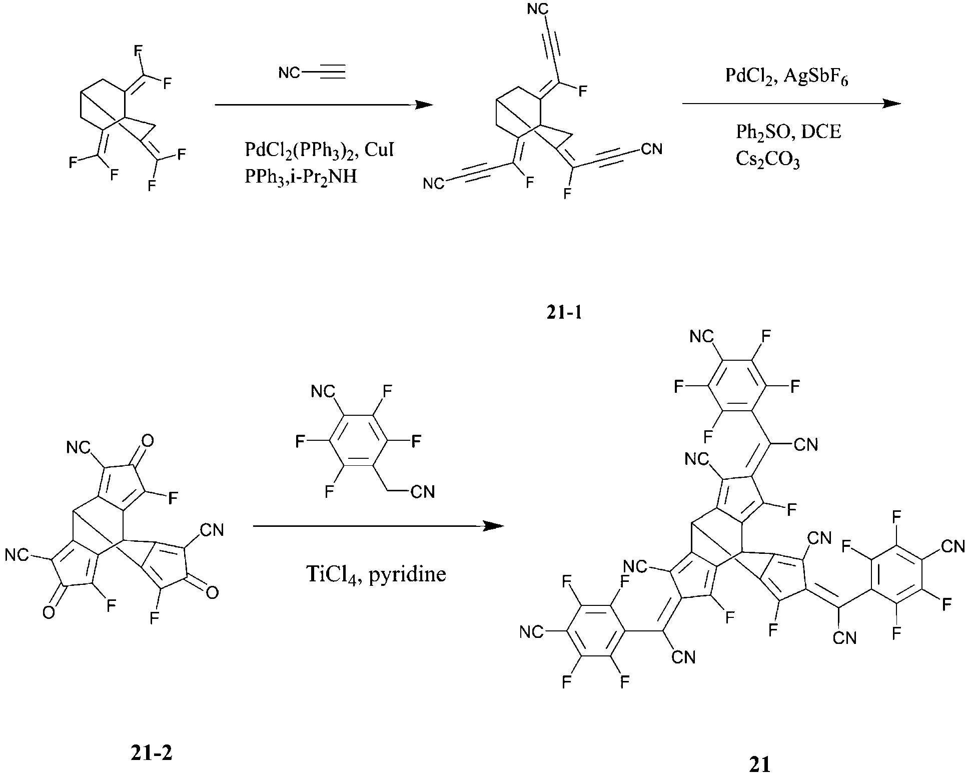

### Synthesis of Intermediate 21-1

In a nitrogen atmosphere, (2E,5E,7E)-2,5,7-tris( difluoromethylene)bicyclo[2.2.2]octane (1 eq), propiolonitrile (3 eq), PdCl₂(PPh₃)₂ (0.05 eq), copper iodide (0.05 eq), triphenylphosphine (0.1 eq), and diisopropylamine (0.2 eq) were dissolved in toluene and stirred at 40 °C for 24 hours. After cooling, the mixture was washed with ethyl acetate and water each for three times and separated, and the resultant organic layer was dried with MgSO₄ first and then dried again under reduced pressure. The resultant was purified by column chromatography to thereby obtain Intermediate 21-1. (Yield: 56%)

### Synthesis of Intermediate 21-2

Intermediate 21-1 (1 eq), PdCl₂ (0.05 eq), silver hexafluoroantimonate(V) (0.1 eq), and diphenylsulfoxide (3 eq) were dissolved in dichloroethylene and stirred at 60 °C for 24 hours. Then, after Cs₂CO₃ (0.05 eq) was added thereto, the mixture was stirred for 12 hours. Subsequently, the mixture was subjected to an extraction process using dichloromethane, and the resultant was added to 35% hydrochloric acid and stirred for 2 hours. After cooling, the mixture was subjected to an extraction process using dichloromethane and NH₄Cl aqueous solution, and the resultant organic layer was dried with MgSO₄ under reduced pressure. The resultant was subjected to column chromatography to thereby obtain Intermediate 21-2. (Yield: 37 %)

### Synthesis of Compound 21

Intermediate 21-2 (1 eq), 4-(cyanomethyl)-2,3,5,6-tetrafluorobenzonitrile (3 eq), and dichloromethane were stirred for 30 minutes in a nitrogen atmosphere. After titanium tetrachloride (3 eq) was slowly injected thereto, pyridine was added thereto, and the mixture was stirred at room temperature. After cooling, the mixture was subjected to an extraction process using dichloromethane and NH₄Cl aqueous solution, and the resultant organic layer was dried with MgSO₄ under reduced pressure. The resultant was subjected to column chromatography to thereby obtain Compound 21. (Yield: 1.7%)

The resultant compound was identified through MS/FAB.

### Compound 21: C₄₇H₂F₁₅N₉ cal. 977.02, found 977.04

### Synthesis Example 4 (Compound 31)

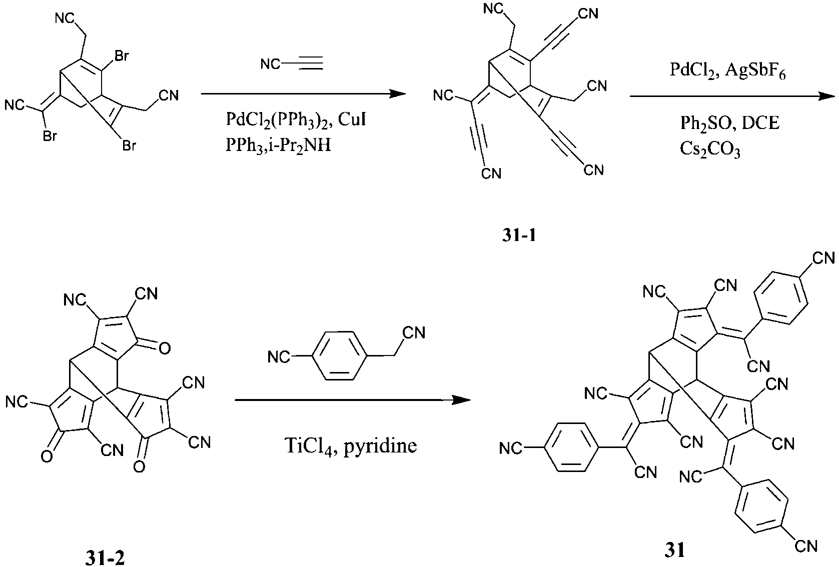

### Synthesis of Intermediate 31-1

In a nitrogen atmosphere, (E)-2,2'-(3,6-dibromo-7-(bromo(cyano)methylene)bicyclo[2.2.2]octa-2,5-diene-2,5-diyl)diacetonitrile (1 eq), propiolonitrile (3 eq), PdCl₂(PPh₃)₂ (0.05 eq), copper iodide (0.05 eq), triphenylphosphine (0.1 eq), and diisopropylamine (0.2 eq) were dissolved in toluene and stirred at 50 °C for 24 hours. After cooling, the mixture was washed with ethyl acetate and water each for three times and separated, and the resultant organic layer was dried with MgSO₄ first and then dried again under reduced pressure. The resultant was purified by column chromatography to thereby obtain Intermediate 31-1. (Yield: 58%)

### Synthesis of Intermediate 31-2

Intermediate 31-1 (1 eq), PdCl₂ (0.05 eq), silver hexafluoroantimonate(V) (0.1 eq), and diphenylsulfoxide (3 eq) were dissolved in dichloroethylene and stirred at 60 °C for 24 hours. Then, after Cs₂CO₃ (0.05 eq) was added thereto, the mixture was stirred for 12 hours. Subsequently, the mixture was subjected to an extraction process using dichloromethane, and the resultant was added to 35% hydrochloric acid and stirred for 2 hours. After cooling, the mixture was subjected to an extraction process using dichloromethane and NH₄Cl aqueous solution, and the resultant organic layer was dried with MgSO₄ under reduced pressure. The resultant was subjected to column chromatography to thereby obtain Intermediate 31-2. (Yield: 39 %)

### Synthesis of Compound 31

Intermediate 31-2 (1 eq), 4-(cyanomethyl)benzonitrile (3 eq), and dichloromethane were stirred for 30 minutes in a nitrogen atmosphere. After titanium tetrachloride (3 eq) was slowly injected thereto, pyridine was added thereto, and the mixture was stirred at room temperature. After cooling, the mixture was subjected to an extraction process using dichloromethane and NH₄Cl aqueous solution, and the resultant organic layer was dried with MgSO₄ under reduced pressure. The resultant was subjected to column chromatography to thereby obtain Compound 31. (Yield: 2.2%)

The resultant compound was identified through MS/FAB.

### Compound 31: C₅₀H₁₄N₁₂ cal. 782.15, found 782.16

Synthesis methods of other compounds in addition to the compounds synthesized in Synthesis Examples 1 to 4 may be easily recognized by those skilled in the art by referring to the synthesis paths and source materials.

### Evaluation Example 1

By using methods described in Table 1, lowest unoccupied molecular orbital (LUMO), highest occupied molecular orbital (HOMO), maximum absorption wavelength, and glass transition temperature (T_{g}) values of the compounds of Synthesis Examples were measured, and the results are shown in Table 2.

**Table 1**

| | |
|---|---|
| HOMO energy level evaluation method | By using cyclic voltammetry (CV) (electrolyte: 0.1 molarity (M)Bu₄NPF₆ / solvent: dimethylforamide (DMF) / electrode: 3-electrode system (working electrode: GC, reference electrode: Ag/AgCl, and auxiliary electrode: Pt)), the potential (V)-current (A) graph of each compound was obtained, and then, from the oxidation onset of the graph, the HOMO energy level of each compound was calculated. |
| LUMO energy level evaluation method | By using cyclic voltammetry (CV) (electrolyte: 0.1 M Bu₄NPF₆ / solvent: dimethylforamide (DMF) / electrode: 3-electrode system (working electrode: GC, reference electrode: Ag/AgCl, and auxiliary electrode: Pt)), the potential (V)-current (A) graph of each compound was obtained, and then, from the reduction onset of the graph, the LUMO energy level of each compound was calculated. |
| Hole mobility and electron mobility | The hole mobility and electron mobility of each compound were evaluated by using the space-charge-limited current (SCLC) method described in "Hole mobility of N,N'-bis(naphtanlen-1-yl)-N,N'-bis(phenyl)benzidine investigated by using space-charge-limited currents, Appl. Phys. Lett. 90, 203512 (2007)," the entire content of which is herein incorporated by reference. |
| Glass transition temperature (T_{g}) | Glass transition temperature (T_{g}) characteristics of each compoud were analyzed using differential scanning calorimetry (DSC). During the analysis, a sample having a weight of 5 mg was heated from room temperature to 300 °C at a scan rate of 10 °C/min, cooled from 300 °C to 25 °C at a scan rate of 10 °C/min, and then heated again to 300 °C at a scan rate of 10 °C/min. In this regard, the glass transition temperature of the compound was measured during the second heating and was obtained from the inflection point on the graph obtained by the analysis. |

**Table 2**

| Compound | HOMO (eV) | LUMO (eV) | Hole mobility (cm²/Vs) | Electron mobility (cm²/Vs) | Glass transition temperature (T_{g}, °C) |
|---|---|---|---|---|---|
| Synthesis Example 1 | -8.57 | -5.99 | 9.0E-04 | 8.4E-03 | 126 |
| Synthesis Example 2 | -7.36 | -5.39 | 2.0E-04 | 9.6E-03 | 147 |
| Synthesis Example 3 | -7.89 | -5.11 | 2.5E-04 | 5.3E-03 | 153 |
| Synthesis Example 4 | -7.94 | -5.18 | 9.2E-04 | 1.4E-03 | 140 |

### Example 1

As an anode, a glass substrate (product of Corning Inc.) with a 15 ohm per square centimeter (Ω/cm²) (1,300 angstrom (Å)) ITO electrode formed thereon was cut to a size of 50 millimeter (mm) x 50 mm x 0.7 mm, sonicated by using isopropyl alcohol and pure water each for 5 minutes, cleaned by irradiation of ultraviolet rays and exposure of ozone thereto for 30 minutes, and then mounted on a vacuum deposition apparatus.

Compound 1 and HT3 were deposited on the anode at a weight ratio of 3:97 to form a hole injection layer having a thickness of 100 Å, and HT40 was deposited on the hole injection layer to form a hole transport layer having a thickness of 1,250 Å.

H125, H126, and D1 were co-deposited on the hole transport layer at a weight ratio of 45:45:10 to form an emission layer having a thickness of 300 Å, ET37 was deposited on the emission layer to form a buffer layer having a thickness of 50 Å, and ET46 and LiQ were deposited on the buffer layer at a weight ratio of 1:1 to form an electron transport layer having a thickness of 310 Å. Yb was deposited on the electron transport layer to form an electron injection layer having a thickness of 15 Å. Subsequently, Ag and Mg were deposited thereon at a weight ratio of 1:1 to form a cathode having a thickness of 1,000 Å.

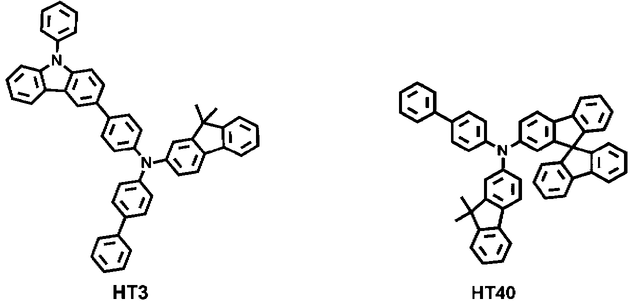

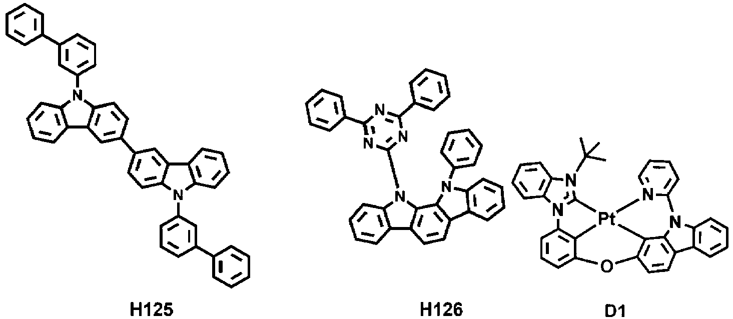

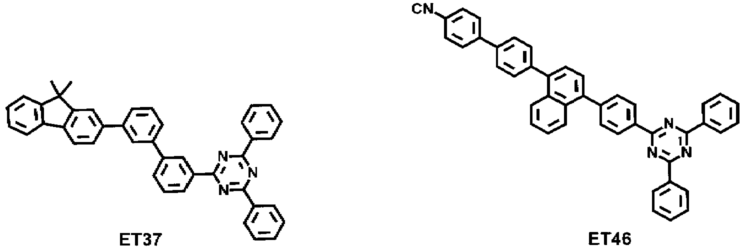

### Examples 2 to 4 and Comparative Examples 1 to 7

Light-emitting devices of Examples 2 to 4 and Comparative Examples 1 to 7 were manufactured in substantially the same manner as in Example 1, except that Compounds 17, 21, and 31 and Comparative Example Compounds 1 to 7 were each used instead of Compound 1 used in Example 1.

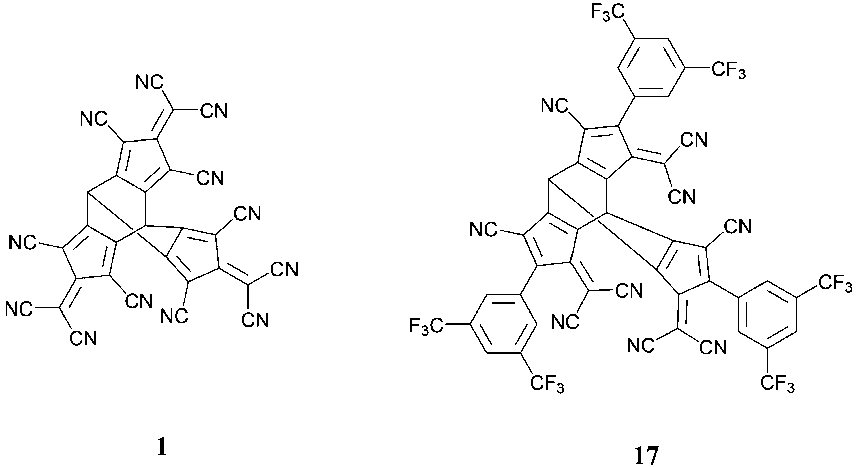

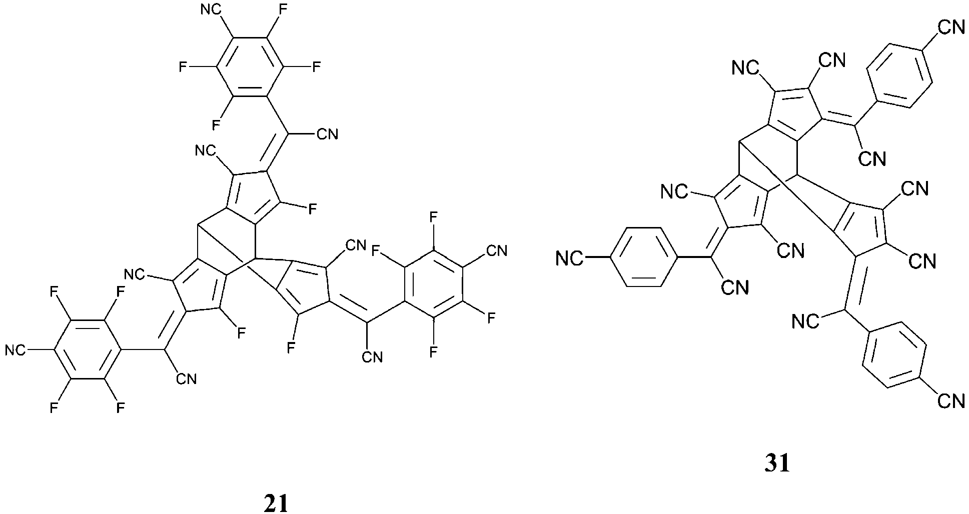

### Comparative Example Compound 1

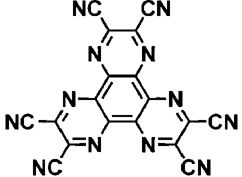

### Comparative Example Compound 2

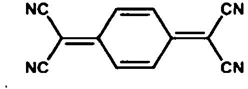

### Comparative Example Compound 3

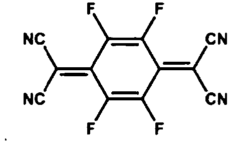

### Comparative Example Compound 4

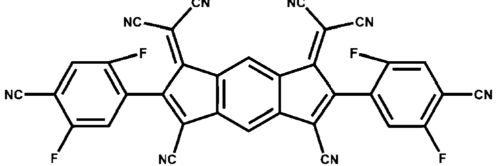

### Comparative Example Compound 5

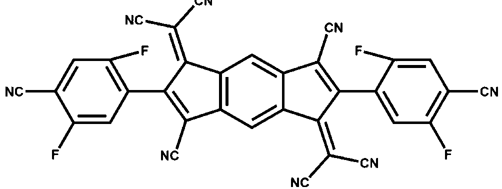

### Comparative Example Compound 6

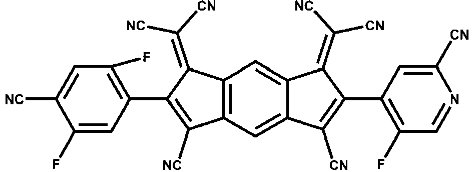

### Comparative Example Compound 7

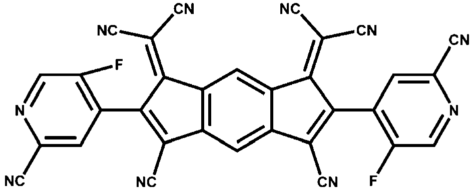

### Evaluation Example 2

To evaluate characteristics of the light-emitting devices manufactured according to Examples 1 to 4 and Comparative Examples 1 to 7, the driving voltage, current efficiency, and device lifespan thereof at a current density of 10 milliampere per square centimeter (mA/cm²) were measured, and the results are shown in Table 3. The driving voltage of each light-emitting device was measured using a source meter (Keithley Instrument Inc., 2400 series), and the current efficiency thereof was measured using a luminance meter CS-2000 (Konica Minolta Inc.). In some embodiments, to measure the device lifespan, the time taken for each device to reach 95% of the initial luminance was measured. The device lifespan values are expressed as relative values (%).

**Table 3**

| | Driving voltage (V) | Current efficiency (cd/A) | Relative lifespan (T95, %) |
|---|---|---|---|
| Example 1 | 3.5 | 17.3 | 122 % |
| Example 2 | 3.3 | 17.6 | 124 % |
| Example 3 | 3.4 | 17.5 | 123 % |
| Example 4 | 3.4 | 17.5 | 124 % |
| Comparative Example 1 | 4.2 | 16.9 | 115 % |
| Comparative Example 2 | 4.3 | 16.2 | 112 % |
| Comparative Example 3 | 4.2 | 16.5 | 114 % |
| Comparative Example 4 | 4.0 | 16.7 | 117 % |
| Comparative Example 5 | 3.9 | 16.8 | 118 % |
| Comparative Example 6 | 3.8 | 16.9 | 117 % |
| Comparative Example 7 | 3.7 | 16.7 | 116 % |

According to one or more embodiments, the use of a condensed cyclic compound may enable the manufacture of a light-emitting device having high efficiency and a long lifespan and a high-quality electronic apparatus including the light-emitting device.

In the context of the present application and unless otherwise defined, the terms "use," "using," and "used" may be considered synonymous with the terms "utilize," "utilizing," and "utilized," respectively.

A person of ordinary skill in the art, in view of the present disclosure in its entirety, would appreciate that each suitable feature of the one or more suitable embodiments of the present disclosure may be combined or combined with each other, partially or entirely, and may be technically interlocked and operated in one or more suitable ways, and each embodiment may be implemented independently of each other or in conjunction with each other in any suitable manner unless otherwise stated or implied.

It should be understood that embodiments described herein should be considered in a descriptive sense only and not for purposes of limitation. Descriptions of features or aspects within each embodiment should typically be considered as available for other similar features or aspects in one or more embodiments. While one or more embodiments have been described with reference to the drawings, it will be understood by those of ordinary skill in the art that one or more suitable changes in form and details may be made therein without departing from the scope as defined by the following claims and equivalents thereof.

## Claims

1. A light-emitting device (10) comprising:
a first electrode (110);
a second electrode (150) opposite to the first electrode (110);
an interlayer (130) between the first electrode (110) and the second electrode (150) and comprising an emission layer; and
a condensed cyclic compound represented by Formula 1: 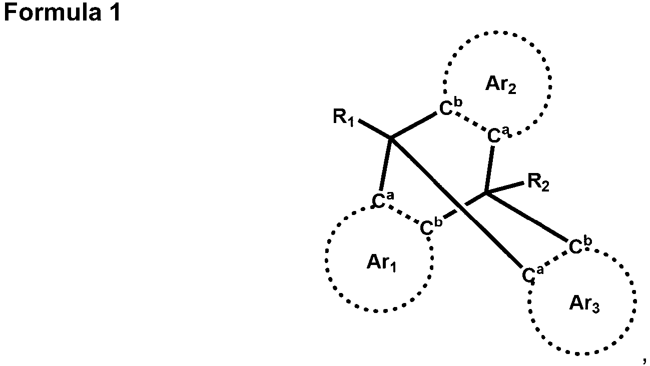
wherein, in Formula 1,
Ar₁ to Ar₃ are each independently any one selected from among groups represented by Formulae 2-1 to 2-3,
when Ar₁ to Ar₃ are rings represented by a same formula, the rings are substantially identical to or different from each other, 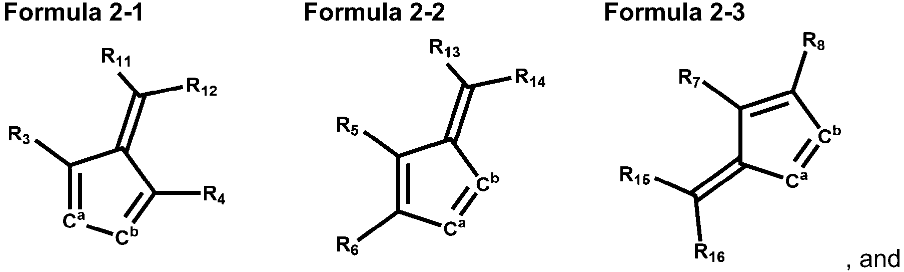
wherein, in Formulae 1 and 2-1 to 2-3,
R₁ to R₈ and R₁₁ to R₁₆ are each independently hydrogen, deuterium, -F, -Cl, - Br, -I, a hydroxyl group, a cyano group, a nitro group, a C₁-C₆₀ alkyl group unsubstituted or substituted with at least one R₁₀₂, a C₂-C₆₀ alkenyl group unsubstituted or substituted with at least one R₁₀ₐ, a C₂-C₆₀ alkynyl group unsubstituted or substituted with at least one R₁₀ₐ, a C₁-C₆₀ alkoxy group unsubstituted or substituted with at least one R₁₆ₐ, a C₃-C₆₀ carbocyclic group unsubstituted or substituted with at least one R₁₆ₐ, a C₁-C₆₀ heterocyclic group unsubstituted or substituted with at least one R₁₀ₐ, - C(Q₁)(Q₂)(Q₃), -Si(Q₁)(Q₂)(Q₃), -N(Q₁)(Q₂), -B(Q₁)(Q₂), -C(=O)(Q₁), -S(=O)₂(Q₁), or - P(=O)(Q₁)(Q₂),
C^{a} and C^{b} in Formula 1 represent carbon atoms,
R₁₀ₐ is:
deuterium, -F, -Cl, -Br, -I, a hydroxyl group, a cyano group, or a nitro group;
a C₁-C₆₀ alkyl group, a C₂-C₆₀ alkenyl group, a C₂-C₆₀ alkynyl group, or a C₁-C₆₀ alkoxy group, each unsubstituted or substituted with deuterium, -F, -Cl, -Br, -I, a hydroxyl group, a cyano group, a nitro group, a C₃-C₆₀ carbocyclic group, a C₁-C₆₀ heterocyclic group, a C₆-C₆₀ aryloxy group, a C₆-C₆₀ arylthio group, a C₇-C₆₀ arylalkyl group, a C₂-C₆₀ heteroarylalkyl group, -Si(Q₁₁)(Q₁₂)(Q₁₃), -N(Q₁₁)(Q₁₂), -B(Q₁₁)(Q₁₂), - C(=O)(Q₁₁), -S(=O)₂(Q₁₁), -P(=O)(Q₁₁)(Q₁₂), or any combination thereof;
a C₃-C₆₀ carbocyclic group, a C₁-C₆₀ heterocyclic group, a C₆-C₆₀ aryloxy group, a C₆-C₆₀ arylthio group, a C₇-C₆₀ arylalkyl group, or a C₂-C₆₀ heteroarylalkyl group, each unsubstituted or substituted with deuterium, -F, -Cl, -Br, -I, a hydroxyl group, a cyano group, a nitro group, a C₁-C₆₀ alkyl group, a C₂-C₆₀ alkenyl group, a C₂-C₆₀ alkynyl group, a C₁-C₆₀ alkoxy group, a C₃-C₆₀ carbocyclic group, a C₁-C₆₀ heterocyclic group, a C₆-C₆₀ aryloxy group, a C₆-C₆₀ arylthio group, a C₇-C₆₀ arylalkyl group, a C₂-C₆₀ heteroarylalkyl group, -Si(Q₂₁)(Q₂₂)(Q₂₃), -N(Q₂₁)(Q₂₂), -B(Q₂₁)(Q₂₂), -C(=O)(Q₂₁), - S(=O)₂(Q₂₁), -P(=O)(Q₂₁)(Q₂₂), or any combination thereof; or
-Si(Q₃₁)(Q₃₂)(Q₃₃), -N(Q₃₁)(Q₃₂), -B(Q₃₁)(Q₃₂), -C(=O)(Q₃₁), -S(=O)₂(Q₃₁), or - P(=O)(Q₃₁)(Q₃₂),
Q₁ to Q₃, Q₁₁ to Q₁₃, Q₂₁ to Q₂₃, and Q₃₁ to Q₃₃ are each independently: hydrogen; deuterium; -F; -Cl; -Br; -I; a hydroxyl group; a cyano group; a nitro group; or a C₁-C₆₀ alkyl group, a C₂-C₆₀ alkenyl group, a C₂-C₆₀ alkynyl group, a C₁-C₆₀ alkoxy group, a C₃-C₆₀ carbocyclic group, or a C₁-C₆₀ heterocyclic group, each unsubstituted or substituted with deuterium, -F, a cyano group, a C₁-C₆₀ alkyl group, a C₁-C₆₀ alkoxy group, a phenyl group, a biphenyl group, or any combination thereof, and
C^{a} and C^{b} in Formulae 2-1 to 2-3 are carbon atoms corresponding to C^{a} and C^{b} in Formula 1, respectively.

2. The light-emitting device (10) of claim 1, wherein the first electrode (110) is an anode,
the second electrode (150) is a cathode,
the interlayer (130) further comprises a hole transport region between the first electrode (110) and the emission layer and an electron transport region between the emission layer and the second electrode (150),
the hole transport region comprises a hole injection layer, a hole transport layer, an emission auxiliary layer, an electron-blocking layer, or any combination thereof, and
the electron transport region comprises a buffer layer, a hole-blocking layer, an electron transport layer, an electron injection layer, an electron control layer, or any combination thereof.

3. The light-emitting device (10) of claim 2, wherein the condensed cyclic compound is in the hole transport region.

4. An electronic apparatus comprising the light-emitting device (10) of claim 1 to 3.

5. An electronic equipment (1) comprising the light-emitting device (10) of claim 1 to 3.

6. The electronic equipment of claim 5, wherein the electronic equipment is at least one selected from among a flat panel display, a curved display, a computer monitor, a medical monitor, a television, a billboard, an indoor light, an outdoor light, a signal light, a head-up display, a fully or partially transparent display, a flexible display, a rollable display, a foldable display, a stretchable display, a laser printer, a telephone, a mobile phone, a tablet, a phablet, a personal digital assistant (PDA), a wearable device, a laptop computer, a digital camera, a camcorder, a viewfinder, a micro display, a 3D display, a virtual reality display, an augmented reality display, a vehicle, a video wall comprising multiple displays tiled together, a theater screen, a stadium screen, a phototherapy device, a signboard and a combination thereof.

7. A condensed cyclic compound,
wherein the condensed cyclic compound is represented by Formula 1: 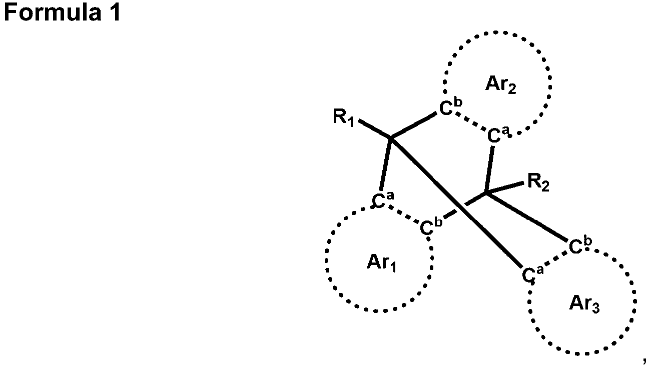
wherein, in Formula 1,
Ar₁ to Ar₃ are each independently any one of groups represented by Formulae 2-1 to 2-3,
when Ar₁ to Ar₃ are rings represented by a same formula, the rings are substantially identical to or different from each other, 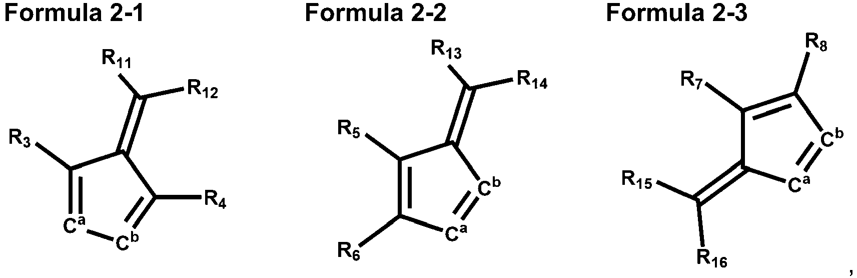
wherein, in Formulae 1 and 2-1 to 2-3,
R₁ to R₈ and R₁₁ to R₁₆ are each independently hydrogen, deuterium, -F, -Cl, - Br, -I, a hydroxyl group, a cyano group, a nitro group, a C₁-C₆₀ alkyl group unsubstituted or substituted with at least one R₁₆ₐ, a C₂-C₆₀ alkenyl group unsubstituted or substituted with at least one R₁₀ₐ, a C₂-C₆₀ alkynyl group unsubstituted or substituted with at least one R₁₆ₐ, a C₁-C₆₀ alkoxy group unsubstituted or substituted with at least one R₁₆ₐ, a C₃-C₆₀ carbocyclic group unsubstituted or substituted with at least one R₁₆ₐ, a C₁-C₆₀ heterocyclic group unsubstituted or substituted with at least one R₁₆ₐ, - C(Q₁)(Q₂)(Q₃), -Si(Q₁)(Q₂)(Q₃), -N(Q₁)(Q₂), -B(Q₁)(Q₂), -C(=O)(Q₁), -S(=O)₂(Q₁), or - P(=O)(Q₁)(Q₂),
C^{a} and C^{b} in Formula 1 represent carbon atoms,
R₁₀ₐ is:
deuterium, -F, -Cl, -Br, -I, a hydroxyl group, a cyano group, or a nitro group;
a C₁-C₆₀ alkyl group, a C₂-C₆₀ alkenyl group, a C₂-C₆₀ alkynyl group, or a C₁-C₆₀ alkoxy group, each unsubstituted or substituted with deuterium, -F, -Cl, -Br, -I, a hydroxyl group, a cyano group, a nitro group, a C₃-C₆₀ carbocyclic group, a C₁-C₆₀ heterocyclic group, a C₆-C₆₀ aryloxy group, a C₆-C₆₀ arylthio group, a C₇-C₆₀ arylalkyl group, a C₂-C₆₀ heteroarylalkyl group, -Si(Q₁₁)(Q₁₂)(Q₁₃), -N(Q₁₁)(Q₁₂), -B(Q₁₁)(Q₁₂), - C(=O)(Q₁₁), -S(=O)₂(Q₁₁), -P(=O)(Q₁₁)(Q₁₂), or any combination thereof;
a C₃-C₆₀ carbocyclic group, a C₁-C₆₀ heterocyclic group, a C₆-C₆₀ aryloxy group, a C₆-C₆₀ arylthio group, a C₇-C₆₀ arylalkyl group, or a C₂-C₆₀ heteroarylalkyl group, each unsubstituted or substituted with deuterium, -F, -Cl, -Br, -I, a hydroxyl group, a cyano group, a nitro group, a C₁-C₆₀ alkyl group, a C₂-C₆₀ alkenyl group, a C₂-C₆₀ alkynyl group, a C₁-C₆₀ alkoxy group, a C₃-C₆₀ carbocyclic group, a C₁-C₆₀ heterocyclic group, a C₆-C₆₀ aryloxy group, a C₆-C₆₀ arylthio group, a C₇-C₆₀ arylalkyl group, a C₂-C₆₀ heteroarylalkyl group, -Si(Q₂₁)(Q₂₂)(Q₂₃), -N(Q₂₁)(Q₂₂), -B(Q₂₁)(Q₂₂), -C(=O)(Q₂₁), - S(=O)₂(Q₂₁), -P(=O)(Q₂₁)(Q₂₂), or any combination thereof; or
-Si(Q₃₁)(Q₃₂)(Q₃₃), -N(Q₃₁)(Q₃₂), -B(Q₃₁)(Q₃₂), -C(=O)(Q₃₁), -S(=O)₂(Q₃₁), or - P(=O)(Q₃₁)(Q₃₂),
Q₁ to Q₃, Q₁₁ to Q₁₃, Q₂₁ to Q₂₃, and Q₃₁ to Q₃₃ are each independently: hydrogen; deuterium; -F; -Cl; -Br; -I; a hydroxyl group; a cyano group; a nitro group; or a C₁-C₆₀ alkyl group, a C₂-C₆₀ alkenyl group, a C₂-C₆₀ alkynyl group, a C₁-C₆₀ alkoxy group, a C₃-C₆₀ carbocyclic group, or a C₁-C₆₀ heterocyclic group, each unsubstituted or substituted with deuterium, -F, a cyano group, a C₁-C₆₀ alkyl group, a C₁-C₆₀ alkoxy group, a phenyl group, a biphenyl group, or any combination thereof, and
C^{a} and C^{b} in Formulae 2-1 to 2-3 are carbon atoms corresponding to C^{a} and C^{b} in Formula 1, respectively.

8. The condensed cyclic compound of claim 7, wherein at least two of Ar₁ to Ar₃ are substantially identical to each other.

9. The condensed cyclic compound of claim 7 or claim 8, wherein
the condensed cyclic compound comprises at least one cyano group, and
a number of cyano groups included in the condensed cyclic compound is 1 to 18.

10. The condensed cyclic compound of any one of claims 7 to 9, wherein R₁ to R₈ and R₁₁ to R₁₆ are each independently:
hydrogen, deuterium, -F, or a cyano group;
a methyl group, an ethyl group, an n-propyl group, an isopropyl group, an n-butyl group, a sec-butyl group, an isobutyl group, a tert-butyl group, an n-pentyl group, a tert-pentyl group, a neopentyl group, an isopentyl group, a sec-pentyl group, a 3-pentyl group, a sec-isopentyl group, an n-hexyl group, an isohexyl group, a sec-hexyl group, a tert-hexyl group, an n-heptyl group, an isoheptyl group, a sec-heptyl group, a tert-heptyl group, an n-octyl group, an isooctyl group, a sec-octyl group, a tert-octyl group, an n-nonyl group, an isononyl group, a sec-nonyl group, a tert-nonyl group, an n-decyl group, an isodecyl group, a sec-decyl group, a tert-decyl group, a methoxy group, an ethoxy group, an n-propoxy group, an isopropoxy group, an n-butoxy group, a sec-butoxy group, an isobutoxy group, a tert-butoxy group, an n-pentoxy group, a tert-pentoxy group, a 2,2-dimethylpropoxy group, an isopentoxy group, a sec-pentoxy group, or a 3-pentoxy group, each unsubstituted or substituted with deuterium, -F, a cyano group, or any combination thereof; or
a benzene group, a pentalene group, a naphthalene group, an azulene group, an indacene group, an acenaphthylene group, a phenalene group, a phenanthrene group, an anthracene group, a pyrrole group, a thiophene group, a furan group, an indole group, a benzoindole group, a naphthoindole group, an isoindole group, a benzoisoindole group, a naphthoisoindole group, a benzosilole group, a benzothiophene group, a benzofuran group, a carbazole group, a dibenzosilole group, a dibenzothiophene group, a dibenzofuran group, an indenocarbazole group, an indolocarbazole group, a benzofurocarbazole group, a benzothienocarbazole group, a benzosilolocarbazole group, a benzoindolocarbazole group, a benzocarbazole group, a benzonaphthofuran group, a benzonaphthothiophene group, a benzonaphthosilole group, a benzofurodibenzofuran group, a benzofurodibenzothiophene group, a benzothienodibenzothiophene group, a pyrazole group, an imidazole group, a triazole group, an oxazole group, an isoxazole group, an oxadiazole group, a thiazole group, an isothiazole group, a thiadiazole group, a benzopyrazole group, a benzimidazole group, a benzoxazole group, a benzoisoxazole group, a benzothiazole group, a benzoisothiazole group, a pyridine group, a pyrimidine group, a pyrazine group, a pyridazine group, a triazine group, a quinoline group, an isoquinoline group, a benzoquinoline group, a benzoisoquinoline group, a quinoxaline group, a benzoquinoxaline group, a quinazoline group, a benzoquinazoline group, a phenanthroline group, a cinnoline group, a phthalazine group, a naphthyridine group, an imidazopyridine group, an imidazopyrimidine group, an imidazotriazine group, an imidazopyrazine group, an imidazopyridazine group, an azacarbazole group, an azafluorene group, an azadibenzosilole group, an azadibenzothiophene group, or an azadibenzofuran group, each unsubstituted or substituted with deuterium, -F, a cyano group, a methyl group, an ethyl group, an n-propyl group, an isopropyl group, an n-butyl group, a sec-butyl group, an isobutyl group, a tert-butyl group, an n-pentyl group, a tert-pentyl group, a neopentyl group, an isopentyl group, a sec-pentyl group, a 3-pentyl group, a sec-isopentyl group, an n-hexyl group, an isohexyl group, a sec-hexyl group, a tert-hexyl group, an n-heptyl group, an isoheptyl group, a sec-heptyl group, a tert-heptyl group, an n-octyl group, an isooctyl group, a sec-octyl group, a tert-octyl group, an n-nonyl group, an isononyl group, a sec-nonyl group, a tert-nonyl group, an n-decyl group, an isodecyl group, a sec-decyl group, a tert-decyl group, a methoxy group, an ethoxy group, an n-propoxy group, an isopropoxy group, an n-butoxy group, a sec-butoxy group, an isobutoxy group, a tert-butoxy group, an n-pentoxy group, a tert-pentoxy group, a 2,2-dimethylpropoxy group, an isopentoxy group, a sec-pentoxy group, a 3-pentoxy group, or any combination thereof.

11. The condensed cyclic compound of any one of claims 7 to 10, wherein at least one selected from among R₁ and R₂ is hydrogen, deuterium, -F, a cyano group, or a pyridine group.

12. The condensed cyclic compound of any one of claims 7 to 11, wherein R₃ to R₈ and R₁₁ to R₁₆ are each independently:
hydrogen, deuterium, -F, or a cyano group;
a C₁-C₂₀ alkyl group or a C₁-C₂₀ alkoxy group, each unsubstituted or substituted with deuterium, -F, a cyano group, or any combination thereof; or
a group represented by Formula 3: 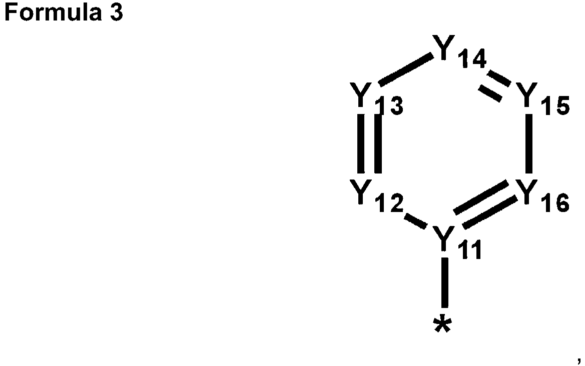 and
wherein, in Formula 3,
Y₁₁ is C or N,
Y₁₂ is C(Z₁₂) or N, Y₁₃ is C(Z₁₃) or N, Y₁₄ is C(Z₁₄) or N, Y₁₅ is C(Z₁₅) or N, and Y₁₆ is C(Z₁₆) or N,
Z₁₂ to Z₁₆ are each independently:
hydrogen, deuterium, -F, or a cyano group;
a C₁-C₂₀ alkyl group or a C₁-C₂₀ alkoxy group, each unsubstituted or substituted with deuterium, -F, a cyano group, or any combination thereof; or
a C₃-C₆₀ carbocyclic group or a C₁-C₆₀ heterocyclic group, each unsubstituted or substituted with deuterium, -F, a cyano group, a C₁-C₂₀ alkyl group, a C₁-C₂₀ alkoxy group, or any combination thereof, and
* indicates a binding site to a neighboring atom.

13. The condensed cyclic compound of claim 7, wherein R₃ to R₈ and R₁₁ to R₁₆ are each independently:
hydrogen, deuterium, -F, or a cyano group;
a methyl group, a tert-butyl group, -OCH₃, or -OC₂H₅, each unsubstituted or substituted with deuterium, -F, a cyano group, or any combination thereof; or
a group represented by any one selected from among Formulae 3-1 to 3-22: 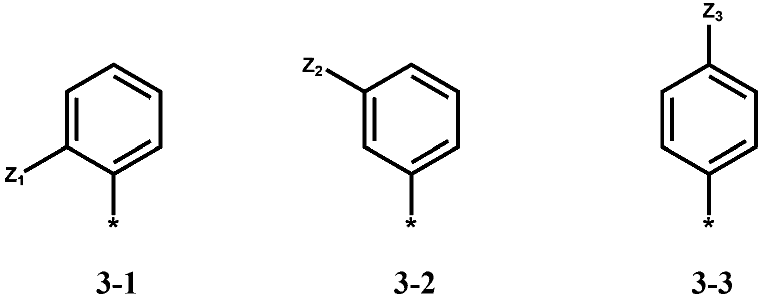 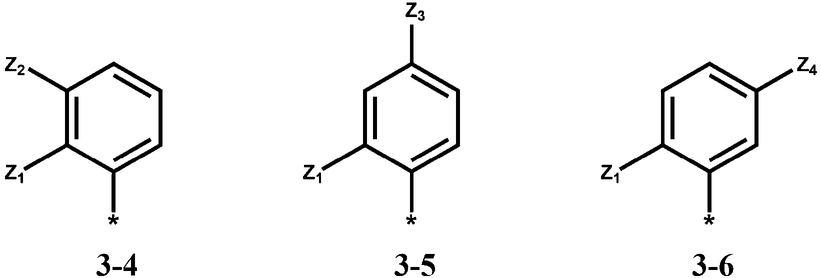 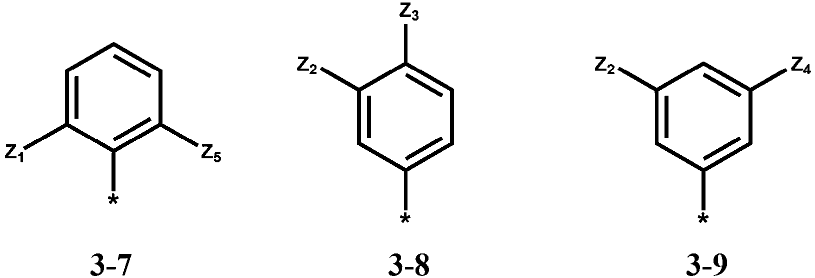 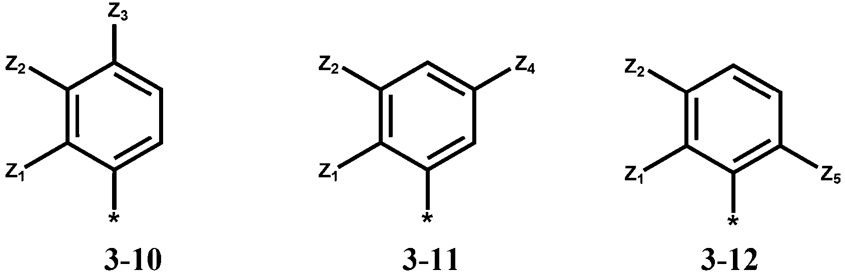 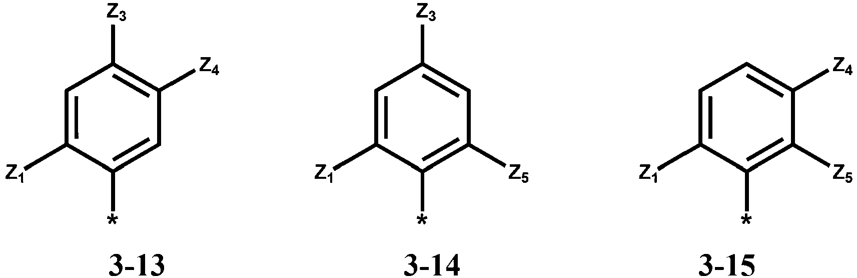 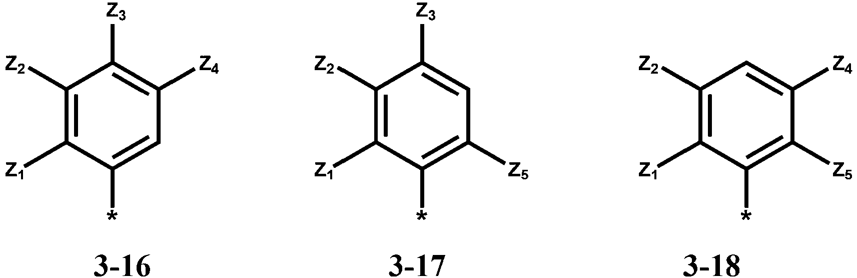 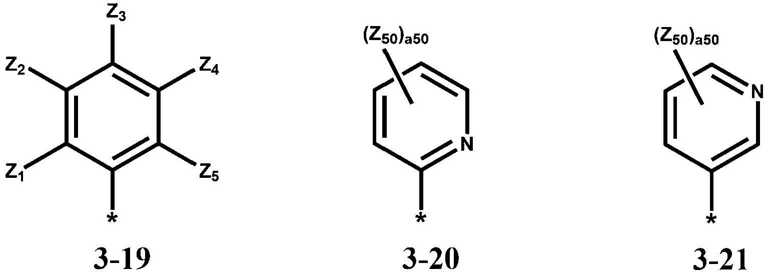 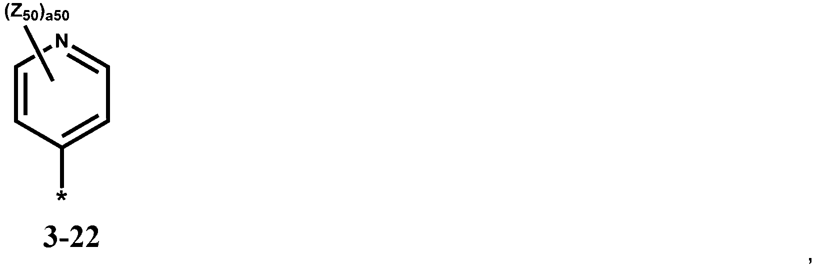 and
wherein, in Formulae 3-1 to 3-22,
a50 is an integer from 0 to 5,
Z₁ to Z₅ and Z₅₀ are each independently: deuterium, -F, or a cyano group; a C₁-C₂₀ alkyl group or a C₁-C₂₀ alkoxy group, each unsubstituted or substituted with deuterium, -F, a cyano group, or any combination thereof; or a C₃-C₆₀ carbocyclic group or a C₁-C₆₀ heterocyclic group, each unsubstituted or substituted with deuterium, -F, a cyano group, a C₁-C₂₀ alkyl group, a C₁-C₂₀ alkoxy group, or any combination thereof, and
* indicates a binding site to a neighboring atom.

14. The condensed cyclic compound of claim 7, wherein the condensed cyclic compound is any one selected from among groups represented by Formulae 1-1 to 1-6: 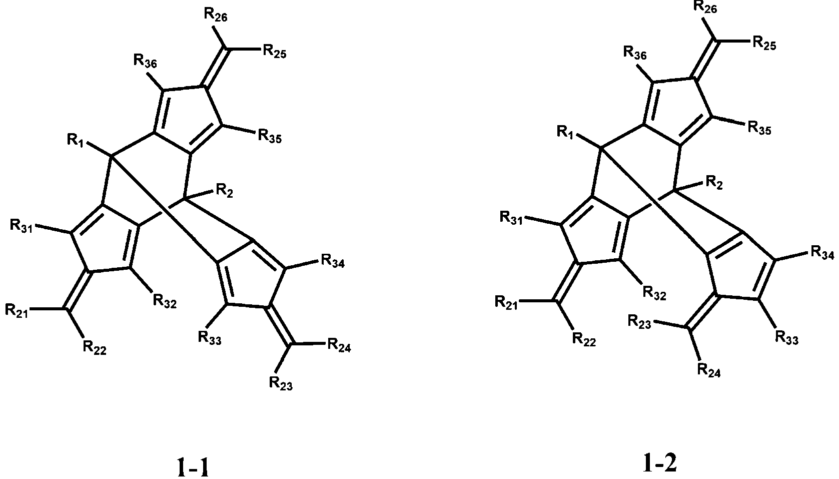 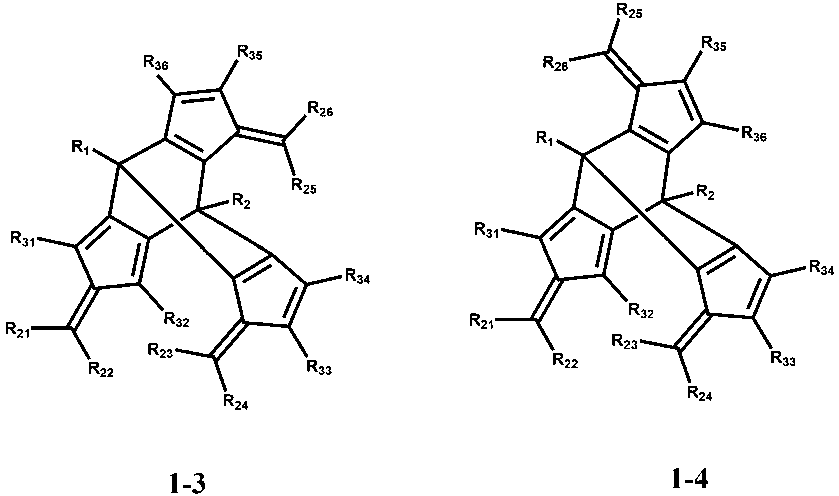 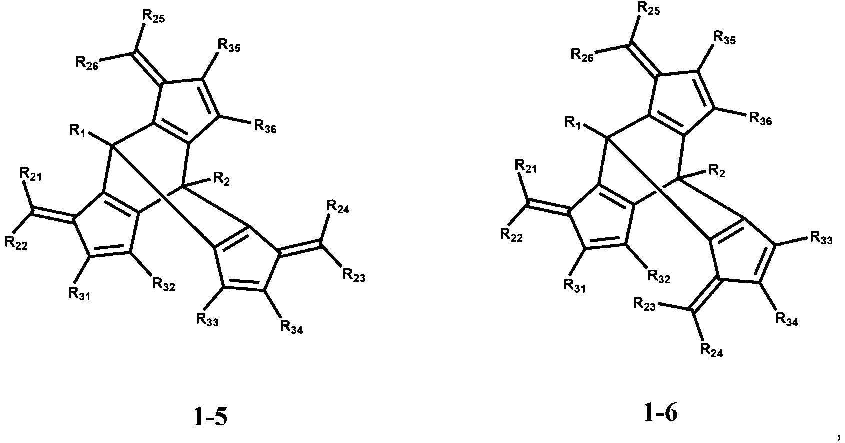 and
wherein, in Formulae 1-1 to 1-6,
R₁ and R₂ are each as described in Formula 1,
R₂₁ to R₂₆ and R₃₁ to R₃₆ are each independently hydrogen, deuterium, -F, -Cl, - Br, -I, a hydroxyl group, a cyano group, a nitro group, a C₁-C₆₀ alkyl group unsubstituted or substituted with at least one R₁₆ₐ, a C₂-C₆₀ alkenyl group unsubstituted or substituted with at least one R₁₀ₐ, a C₂-C₆₀ alkynyl group unsubstituted or substituted with at least one R₁₆ₐ, a C₁-C₆₀ alkoxy group unsubstituted or substituted with at least one R₁₆ₐ, a C₃-C₆₀ carbocyclic group unsubstituted or substituted with at least one R₁₆ₐ, a C₁-C₆₀ heterocyclic group unsubstituted or substituted with at least one R₁₀ₐ, - C(Q₁)(Q₂)(Q₃), -Si(Q₁)(Q₂)(Q₃), -N(Q₁)(Q₂), -B(Q₁)(Q₂), -C(=O)(Q₁), -S(=O)₂(Q₁), or - P(=O)(Q₁)(Q₂),
R₁₀ₐ is:
deuterium, -F, -Cl, -Br, -I, a hydroxyl group, a cyano group, or a nitro group;
a C₁-C₆₀ alkyl group, a C₂-C₆₀ alkenyl group, a C₂-C₆₀ alkynyl group, or a C₁-C₆₀ alkoxy group, each unsubstituted or substituted with deuterium, -F, -Cl, -Br, -I, a hydroxyl group, a cyano group, a nitro group, a C₃-C₆₀ carbocyclic group, a C₁-C₆₀ heterocyclic group, a C₆-C₆₀ aryloxy group, a C₆-C₆₀ arylthio group, a C₇-C₆₀ arylalkyl group, a C₂-C₆₆ heteroarylalkyl group, -Si(Q₁₁)(Q₁₂)(Q₁₃), -N(Q₁₁)(Q₁₂), -B(Q₁₁)(Q₁₂), - C(=O)(Q₁₁), -S(=O)₂(Q₁₁), -P(=O)(Q₁₁)(Q₁₂), or any combination thereof;
a C₃-C₆₀ carbocyclic group, a C₁-C₆₀ heterocyclic group, a C₆-C₆₀ aryloxy group, a C₆-C₆₀ arylthio group, a C₇-C₆₀ arylalkyl group, or a C₂-C₆₀ heteroarylalkyl group, each unsubstituted or substituted with deuterium, -F, -Cl, -Br, -I, a hydroxyl group, a cyano group, a nitro group, a C₁-C₆₀ alkyl group, a C₂-C₆₀ alkenyl group, a C₂-C₆₀ alkynyl group, a C₁-C₆₀ alkoxy group, a C₃-C₆₀ carbocyclic group, a C₁-C₆₀ heterocyclic group, a C₆-C₆₀ aryloxy group, a C₆-C₆₀ arylthio group, a C₇-C₆₀ arylalkyl group, a C₂-C₆₀ heteroarylalkyl group, -Si(Q₂₁)(Q₂₂)(Q₂₃), -N(Q₂₁)(Q₂₂), -B(Q₂₁)(Q₂₂), -C(=O)(Q₂₁), - S(=O)₂(Q₂₁), -P(=O)(Q₂₁)(Q₂₂), or any combination thereof; or
-Si(Q₃₁)(Q₃₂)(Q₃₃), -N(Q₃₁)(Q₃₂), -B(Q₃₁)(Q₃₂), -C(=O)(Q₃₁), -S(=O)₂(Q₃₁), or **-** P(=O)(Q₃₁)(Q₃₂), and
Q₁ to Q₃, Q₁₁ to Q₁₃, Q₂₁ to Q₂₃, and Q₃₁ to Q₃₃ are each independently: hydrogen; deuterium; -F; -Cl; -Br; -I; a hydroxyl group; a cyano group; a nitro group; or a C₁-C₆₀ alkyl group, a C₂-C₆₀ alkenyl group, a C₂-C₆₀ alkynyl group, a C₁-C₆₀ alkoxy group, a C₃-C₆₀ carbocyclic group, or a C₁-C₆₀ heterocyclic group, each unsubstituted or substituted with deuterium, -F, a cyano group, a C₁-C₆₀ alkyl group, a C₁-C₆₀ alkoxy group, a phenyl group, a biphenyl group, or any combination thereof.

15. The condensed cyclic compound of claim 7, wherein the condensed cyclic compound is any one selected from among Compounds 1 to 72:
